(19) Europäisches Patentamt
European Patent Office
Office européen des brevets

(11) EP 4 159 455 B1

(12) EUROPEAN PATENT SPECIFICATION

(45) Date of publication and mention of the grant of the patent:
**29.10.2025 Bulletin 2025/44**

(21) Application number: **21812322.2**

(22) Date of filing: **24.05.2021**

(51) International Patent Classification (IPC):
***B41C 1/10*** *(2006.01)*

(52) Cooperative Patent Classification (CPC):
**B41C 1/1016;** B41C 2201/02; B41C 2201/14; B41C 2210/04; B41C 2210/08

(86) International application number:
**PCT/JP2021/019666**

(87) International publication number:
**WO 2021/241518 (02.12.2021 Gazette 2021/48)**

# (54) ON-PRESS DEVELOPMENT TYPE LITHOGRAPHIC PRINTING PLATE PRECURSOR AND METHOD OF PREPARING A LITHOGRAPHIC PRINTING PLATE

AUF DER DRUCKPRESSE ENTWICKELBARER LITHOGRAPHIEDRUCKPLATTENVORLÄUFER UND VERFAHREN ZUR HERSTELLUNG EINER LITHOGRAPHISCHEN DRUCKPLATTE

PRÉCURSEUR DE PLAQUE D’IMPRESSION LITHOGRAPHIQUE DE TYPE À DÉVELOPPEMENT SUR PRESSE ET PROCÉDÉ DE FABRICATION D’UNE PLAQUE D’IMPRESSION LITHOGRAPHIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.05.2020 JP 2020095070**
**28.01.2021 JP 2021012042**
**31.03.2021 JP 2021061397**

(43) Date of publication of application:
**05.04.2023 Bulletin 2023/14**

(73) Proprietor: **FUJIFILM Corporation**
**Tokyo 106-8620 (JP)**

(72) Inventor: **KUDO, Kotaro**
**Haibara-gun, Shizuoka 421-0396 (JP)**

(74) Representative: **HGF**
**HGF Limited**
**1 City Walk**
**Leeds LS11 9DX (GB)**

(56) References cited:
**EP-A1- 3 747 661**
**EP-A1- 3 991 990**
**WO-A1-2016/027886**
**WO-A1-2019/013268**
**WO-A1-2019/150788**
**WO-A1-2019/150788**
**JP-A- 2004 237 605**
**JP-A- 2012 501 878**
**JP-A- 2020 069 790**
**JP-B1- 6 461 447**
**US-A1- 2014 165 867**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 159 455 B1

## Description

## BACKGROUND OF THE INVENTION

1. Field of the Invention

The present invention relates to an on-press development type lithographic printing plate precursor, a method of preparing a lithographic printing plate, and a lithographic printing method.

2. Description of the Related Art

Generally, a lithographic printing plate consists of a lipophilic image area that receives ink in a printing process and a hydrophilic non-image area that receives dampening water. Lithographic printing is a method of making a difference in ink adhesiveness between the areas of the surface of a lithographic printing plate such that only an image area receives ink, and then performing printing by transferring the ink to a printing substrate (for example, paper). In lithographic printing, for example, a lipophilic image area and a hydrophilic non-image area of a lithographic printing plate are used as an ink-receiving portion and a dampening water-receiving portion (non-ink-receiving portion) respectively. In the related art, in order to prepare a lithographic printing plate, a lithographic printing plate precursor (PS plate) has been widely used which is obtained by providing a lipophilic photosensitive resin layer (image-recording layer) on a hydrophilic support. Generally, a lithographic printing plate is obtained by a plate making method of exposing a lithographic printing plate precursor through an original picture such as a lith film, then keeping a portion of an image-recording layer that will be an image area while removing unnecessary portions of the image-recording layer other than the portion to be an image area by dissolving such portions in an alkaline developer or an organic solvent, and forming a non-image area by exposing the hydrophilic surface of a support.

In response to the intensifying interest in the global environment, an environmental issue of waste liquid generated by wet treatments such as a development treatment has gathered more attention. Regarding the environmental issue described above, an attempt is made to simplify development or plate making or to remove treatments. As one of simple preparation methods, a method called "on-press development" is being carried out. The on-press development is, for example, known as a method of mounting an exposed lithographic printing plate precursor on a printer without performing development with a developer of the related art and removing unnecessary portions of an image-recording layer at the initial stage of a printing step (for example, see WO2019/243036A).

JP 2004/237605 discloses a heat-sensitive lithographic printing plate having a hydrophilic heat-sensitive layer including a hydrophobic precursor and a hydrophobic overcoat layer on a support having the hydrophilic surface in this order.

WO2019/150788 discloses a lithographic printing plate precursor including an image recording layer on a support, in which a hydrophobic area is existed at at least a part of a surface of an outermost layer on a side where the image recording layer is provided and an occupation area ratio of the hydrophobic area in the surface of the outermost layer is more than 20% by area and less than 100% by area.

EP 3 991 990 is prior art under Article 54(3) EPC. EP 3 991 990 discloses an on-press development type lithographic printing plate precursor having an aluminum support and an image-recording layer on the aluminum support, in which the image-recording layer contains an infrared-absorbing polymethine colorant having HOMO of -5.2 eV or less, a polymerization initiator, and a polymerizable compound having 7 or more functional groups and contains or does not contain a polymer having a molecular weight 10,000 or more, and in a case where the image-recording layer contains the polymer having a molecular weight of 10,000 or more, a ratio Wp/Wm of a content Wp of the polymer having a molecular weight of 10,000 or more to a content Wm of the polymerizable compound having 7 or more functional groups is 1.00 or less.

## SUMMARY **OF THE INVENTION**

In a printing method using a lithographic printing plate precursor, for example, it is required to suppress discoloration of the lithographic printing plate precursor caused by the exposure to ozone generated by exposure and ozone contained in the atmosphere.

The present invention has been made in consideration of the circumstances described above.

An object of an embodiment of the present invention is to provide an on-press development type lithographic printing plate precursor in which discoloration caused by exposure to ozone is suppressed.

An object of another embodiment of the present invention is to provide a method of preparing a lithographic printing plate by using an on-press development type lithographic printing plate precursor in which discoloration caused by exposure to ozone is suppressed.

Described herein is a lithographic printing method using an on-press development type lithographic printing plate precursor in which discoloration caused by exposure to ozone is suppressed.

The present invention is as defined in the appended claim set.

According to an embodiment of the present invention, there is provided an on-press development type lithographic printing plate precursor in which discoloration caused by exposure to ozone is suppressed.

According to another embodiment of the present invention, there is provided a method of preparing a lithographic printing plate by using an on-press development type lithographic printing plate precursor in which discoloration caused by exposure to ozone is suppressed.

Described herein is a lithographic printing method using an on-press development type lithographic printing plate precursor in which discoloration caused by exposure to ozone is suppressed.

## BRIEF DESCRIPTION OF THE DRAWINGS

Fig. 1 is a schematic cross-sectional view of a support according to an embodiment.
Fig. 2 is a schematic cross-sectional view of a support according to another embodiment.
Fig. 3 is a schematic view showing an example of an anodization treatment device.

## DESCRIPTION OF THE PREFERRED EMBODIMENTS

Hereinafter, the contents of the present invention will be specifically described. The following configuration requirements will be described on the basis of typical embodiments of the present invention, but the present invention is not limited to such embodiments.

In the present specification, a numerical range expressed using "to" includes numerical values listed before and after "to" as the lower limit and the upper limit.

Regarding the numerical ranges described stepwise in the present specification, the upper limit or lower limit that defines a numerical range may be replaced with the upper limit or lower limit of another numerical range. Furthermore, the upper limit or lower limit of a numerical range in the present specification may be replaced with the values shown in Examples.

In the present specification, in a case where there is no description regarding whether a group (atomic group) is substituent or unsubstituted, the group includes a group having no substituent and a group having a substituent. For example, "alkyl group" includes not only an alkyl group having no substituent (that is, unsubstituted alkyl group) but also an alkyl group having a substituent (substituted alkyl group).

In the present specification, "(meth)acryl" is a term used to explain a concept including both the acryl and methacryl, and "(meth)acryloyl" is a term used to explain a concept including both the acryloyl and methacryloyl.

The term "step" in the present specification means not only an independent step but also a step that cannot be clearly differentiated from other steps as long as the intended goal of the step is achieved.

In the present specification, "% by mass" has the same definition as "% by weight", and "part by mass" has the same definition as "part by weight".

In the present specification, a combination of two or more preferred aspects is a more preferred aspect.

In the present specification, unless otherwise specified, each of the weight-average molecular weight (Mw) and number-average molecular weight (Mn) is a molecular weight that is detected using a gel permeation chromatography (GPC) analysis device using TSKgel GMHxL, TSKgel G4000HxL, and TSKgel G2000HxL (trade names, manufactured by Tosoh Corporation) as columns, tetrahydrofuran (THF) as a solvent, and a differential refractometer, and expressed in terms of polystyrene as a standard substance.

In the present specification, the term "lithographic printing plate precursor" refers not only to a lithographic printing plate precursor but also to a key plate precursor.

In the present specification, the term "lithographic printing plate" refers not only to a lithographic printing plate prepared by performing operations such as exposure and development as necessary on a lithographic printing plate precursor but also to a key plate. The key plate precursor is not necessarily subjected to the operations such as exposure and development. The key plate refers to a lithographic printing plate precursor to be mounted on a plate cylinder that is not used, in a case where monochromatic or dichromatic printing is carried out on a part of paper during, for example, color newspaper printing.

In the present specification, "printing durability" means the number of sheets that can be printed using the lithographic printing plate. The printing durability exhibited in a case where an ultraviolet-curable ink (UV ink) is used as a printing ink is also called "UV printing durability".

<On-press development type lithographic printing plate precursor>

The on-press development type lithographic printing plate precursor according to an embodiment of the present invention has a support, an image-recording layer, and an outermost layer are provided in this order, in which a contact angle of a water droplet on a surface of the outermost layer that is measured 2 seconds after the water droplet is landed by an airborne water droplet method is greater than 36°. According to an embodiment of the present invention, there is provided an on-press development type lithographic printing plate precursor in which discoloration caused by exposure to ozone (hereinafter, also called "ozone discoloration") is suppressed.

The reason why the on-press development type lithographic printing plate precursor according to an embodiment of the present invention brings about the above effect is assumed to be as below. In the on-press development type lithographic printing plate precursor according to an embodiment of the present invention, the contact angle of a water droplet on the surface of the outermost layer that is measured 2 seconds after the water droplet is landed by an airborne water droplet method is greater than 36°. Due to the above characteristics, the hydrophobicity of the surface of the outermost layer is improved, and the affinity between the outermost layer and ozone is reduced. Therefore, according to an embodiment of the present invention, there is provided an on-press development type lithographic printing plate precursor in which discoloration caused by exposure to ozone is suppressed.

Hereinafter, the on-press development type lithographic printing plate precursor will be specifically described. Hereinafter, sometimes "on-press development type lithographic printing plate precursor" will be simply called "lithographic printing plate precursor".

<<Outermost layer>>

The on-press development type lithographic printing plate precursor according to an embodiment of the present invention has an outermost layer. The outermost layer may function as a protective layer, for example. The outermost layer may have, for example, a function of suppressing the reaction inhibiting image formation by blocking oxygen, a function of preventing the damage of the image-recording layer, and a function of preventing ablation during exposure to high-illuminance lasers. The layer having the above characteristics is described, for example, in US3458311A and JP1980-49729B (JP-S55-49729B).

[Contact angle]

The contact angle of a water droplet on the surface of the outermost layer that is measured 2 seconds after the water droplet is landed by an airborne water droplet method (hereinafter, also simply called "contact angle of the water droplet") is greater than 36°. In a case where the contact angle of the water droplets is greater than 36°, ozone discoloration can be suppressed. From the viewpoint of suppressing ozone discoloration and suppressing the occurrence of development residues, the contact angle of the water droplet is preferably 40° or more, more preferably 50° or more, even more preferably 60° or more, and particularly preferably 70° or more. The upper limit of the contact angle of the water droplet is not limited. The contact angle of the water droplet may be, for example, 80° or less or 70° or less. Unless otherwise specified, "surface of the outermost layer" means one of the surfaces of the outermost layer facing the side opposite to the other surface facing the image-recording layer. The contact angle of the water droplet is measured as a contact angle of a water droplet landed on the surface of a measurement object at 25°C (contact angle 2 seconds after dripping) by using a fully automated contact angle meter (for example, DM-501 manufactured by Kyowa Interface Science Co., Ltd.) as a measuring device. The contact angle is measured at 3 or more sites on the surface of the same measurement object, and then the average of the measured values is calculated.

From the viewpoint of suppressing ozone discoloration and suppressing the occurrence of development residues, the contact angle of an oil droplet on the surface of the outermost layer that is measured 2 seconds after the oil droplet is landed by an airborne oil droplet method (hereinafter, also simply called "contact angle of the oil droplet") is preferably 20° or less, more preferably 15° or less, and particularly preferably 12° or less. The lower limit of the contact angle of the oil droplet is not limited. The contact angle of the oil droplet may be, for example, more than 0°. From the viewpoint of on-press developability, the contact angle of the oil droplet is preferably 3° or more, more preferably 5° or more, and particularly preferably 8° or more. The contact angle of the oil droplet is measured as a contact angle of linseed oil landed on the surface of a measurement object at 25°C (contact angle 2 seconds after dripping) by using a fully automated contact angle meter (for example, DM-501 manufactured by Kyowa Interface Science Co., Ltd.) as a measuring device. The contact angle is measured at 3 or more sites on the surface of the same measurement object, and then the average of the measured values is calculated.

The contact angle of the water droplet and the contact angle of the oil droplet on the surface of the outermost layer can be adjusted, for example, by the composition of the outermost layer. For example, the contact angle of the water droplet and the contact angle of the oil droplet can be adjusted by the use of the hydrophobic polymer or hydrophilic

polymer that will be described later and the content of the hydrophobic polymer or hydrophilic polymer that will be described later. However, the method of adjusting the contact angle is not limited to the above method. Known methods may be used as the method of adjusting the contact angle.

[Polymer]

The outermost layer preferably contains a polymer. Examples of the polymer include a hydrophobic polymer and a hydrophilic polymer. The outermost layer preferably contains a hydrophobic polymer, and more preferably contains a hydrophobic polymer and a hydrophilic polymer. Hereinafter, the hydrophobic polymer and the hydrophilic polymer will be specifically described.

(Hydrophobic polymer)

From the viewpoint of suppressing ozone discoloration and suppressing the occurrence of development residues, the outermost layer preferably contains a hydrophobic polymer. Herein,, "hydrophobic polymer" means a polymer having a solubility of 5% by mass or less in water at 25°C.

Examples of the hydrophobic polymer include polyethylene, polystyrene, polyvinyl chloride, polyvinylidene chloride, polyalkyl (meth)acrylate ester (for example, polymethyl (meth)acrylate, polyethyl (meth)acrylate, and polybutyl (meth)acrylate), a fluorine atom-containing (meth)acrylic resin, and a copolymer obtained by combining raw material monomers of these polymers. The hydrophobic polymer preferably includes a styrene-acrylic copolymer.

From the viewpoint of suppressing ozone discoloration and suppressing the occurrence of development residues, a glass transition temperature (Tg) of the hydrophobic polymer is preferably 30°C or higher, more preferably 60°C or higher, and particularly preferably 70°C or higher. The upper limit of the glass transition temperature of the hydrophobic polymer is not limited. The glass transition temperature of the hydrophobic polymer may be 150°C or lower or 120°C or lower.

The glass transition temperature of the polymer is measured using differential scanning calorimetry (DSC). Specifically, the glass transition temperature is measured according to the method described in "JIS K 7121 (1987)" or "JIS K 6240 (2011)". An appropriate JIS standard is selected depending on the composition of the polymer. As the glass transition temperature, an extrapolated glass transition initiation temperature (hereinafter, also called "Tig") is used. Hereinafter, the method of measuring the glass transition temperature will be specifically described. In order to measure the glass transition temperature, the device is kept at a temperature approximately 50°C lower than the expected glass transition temperature of the polymer until the device stabilizes. Then, the polymer is heated at a heating rate of 20°C/min to a temperature approximately 30°C higher than the temperature at which the glass transition ends, and a differential thermal analysis (DTA) curve or a DSC curve is plotted. The extrapolated glass transition initiation temperature (Tig), that is, the glass transition temperature (Tg) is determined as a temperature at an intersection point between a straight line that is obtained by extending the baseline of a low temperature side in the DTA curve or the DSC curve to a high temperature side and a tangent line that is drawn at a point where the slope of the curve of a portion in which the glass transition stepwise changes is maximum.

The hydrophobic polymer is preferably in the form of particles. In a case where the hydrophobic polymer is in the form of particles, the hydrophobicity of the surface of the outermost layer can be further improved. For example, the hydrophobic polymer in the form of particles can form a sea-island structure including the hydrophobic polymer as an island region on the surface of the outermost layer. The sea-island structure described above can contribute to the improvement of hydrophobicity. The shape of the hydrophobic polymer whose contour is confirmed by surface observation (that is, plan view) of the outermost layer is regarded as a particle. The shape of contour of the hydrophobic polymer confirmed by the surface observation of the outermost layer is not limited to a perfect circle, and may be, for example, an ellipse, a polygon, or an amorphous shape. For the surface observation of the outermost layer, as necessary, an observation method used in the method for measuring "proportion of area occupied by the hydrophobic polymer" that will be described later may be used.

From the viewpoint of suppressing ozone discoloration and suppressing the occurrence of development residues, the proportion of the area occupied by the hydrophobic polymer within the surface of the outermost layer is preferably 5% or more, more preferably 10% or more, even more preferably 20% or more, particularly preferably 50% or more, and most preferably 60% or more. The proportion of the area occupied by the hydrophobic polymer within the surface of the outermost layer may be 70% or more or 80% or more. There is no limitation on the upper limit of the proportion of the area occupied by the hydrophobic polymer within the surface of the outermost layer. The proportion of the area occupied by the hydrophobic polymer within the surface of the outermost layer may be less than 100%, 95% or less, 90% or less, or 85% or less.

The proportion of the area occupied by the hydrophobic polymer within the surface of the outermost layer is measured by the following method. As a conductive treatment, a 3 nm carbon film or a 3 nm Pt-Pd film is applied to the

surface of the measurement object. Then, by using an SU8010 type FE-SEM manufactured by Hitachi High-Tech Corporation., a backscattered electron image is observed at an acceleration voltage of 5 kV to 10 kV. For images captured at a total of 3 sites at 1,000X to 10,000X magnification for observation (the magnification is arbitrarily adjusted depending on the size of the hydrophobic polymer to be observed), by using image processing software (for example, ImageJ) and a difference in contrast between the hydrophobic polymer (for example, a projection) and the periphery of the hydrophobic polymer, a binarization processing is performed, and the proportion of the area occupied by the hydrophobic polymer is calculated. The proportion of the area occupied by the hydrophobic polymer is calculated by dividing "area of the hydrophobic polymer" by "area of the visual field (sum of the area of the hydrophobic polymer and the area of regions other than the hydrophobic polymer)". In a case where the hydrophobic polymer cannot be observed in the image obtained by the above method, the content (unit: % by mass) of the hydrophobic polymer contained in the outermost layer is defined as the proportion of the area occupied by the hydrophobic polymer.

The outermost layer may contain one kind of hydrophobic polymer or two or more kinds of hydrophobic polymers.

From the viewpoint of suppressing ozone discoloration and suppressing the occurrence of development residues, the content of the hydrophobic polymer with respect to the total mass of the outermost layer is preferably 5% by mass or more, more preferably 10% by mass or more, even more preferably 20% by mass or more, particularly preferably 50% by mass or more, and most preferably 60% by mass or more. The content of the hydrophobic polymer may be 70% by mass or more or 80% by mass or more with respect to the total mass of the outermost layer. The upper limit of the content of the hydrophobic polymer is not limited. The content of the hydrophobic polymer with respect to the total mass of the outermost layer may be less than 100% by mass, 95% by mass or less, 90% by mass or less, or 85% by mass or less.

In a case where the outermost layer contains a hydrophobic polymer and a hydrophilic polymer, the content of the hydrophobic polymer is preferably higher than the content of the hydrophilic polymer. In a case where the content of the hydrophobic polymer is higher than the content of the hydrophilic polymer, ozone discoloration can be further suppressed. Furthermore, the occurrence of development residues can be further suppressed. Specifically, the content of the hydrophobic polymer is preferably equal to or more than 1.7 times the content of the hydrophilic polymer, more preferably equal to or more than 2.9 times the content of the hydrophilic polymer, and particularly preferably equal to or more than 3.2 times the content of the hydrophilic polymer, based on mass. There is no limitation on the upper limit of the ratio of the content of the hydrophobic polymer to the content of the hydrophilic polymer. The content of the hydrophobic polymer may be equal to or less than 10.0 times the content of the hydrophilic polymer, based on mass.

(Hydrophilic polymer)

From the viewpoint of on-press developability, the outermost layer preferably contains a hydrophilic polymer. Herein, "hydrophilic polymer" means a polymer having a solubility of more than 5% by mass in water at 25°C.

Examples of the hydrophilic polymer include polyvinyl alcohol, modified polyvinyl alcohol, polyvinylpyrrolidone, a cellulose derivative, polyethylene glycol, and poly(meth)acrylonitrile. As the modified polyvinyl alcohol, acid-modified polyvinyl alcohol having a carboxy group or a sulfo group is preferably used. Specific examples thereof include modified polyvinyl alcohols described in JP2005-250216A and JP2006-259137A. Examples of the cellulose derivative include methyl cellulose, hydroxypropyl methyl cellulose, and carboxymethyl cellulose.

**In** a certain embodiment, the hydrophilic polymer preferably includes at least one kind of compound selected from the group consisting of a modified polyvinyl alcohol and a cellulose derivative.

In a certain embodiment, the hydrophilic polymer preferably includes a polyvinyl alcohol. Among the polyvinyl alcohols, a polyvinyl alcohol having a saponification degree of 50% or more is more preferable. The saponification degree is preferably 60% or more, more preferably 70% or more, and particularly preferably 85% or more. The upper limit of the saponification degree is not limited. The saponification degree may be 100% or less. The saponification degree is measured according to the method described in "JIS K 6726: 1994".

In a certain embodiment, the hydrophilic polymer preferably includes polyvinylpyrrolidone. It is also preferable to use a polyvinyl alcohol and polyvinylpyrrolidone in combination as the hydrophilic polymer.

The outermost layer may contain one kind of hydrophilic polymer or two or more kinds of hydrophilic polymers.

From the viewpoint of on-press developability, the content of the hydrophilic polymer is preferably 10% by mass or more with respect to the total mass of the outermost layer. From the viewpoint of suppressing ozone discoloration and suppressing the occurrence of development residues, the content of the hydrophilic polymer is preferably 90% by mass or less with respect to the total mass of the outermost layer.

[Discoloring compound]

The outermost layer preferably contains a discoloring compound. Herein, "discoloring compound" refers to a compound which undergoes change in absorption in the visible light region (wavelength: 400 nm or more and less than 750 nm) due to the exposure to infrared. Herein, "discoloring" means that the absorption in the visible light region (wavelength:

400 nm or more and less than 750 nm) changes due to the exposure to infrared. Specifically, examples of the discoloring compound include (1) compound that absorbs more light in the visible light region due to the exposure to infrared than before the exposure to infrared, (2) compound that is made capable of absorbing light in the visible light region due to the exposure to infrared, and (3) compound that is made incapable of absorbing light in the visible light region due to the exposure to infrared. "Infrared" is a ray in a wavelength region of 750 nm to 1 mm, and preferably a ray in a wavelength region of 750 nm to 1,400 nm.

The discoloring compound preferably includes a compound that develops color due to the exposure to infrared. Furthermore, the discoloring compound preferably includes a decomposable compound that decomposes due to the exposure to infrared, and more preferably includes a decomposable compound that decomposes by either or both of heat and electron migration due to the exposure to infrared. Specifically, the discoloring compound is preferably a compound that decomposes due to the exposure to infrared (more preferably, decomposes by either or both of heat or electron migration due to the exposure to infrared) and absorbs more light in the visible light region than before the exposure to infrared or is made capable of absorbing light of shorter wavelengths and thus capable of absorbing light in the visible light region. "Decomposes by electron migration" mentioned herein means that electrons excited to the lowest unoccupied molecular orbital (LUMO) from the highest occupied molecular orbital (HOMO) of the discoloring compound by exposure to infrared move to electron accepting groups (groups having potential close to LUMO) in a molecule by means of intramolecular electron migration and thus result in decomposition.

The decomposable compound may be, for example, a compound that absorbs at least a part of light in the infrared wavelength region (wavelength region of 750 nm to 1 mm, preferably a wavelength region of 750 nm to 1,400 nm) and decomposes. The decomposable compound is preferably a compound having maximum absorption wavelength in the wavelength region of 750 nm to 1,400 nm. Specifically, the decomposable compound is preferably a compound that decomposes due to the exposure to infrared and generates a compound having maximum absorption wavelength in a wavelength region of 500 nm to 600 nm.

Preferred examples of the discoloring compound include a compound represented by Formula 1, a compound represented by Formula 1-1, a compound represented by Formula 1-2, a compound represented by Formula 1-3, and a compound represented by Formula 1-4, a compound represented by Formula 1-5, a compound represented by Formula 1-6, and a compound represented by Formula 1-7 that will be described later.

(Compound represented by Formula 1)

The discoloring compound preferably includes a compound represented by Formula 1.

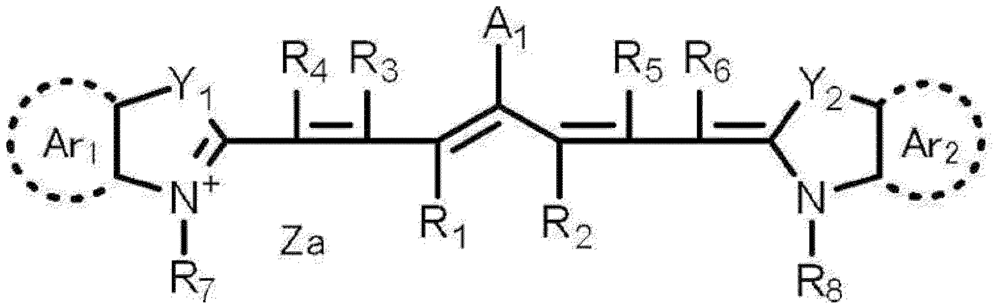

Formula 1

In Formula 1, $R_1$ and $R_2$ each independently represent a hydrogen atom or an alkyl group, $R_1$ and $R_2$ may be linked to each other to form a ring, $R_3$ to $R_6$ each independently represent a hydrogen atom or an alkyl group, $R_7$ and $R_8$ each independently represent an alkyl group or an aryl group, $Y_1$ and $Y_2$ each independently represent an oxygen atom, a sulfur atom, $-NR_0-$, or a dialkylmethylene group, $R_0$ represents a hydrogen atom, an alkyl group, or an aryl group, $Ar_1$ and $Ar_2$ each independently represent a group forming a benzene ring or a naphthalene ring which may have a group represented by Formula 2 that will be described later, $A_1$ represents $-NR_9R_{10}$, $-X_1-L_1$, or a group represented by Formula 2 that will be described later, $R_9$ and $R_{10}$ each independently represent an alkyl group, an aryl group, an alkoxycarbonyl group, or an arylsulfonyl group, $X_1$ represents an oxygen atom or a sulfur atom, $L_1$ represents a hydrocarbon group, a heteroaryl group, or a group that undergoes bond cleavage from $X_1$ by heat or exposure to infrared, Za represents a counterion that neutralizes charge, and at least one of $Ar_1$ or $Ar_2$ has a group represented by Formula 2.

-X: Formula 2

In Formula 2, X represents a halogen atom, $-C(=O)-X_2-R_{11}$, $-C(=O)-NR_{12}R_{13}$, $-O-C(=O)-R_{14}$, -CN, $-SO_2NR_{15}R_{16}$, or a perfluoroalkyl group, $X_2$ represents a single bond or an oxygen atom, $R_{11}$ and $R_{14}$ each independently

represent an alkyl group or an aryl group, and $R_{12}$, $R_{13}$, $R_{15}$, and $R_{16}$ each independently represent a hydrogen atom, an alkyl group, or an aryl group.

$Ar^1$ and $Ar^2$ each independently represent a group forming a benzene ring or a naphthalene ring. The benzene ring and the naphthalene ring may have a substituent other than -X. Examples of the substituent include an alkyl group, an alkoxy group, an aryloxy group, an amino group, an alkylthio group, an arylthio group, a carboxy group, a carboxylate group, a sulfo group, a sulfonate group, groups obtained by combining these, and the like. Among these, an alkyl group is preferable.

In Formula 1, at least one of $Ar_1$ or $Ar_2$ has a group represented by Formula 2. From the viewpoint of printing durability and visibility, it is preferable that both of $Ar_1$ and $Ar_2$ have a group represented by Formula 2.

X in Formula 2 represents a halogen atom, $-C(=O)-X_2-R_{11}$, $-C(=O)-NR_{12}R_{13}$, $-O-C(=O)-R_{14}$, -CN, $-SO_2NR_{15}R_{16}$, or a perfluoroalkyl group. From the viewpoint of printing durability, visibility, and temporal stability, X is preferably a halogen atom, $-C(=O)-X_2-R_{11}$, $-C(=O)-NR_{12}R_{13}$, $-O-C(=O)-R_{14}$, CN, or $-SO_2NR_{15}R_{16}$, more preferably a halogen atom, $-C(=O)-O-R_{11}$, $-C(=O)-NR_{12}R_{13}$, or $-O-C(=O)-R_{14}$, even more preferably a halogen atom, $-C(=O)-O-R_{11}$ or $-O-C(=O)-R_{14}$, particularly preferably a fluorine atom, a chlorine atom, a bromine atom, or $-C(=O)OR_{17}$, and most preferably a chlorine atom or a bromine atom.

$X_2$ represents a single bond or an oxygen atom, and is preferably an oxygen atom.

$R_{11}$ and $R_{14}$ each independently represent an alkyl group or an aryl group, preferably each independently represent an alkyl group having 1 to 12 carbon atoms or an aryl group having 6 to 12 carbon atoms, and more preferably each independently represent an alkyl group having 1 to 12 carbon atoms.

$R_{12}$, $R_{13}$, $R_{15}$, and $R_{16}$ each independently represent a hydrogen atom, an alkyl group, or an aryl group, preferably each independently represent a hydrogen atom, an alkyl group having 1 to 12 carbon atoms, or an aryl group having 6 to 12 carbon atoms, more preferably each independently represent a hydrogen atom or an alkyl group having 1 to 12 carbon atoms, and even more preferably each independently represent an alkyl group having 1 to 12 carbon atoms.

$R_{17}$ represents an alkyl group or an aryl group, preferably represents an alkyl group having 1 to 12 carbon atoms or an aryl group having 6 to 12 carbon atoms, and more preferably represents an alkyl group having 1 to 12 carbon atoms.

$A_1$ represents $-NR_9R_{10}$, $-X_1-L_1$, or -X. From the viewpoint of printing durability, visibility, and temporal stability, $A_1$ is preferably $-NR_9R_{10}$ or $-X_1-L_1$, and more preferably $-NR_{18}R_{19}$ or $-S-R_{20}$.

Furthermore, from the viewpoint of UV plate missing suppressiveness, GLV suitability, and UV printing durability, $A_1$ is preferably -X, more preferably a halogen atom, even more preferably a chlorine atom or a bromine atom, and particularly preferably a chlorine atom.

$R_9$ and $R_{10}$ each independently represent an alkyl group, an aryl group, an alkoxycarbonyl group, or an arylsulfonyl group, preferably each independently represent an alkyl group having 1 to 12 carbon atoms or an aryl group having 6 to 12 carbon atoms, and more preferably each independently represent an alkyl group having 1 to 12 carbon atoms.

$X_1$ represents an oxygen atom or a sulfur atom. **In** a case where $L_1$ is a hydrocarbon group or a heteroaryl group, $X_1$ is preferably a sulfur atom. $L_1$ is preferably a group that undergoes bond cleavage from $X_1$ by heat or exposure to infrared.

$L_1$ represents a hydrocarbon group, a heteroaryl group, or a group that undergoes bond cleavage from $X_1$ by heat or exposure to infrared. From the viewpoint of printing durability, $L_1$ is preferably a hydrocarbon group or a heteroaryl group, more preferably an aryl group or a heteroaryl group, and even more preferably a heteroaryl group.

Furthermore, from the viewpoint of visibility and suppressing fading over time, $L_1$ is preferably a group that undergoes bond cleavage from $X_1$ by heat or exposure to infrared.

The group that undergoes bond cleavage from $X_1$ by heat or exposure to infrared will be described later.

$R_{18}$ and $R_{19}$ each independently represent an aryl group, preferably each independently represent an aryl group having 6 to 20 carbon atoms, and more preferably each independently represent a phenyl group.

$R_{20}$ represents a hydrocarbon group or a heteroaryl group, preferably represents an aryl group or a heteroaryl group, and more preferably represents a heteroaryl group.

Preferred examples of the heteroaryl group represented by $L_1$ and $R_{20}$ include the following groups.

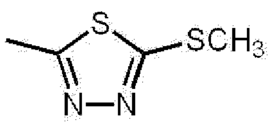

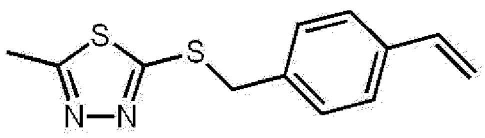

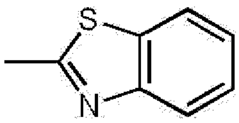 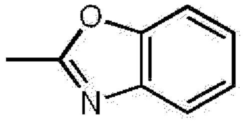 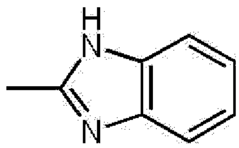

The alkyl group represented by $R_1$ to $R_{10}$ and $R_0$ is preferably an alkyl group having 1 to 30 carbon atoms, more preferably an alkyl group having 1 to 15 carbon atoms, and even more preferably an alkyl group having 1 to 10 carbon atoms. The alkyl group may be linear or branched, or may have a ring structure.

Specific examples of the alkyl group include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbornyl group.

Among these alkyl groups, a methyl group, an ethyl group, a propyl group, or a butyl group is particularly preferable.

The above alkyl group may have a substituent. Examples of the substituent include an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, and groups obtained by combining these, and the like.

The aryl group represented by $R_9$, $R_{10}$, $R_{18}$, $R_{19}$, and $R_0$ is preferably an aryl group having 6 to 30 carbon atoms, more preferably an aryl group having 6 to 20 carbon atoms, and even more preferably an aryl group having 6 to 12 carbon atoms.

The aryl group may have a substituent. Examples of the substituent include an alkyl group, an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, and groups obtained by combining these, and the like.

Specific examples of the aryl group include a phenyl group, a naphthyl group, a p-tolyl group, a p-chlorophenyl group, a p-fluorophenyl group, a p-methoxyphenyl group, a p-dimethylaminophenyl group, a p-methylthiophenyl group, a p-phenylthiophenyl group, and the like.

Among these aryl groups, a phenyl group, a p-methoxyphenyl group, a p-dimethylaminophenyl group, or a naphthyl group is preferable.

It is preferable that $R_1$ and $R_2$ be linked to each other to form a ring.

In a case where $R_1$ and $R_2$ are linked to each other to form a ring, the formed ring is preferably a 5- or a 6-membered ring and more preferably a 6-membered ring. Furthermore, the ring formed of $R_1$ and $R_2$ linked to each other is preferably a hydrocarbon ring which may have an ethylenically unsaturated bond.

$Y_1$ and $Y_2$ each independently represent an oxygen atom, a sulfur atom, $-NR_0-$, or a dialkylmethylene group. Among these, $-NR_0-$ or a dialkylmethylene group is preferable, and a dialkylmethylene group is more preferable.

$R_0$ represents a hydrogen atom, an alkyl group, or an aryl group. $R_0$ is preferably an alkyl group.

It is preferable that $R_7$ and $R_8$ be the same group.

$R_7$ and $R_8$ preferably each independently represent a linear alkyl group or an alkyl group having a sulfonate group on a terminal, and more preferably each independently represent a methyl group, an ethyl group, or a butyl group having a sulfonate group on a terminal.

The countercation of the aforementioned sulfonate group may be a cation on a nitrogen atom in Formula 1 or may be an alkali metal cation or an alkaline earth metal cation.

From the viewpoint of improving water solubility of the compound represented by Formula 1, $R_7$ and $R_8$ preferably each independently represent an alkyl group having an anion structure, more preferably each independently represent an alkyl group having a carboxylate group or a sulfonate group, and even more preferably each independently represent an alkyl group having a sulfonate group on a terminal.

From the viewpoint of increasing the maximum absorption wavelength of the compound represented by Formula 1 and from the viewpoint of visibility and printing durability of the lithographic printing plate, $R_7$ and $R_8$ preferably each independently represent an alkyl group having an aromatic ring, more preferably each independently represent an alkyl group having an aromatic ring on a terminal, and particularly preferably each independently represent a 2-phenylethyl group, a 2-naphthalenylethyl group, or a 2-(9-anthracenyl)ethyl group.

$R_3$ to $R_6$ each independently represent a hydrogen atom or an alkyl group, and preferably each independently represent a hydrogen atom.

From the viewpoint of temporal stability, UV plate missing suppressiveness, GLV suitability, and UV printing

durability, the compound represented by Formula 1 preferably has one or more halogen atoms, more preferably has one or more halogen atoms in at least one group selected from the group consisting of $A_1$, $Ar_1$, and $Ar_2$, and particularly preferably has one or more halogen atoms in each of $A_1$, $Ar_1$, and $Ar_2$.

Furthermore, from the viewpoint of temporal stability, UV plate missing suppressiveness, GLV suitability, and UV printing durability, the compound represented by Formula 1 more preferably has two or more halogen atoms, even more preferably has three or more halogen atoms, and particularly preferably has three or more and six or less halogen atoms.

Preferred examples of the aforementioned halogen atoms include a chlorine atom and a bromine atom.

From the viewpoint of temporal stability, UV plate missing suppressiveness, GLV suitability, and UV printing durability, the compound represented by Formula 1 preferably has halogen atoms in at least one of $Ar_1$ or $Ar_2$, more preferably has chlorine atoms or bromine atoms in at least one of $Ar_1$ or $Ar_2$, and particularly preferably has bromine atoms in at least one of $Ar_1$ or $Ar_2$.

Za represents a counterion that neutralizes charge. In a case where Za represents anionic species, examples thereof include a sulfonate ion, a carboxylate ion, a tetrafluoroborate ion, a hexafluorophosphate ion, a perchlorate ion, a sulfonamide anion, a sulfonimide anion, and the like. In a case where Za represents cationic species, an alkali metal ion, an alkaline earth metal ion, an ammonium ion, a pyridinium ion, or a sulfonium ion is preferable, a sodium ion, a potassium ion, an ammonium ion, a pyridinium ion, or a sulfonium ion is more preferable, a sodium ion, a potassium ion, or an ammonium ion is even more preferable, and a sodium ion, a potassium ion, or a trialkylammonium ion is particularly preferable.

As Za, among the above, from the viewpoint of printing durability and visibility, an organic anion having a carbon atom is preferable, a sulfonate ion, a carboxylate ion, a sulfonamide anion, or a sulfonimide anion is more preferable, a sulfonamide anion or a sulfonimide anion is even more preferable, and a sulfonimide anion is particularly preferable.

$R_1$ to $R_8$, $R_0$, $A_1$, $Ar_1$, $Ar_2$, $Y_1$, and $Y_2$ may have an anion structure and a cation structure. In a case where all of $R_1$ to $R_8$, $R_0$, $A_1$, $Ar_1$, $Ar_2$, $Y_1$, and $Y_2$ represent a group having neutral charge, Za represents a monovalent counteranion. However, for example, in a case where two or more among $R_1$ to $R_8$, $R_0$, $A_1$, $Ar_1$, $Ar_2$, $Y_1$, and $Y_2$ have an anion structure, Za can be a countercation.

In Formula 1, in a case where portions other than Za have neutral charge, Formula 1 may not have Za.

As the sulfonamide anion, an aryl sulfonamide anion is preferable.

As the sulfonimide anion, a bisaryl sulfonimide anion is preferable.

Specific examples of the sulfonamide anion or the sulfonimide anion will be shown below, but is not limited thereto. In the following specific examples, Ph represents a phenyl group, Me represents a methyl group, and Et represents an ethyl group.

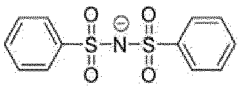
I-1

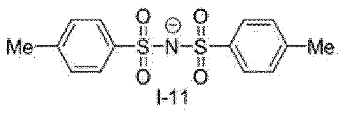
I-11

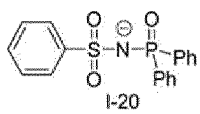
I-20

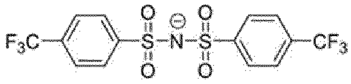

I-2

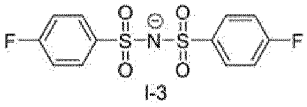

I-3

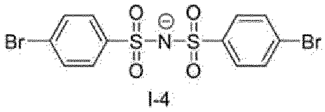

I-4

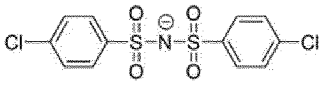

I-5

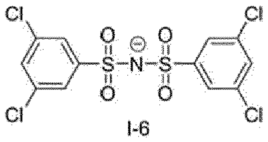

I-6

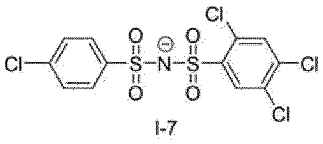

I-7

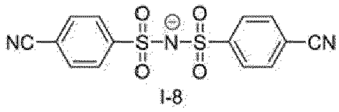

I-8

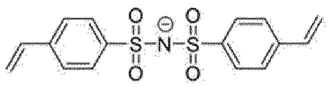

I-9

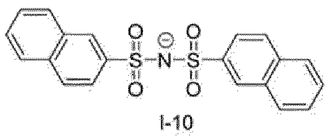

I-10

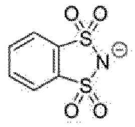

I-12

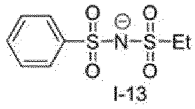

I-13

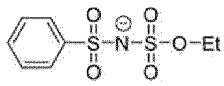

I-14

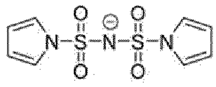

I-15

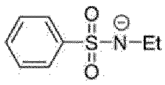

I-16

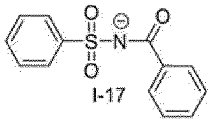

I-17

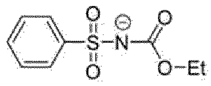

I-18

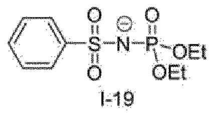

I-19

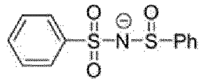

I-21

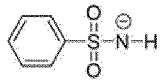

I-22

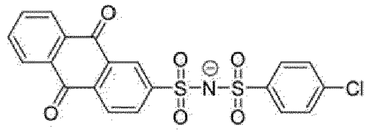

I-23

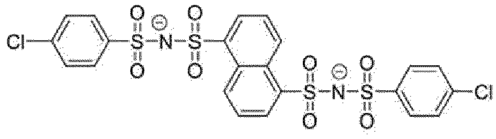

I-24

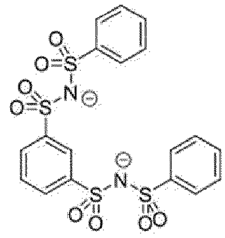

I-25

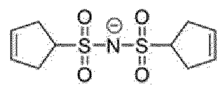

I-26

From the viewpoint of visibility, the group that undergoes bond cleavage from $X_1$ by heat or exposure to infrared is preferably a group represented by any of Formula (1-1) to Formula (1-7), and more preferably a group represented by any of Formula (1-1) to Formula (1-3).

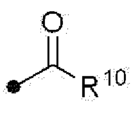

(1-1)

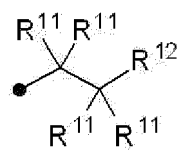

(1-2)

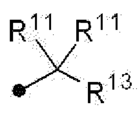

(1-3)

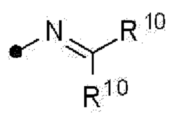

(1-4)

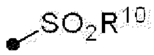 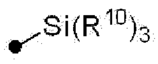 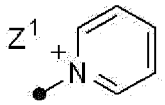

(1-5) (1-6) (1-7)

In Formula (1-1) to Formula (1-7), • represents a bonding site with $X_1$ in Formula 1, $R^{10}$ each independently represent a hydrogen atom, an alkyl group, an alkenyl group, an aryl group, $-OR^{14}$, $-NR^{15}R^{16}$, or $-SR^{17}$, $R^{11}$ each independently represent a hydrogen atom, an alkyl group, or an aryl group, $R^{12}$ represents an aryl group, $-OR^{14}$, $-NR^{15}R^{16}$, $-SR^{17}$, $-C(=O)R^{18}$, $-OC(=O)R^{18}$, or a halogen atom, $R^{13}$ represents an aryl group, an alkenyl group, an alkoxy group, or an onium group, $R^{14}$ to $R^{17}$ each independently represent a hydrogen atom, an alkyl group, or an aryl group, $R^{18}$ each independently represent an alkyl group, an aryl group, $-OR^{14}$, $-NR^{15}R^{16}$, or $-SR^{17}$, and $Z^1$ represents a counterion that neutralizes charge.

In a case where $R^{10}$, $R^{11}$, and $R^{14}$ to $R^{18}$ each represent an alkyl group, preferred aspects of the alkyl group are the same as preferred aspects of the alkyl group represented by $R^2$ to $R^9$ and $R^0$.

The number of carbon atoms in the alkenyl group represented by $R^{10}$ and $R^{13}$ is preferably 1 to 30, more preferably 1 to 15, and even more preferably 1 to 10.

In a case where $R^{10}$ to $R^{18}$ each represent an aryl group, preferred aspects of the aryl group are the same as preferred aspects of the aryl group represented by $R^0$.

From the viewpoint of visibility, $R^{10}$ in Formula (1-1) is preferably an alkyl group, an alkenyl group, an aryl group, $-OR^{14}$, $-NR^{15}R^{16}$, or $-SR^{17}$, more preferably an alkyl group, $-OR^{14}$, $-NR^{15}R^{16}$, or $-SR^{17}$, even more preferably an alkyl group or $-OR^{14}$, and particularly preferably $-OR^{14}$.

In a case where $R^{10}$ in Formula (1-1) is an alkyl group, the alkyl group is preferably an alkyl group having an arylthio group or an alkyloxycarbonyl group at the $\alpha$-position.

In a case where $R^{10}$ in Formula (1-1) represents $-OR^{14}$, $R^{14}$ is preferably an alkyl group, more preferably an alkyl group having 1 to 8 carbon atoms, even more preferably an isopropyl group or a t-butyl group, and particularly preferably a t-butyl group.

From the viewpoint of visibility, $R^{11}$ in Formula (1-2) is preferably a hydrogen atom.

Furthermore, from the viewpoint of visibility, $R^{12}$ in Formula (1-2) is preferably $-C(=O)OR^{14}$, $-OC(=O)OR^{14}$, or a halogen atom, and more preferably $-C(=O)OR^{14}$ or $-OC(=O)OR^{14}$. In a case where $R^{12}$ in Formula (1-2) is $-C(=O)OR^{14}$ or $-OC(=O)OR^{14}$, $R^{14}$ is preferably an alkyl group.

From the viewpoint of visibility, $R_{11}$ in Formula (1-3) preferably each independently represent a hydrogen atom or an alkyl group. It is more preferable that at least one of $R^{11}$'s in Formula (1-3) be an alkyl group.

The alkyl group represented by $R^{11}$ is preferably an alkyl group having 1 to 10 carbon atoms, and more preferably an alkyl group having 3 to 10 carbon atoms.

Furthermore, the alkyl group represented by $R^{11}$ is preferably an alkyl group having a branch or a cycloalkyl group, more preferably a secondary or tertiary alkyl group or a cycloalkyl group, and even more preferably an isopropyl group, a cyclopentyl group, a cyclohexyl group, or a t-butyl group.

From the viewpoint of visibility, $R^{13}$ in Formula (1-3) is preferably an aryl group, an alkoxy group, or an onium group, more preferably a p-dimethylaminophenyl group or a pyridinium group, and even more preferably a pyridinium group.

Examples of the onium group represented by $R^{13}$ include a pyridinium group, an ammonium group, a sulfonium group, and the like. The onium group may have a substituent. Examples of the substituent include an alkyl group, an alkoxy group, an aryloxy group, an amino group, an alkylthio group, an arylthio group, a halogen atom, a carboxy group, a sulfo group, an alkyloxycarbonyl group, an aryloxycarbonyl group, groups formed by combining these, and the like. Among these, an alkyl group, an aryl group, and groups obtained by combining these are preferable.

Among these, a pyridinium group is preferable, a N-alkyl-3-pyridinium group, a N-benzyl-3-pyridinium group, a N-(alkoxypolyalkyleneoxyalkyl)-3-pyridinium group, a N-alkoxycarbonylmethyl-3-pyridinium group, a N-alkyl-4-pyridinium group, a N-benzyl-4-pyridinium group, a N-(alkoxypolyalkyleneoxyalkyl)-4-pyridinium group, a N-alkoxycarbonylmethyl-4-pyridinium group, or a N-alkyl-3,5-dimethyl-4-pyridinium group is more preferable, a N-alkyl-3-pyridinium group or a N-alkyl-4-pyridinium group is even more preferable, a N-methyl-3-pyridinium group, a N-octyl-3-pyridinium group, a N-methyl-4-pyridinium group, or a N-octyl-4-pyridinium group is particularly preferable, and a N-octyl-3-pyridinium group or a N-octyl-4-pyridinium group is most preferable.

In a case where $R^{13}$ is a pyridinium group, examples of the counteranion include a sulfonate ion, a carboxylate ion, a tetrafluoroborate ion, a hexafluorophosphate ion, a p-toluenesulfonate ion, a perchlorate ion, and the like. Among these, a p-toluenesulfonate ion or a hexafluorophosphate ion is preferable.

From the viewpoint of visibility, $R^{10}$ in Formula (1-4) is preferably an alkyl group or an aryl group. It is more

preferable that one of two $R^{10}$'s be an alkyl group and the other be an aryl group.

From the viewpoint of visibility, $R^{10}$ in Formula (1-5) is preferably an alkyl group or an aryl group, more preferably an aryl group, and even more preferably a p-methylphenyl group.

From the viewpoint of visibility, $R^{10}$ in Formula (1-6) preferably each independently represent an alkyl group or an aryl group, and more preferably each independently represent a methyl group or a phenyl group.

From the viewpoint of visibility, $Z^1$ in Formula (1-7) may be a counterion that neutralizes charge, and may be included in Za in the entirety of the compound.

$Z^1$ is preferably a sulfonate ion, a carboxylate ion, a tetrafluoroborate ion, a hexafluorophosphate ion, a p-toluenesulfonate ion, or a perchlorate ion, and more preferably a p-toluenesulfonate ion or a hexafluorophosphate ion.

The group that undergoes bond cleavage from $X_1$ by heat or exposure to infrared is particularly preferably a group represented by Formula (1-8).

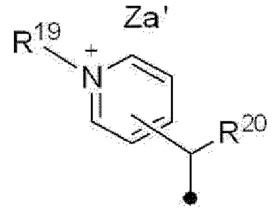

(1 - 8)

In Formula (1-8), • represents a bonding site with $X_1$ in Formula 1, $R^{19}$ and $R^{20}$ each independently represent an alkyl group, and Za' represents a counterion that neutralizes charge.

In Formula (1-8), the bonding position of a pyridinium ring and a hydrocarbon group having $R^{20}$ is preferably the 3-position or 4-position of the pyridinium ring, and more preferably the 4-position of the pyridinium ring.

The alkyl group represented by $R^{19}$ and $R^{20}$ may be linear or branched, or may have a ring structure.

Furthermore, the above alkyl group may have a substituent, and preferred examples of the substituent include an alkoxy group and a terminal alkoxypolyalkyleneoxy group.

$R^{19}$ is preferably an alkyl group having 1 to 12 carbon atoms, more preferably a linear alkyl group having 1 to 12 carbon atoms, even more preferably a linear alkyl group having 1 to 8 carbon atoms, and particularly preferably a methyl group or a n-octyl group.

$R^{20}$ is preferably an alkyl group having 1 to 8 carbon atoms, more preferably a branched alkyl group having 3 to 8 carbon atoms, even more preferably an isopropyl group or a t-butyl group, and particularly preferably an isopropyl group.

Za' may be a counterion that neutralizes charge, and may be included in Za in the entirety of the compound.

Za' is preferably a sulfonate ion, a carboxylate ion, a tetrafluoroborate ion, a hexafluorophosphate ion, a p-toluenesulfonate ion, or a perchlorate ion, and more preferably a p-toluenesulfonate ion or a hexafluorophosphate ion.

From the viewpoint of improving visibility of exposed portions, the decomposable compound as a sort of discoloring compound is preferably a cyanine dye, and more preferably a cyanine dye having a group that decomposes by exposure to infrared (specifically, $R^1$ in Formula 1-1 to Formula 1-7).

(Compound represented by Formula 1-1)

From the viewpoint of improving visibility of exposed portions, the decomposable compound as a sort of discoloring compound is more preferably a compound represented by Formula 1-1.

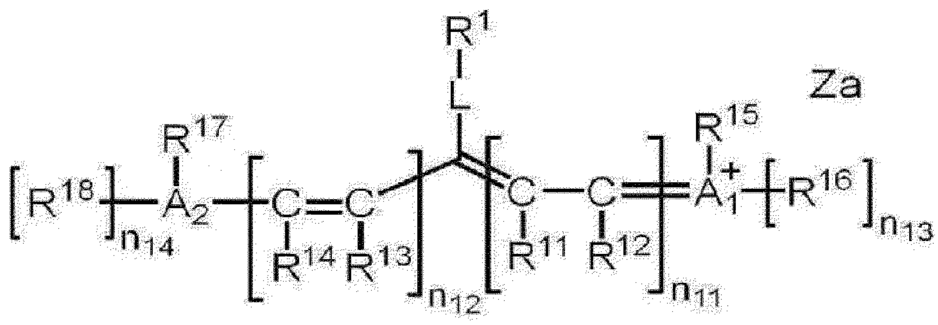

Formula 1-1

In Formula 1-1, $R^1$ represents a group that is represented by any one of Formula 2, Formula 3, or Formula 4, $R^{11}$ to

$R^{18}$ each independently represent a hydrogen atom, a halogen atom, $-R^a$, $-OR^b$, $-SR^c$, or $-NR^dR^e$, $R^a$ to $R^e$ each independently represent a hydrocarbon group, $A_1$, $A_2$, and a plurality of $R^{11}$ to $R^{18}$ may be linked to each other to form a monocyclic or polycyclic ring, $A_1$ and $A_2$ each independently represent an oxygen atom, a sulfur atom, or a nitrogen atom, $n_{11}$ and $n_{12}$ each independently represent an integer of 0 to 5, a sum of $n_{11}$ and $n_{12}$ is 2 or more, $n_{13}$ and $n_{14}$ each independently represent 0 or 1, L represents an oxygen atom, a sulfur atom, or $-NR^{10}-$, $R^{10}$ represents a hydrogen atom, an alkyl group, or an aryl group, and Za represents a counterion that neutralizes charge.

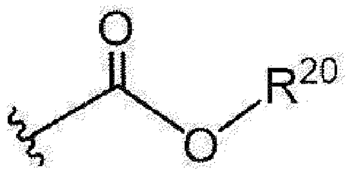

Formula 2

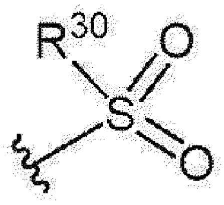

Formula 3

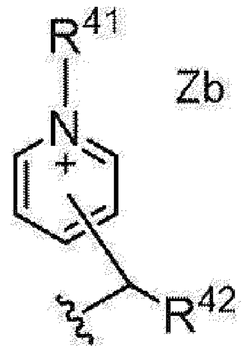

Formula 4

In Formula 2 to Formula 4, $R^{20}$, $R^{30}$, $R^{41}$, and $R^{42}$ each independently represent an alkyl group or an aryl group, Zb represents a counterion that neutralizes charge, and a wavy line represents a bonding site with L.

In a case where the compound represented by Formula 1-1 is exposed to infrared, the $R^1$-L bond is cleaved, and L turns into =O, =S, or $=NR^{10}$. Through the process as described above, the compound represented by Formula 1-1 is discolored.

In Formula 1-1, $R^1$ represents a group represented by any one of Formula 2, Formula 3, or Formula 4. Hereinafter, each of the group represented by Formula 2, the group represented by Formula 3, and the group represented by Formula 4 will be described.

In Formula 2, $R^{20}$ represents an alkyl group or an aryl group, and the portion of the wavy line represents a bonding site with L.

As the alkyl group represented by $R^{20}$, an alkyl group having 1 to 30 carbon atoms is preferable, an alkyl group having 1 to 15 carbon atoms is more preferable, and an alkyl group having 1 to 10 carbon atoms is particularly preferable. The alkyl group may be linear or branched. The above alkyl group may have a ring structure.

The aryl group represented by $R^{20}$ is preferably an aryl group having 6 to 30 carbon atoms, more preferably an aryl group having 6 to 20 carbon atoms, and particularly preferably an aryl group having 6 to 12 carbon atoms. From the viewpoint of color developability, $R^{20}$ is preferably an alkyl group.

From the viewpoint of decomposition properties and color developability, the alkyl group represented by $R^{20}$ is preferably a secondary alkyl group or a tertiary alkyl group, and more preferably a tertiary alkyl group. Furthermore, from the viewpoint of decomposition properties and color developability, the alkyl group represented by $R^{20}$ is preferably an alkyl group having 1 to 8 carbon atoms, more preferably a branched alkyl group having 3 to 10 carbon atoms, even more preferably a branched alkyl group having 3 to 6 carbon atoms, particularly preferably an isopropyl group or a tert-butyl group, and most preferably a tert-butyl group.

Specific examples of the group represented by Formula 2 will be shown below. However, the group represented by Formula 2 is not limited to the following specific examples. In the following structural formulas, • represents a bonding site with L in Formula 1-1.

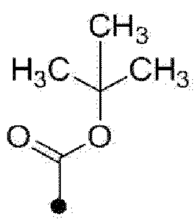
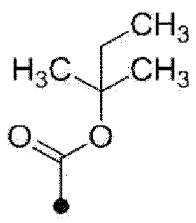
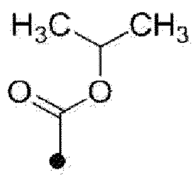
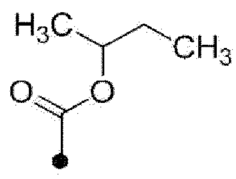
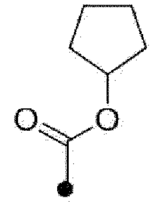

In Formula 3, $R^{30}$ represents an alkyl group or an aryl group, and the portion of the wavy line represents a bonding

site with L. The alkyl group and aryl group represented by $R^{30}$ are the same as the alkyl group and aryl group represented by $R^{20}$ in Formula 2 respectively, and preferred aspects thereof are also the same.

From the viewpoint of decomposition properties and color developability, the alkyl group represented by $R^{30}$ is preferably a secondary alkyl group or a tertiary alkyl group, and more preferably a tertiary alkyl group. Furthermore, from the viewpoint of decomposition properties and color developability, the alkyl group represented by $R^{30}$ is preferably an alkyl group having 1 to 8 carbon atoms, more preferably a branched alkyl group having 3 to 10 carbon atoms, even more preferably a branched alkyl group having 3 to 6 carbon atoms, particularly preferably an isopropyl group or a tert-butyl group, and most preferably a tert-butyl group. In addition, from the viewpoint of decomposition properties and color developability, the alkyl group represented by $R^{30}$ is preferably a substituted alkyl group, more preferably a fluoro-substituted alkyl group, even more preferably a perfluoroalkyl group, and particularly preferably a trifluoromethyl group.

From the viewpoint of decomposition properties and color developability, the aryl group represented by $R^{30}$ is preferably a substituted aryl group. Examples of the substituent in the substituted aryl group include an alkyl group (preferably an alkyl group having 1 to 4 carbon atoms) and an alkoxy group (preferably an alkoxy group having 1 to 4 carbon atoms).

Specific examples of the group represented by Formula 3 will be shown below. However, the group represented by Formula 3 is not limited to the following specific examples. In the following structural formulas, • represents a bonding site with L in Formula 1-1.

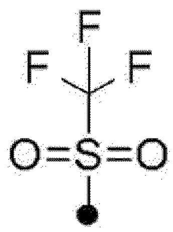

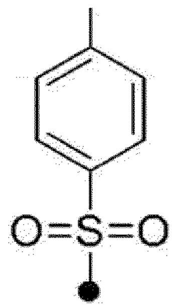

In Formula 4, $R^{41}$ and $R^{42}$ each independently represent an alkyl group or an aryl group, Zb represents a counterion that neutralizes charge, and the portion of the wavy line represents a bonding site with L. The alkyl group and aryl group represented by $R^{41}$ or $R^{42}$ are the same as the alkyl group and aryl group represented by $R^{20}$ in Formula 2 respectively, and preferred aspects thereof are also the same.

From the viewpoint of decomposition properties and color developability, $R^{41}$ in Formula 4 is preferably an alkyl group. From the viewpoint of decomposition properties and color developability, the alkyl group represented by $R^{41}$ is preferably an alkyl group having 1 to 8 carbon atoms, more preferably an alkyl group having 1 to 4 carbon atoms, and particularly preferably a methyl group.

From the viewpoint of decomposition properties and color developability, $R^{42}$ in Formula 4 is preferably an alkyl group. From the viewpoint of decomposition properties and color developability, the alkyl group represented by $R^{42}$ is preferably a secondary alkyl group or a tertiary alkyl group, and more preferably a tertiary alkyl group. Furthermore, from the viewpoint of decomposition properties and color developability, the alkyl group represented by $R^{42}$ is preferably an alkyl group having 1 to 8 carbon atoms, more preferably a branched alkyl group having 3 to 10 carbon atoms, even more preferably a branched alkyl group having 3 to 6 carbon atoms, particularly preferably an isopropyl group or a tert-butyl group, and most preferably a tert-butyl group.

Zb in Formula 4 may be a counterion that neutralizes charge, and may be included in Za in Formula 1-1 in the entirety of the compound. Zb is preferably a sulfonate ion, a carboxylate ion, a tetrafluoroborate ion, a hexafluorophosphate ion, a p-toluenesulfonate ion, or a perchlorate ion, and more preferably a tetrafluoroborate ion.

Specific examples of the group represented by Formula 4 will be shown below. However, the group represented by Formula 4 is not limited to the following specific examples. In the following structural formulas, • represents a bonding site with L in Formula 1-1.

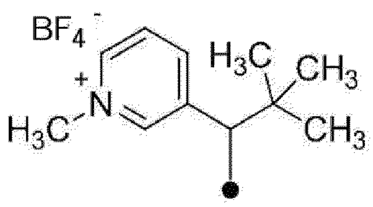

L in Formula 1-1 is preferably an oxygen atom or $-NR^{10}-$, and more preferably an oxygen atom.

$R^{10}$ in $-NR^{10}-$ is preferably an alkyl group. The alkyl group represented by $R^{10}$ is preferably an alkyl group having 1 to 10 carbon atoms. The alkyl group represented by $R^{10}$ may be linear or branched. The alkyl group represented by $R^{10}$ may have a ring structure. The alkyl group is preferably a methyl group or a cyclohexyl group.

The aryl group represented by $R^{10}$ in $-NR^{10}-$ is preferably an aryl group having 6 to 30 carbon atoms, more preferably an aryl group having 6 to 20 carbon atoms, and particularly preferably an aryl group having 6 to 12 carbon atoms. The aryl group may have a substituent.

In Formula 1-1, $R^{11}$ to $R^{18}$ preferably each independently represent a hydrogen atom, $-R^a$, $-OR^b$, $-SR^c$, or $-NR^dR^e$.

The hydrocarbon group represented by $R^a$ to $R^e$ is preferably a hydrocarbon group having 1 to 30 carbon atoms, more preferably a hydrocarbon group having 1 to 15 carbon atoms, and particularly preferably a hydrocarbon group having 1 to 10 carbon atoms. The hydrocarbon group may be linear or branched. The hydrocarbon group may have a ring structure. The hydrocarbon group is preferably an alkyl group. The alkyl group is preferably an alkyl group having 1 to 30 carbon atoms, more preferably an alkyl group having 1 to 15 carbon atoms, and particularly preferably an alkyl group having 1 to 10 carbon atoms. The alkyl group may be linear or branched. The above alkyl group may have a ring structure. Examples of the alkyl group include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbornyl group. Among the above alkyl groups, a methyl group, an ethyl group, a propyl group, or a butyl group is preferable. The above alkyl group may have a substituent. Examples of the substituent include an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, and groups obtained by combining these.

$R^{11}$ to $R^{14}$ in Formula 1-1 preferably each independently represent a hydrogen atom or $-R^a$ (that is, a hydrocarbon group), and more preferably each independently represent a hydrogen atom or an alkyl group. It is preferable that $R^{11}$ to $R^{14}$ in Formula 1-1 each independently represent a hydrogen atom, except for the following cases.

In Formula 1-1, each of $R^{11}$ and $R^{13}$ bonded to the carbon atom that is bonded to the carbon atom to which L is bonded is preferably an alkyl group. It is more preferable that $R^{11}$ and $R^{13}$ be linked to each other to form a ring. The ring to be formed may be a monocyclic ring or a polycyclic ring. Examples of the monocyclic ring to be formed include a cyclopentene ring, a cyclopentadiene ring, a cyclohexene ring, and a cyclohexadiene ring. Examples of the polycyclic ring include an indene ring and an indole ring.

In Formula 1-1, it is preferable that $R^{12}$ bonded to the carbon atom to which $A_1$ is bonded be linked to $R^{15}$ or $R^{16}$ (preferably $R^{16}$) to form a ring. It is preferable that $R^{14}$ bonded to the carbon atom to which $A_2$ is bonded be linked to $R^{17}$ or $R^{18}$ (preferably $R^{18}$) to form a ring.

In Formula 1-1, $n_{13}$ is preferably 1, and $R^{16}$ is preferably $-R^a$ (that is, a hydrocarbon group).

In Formula 1-1, it is preferable that $R^{16}$ be linked to $R^{12}$ bonded to the carbon atom to which $A_1$ is bonded, so as to form a ring. As the ring to be formed, an indolium ring, a pyrylium ring, a thiopyrylium ring, a benzoxazoline ring, or a benzimidazoline ring is preferable, and an indolium ring is more preferable from the viewpoint of improving visibility of exposed portions. These rings may further have a substituent.

In Formula 1-1, $n_{14}$ is preferably 1, and $R^{18}$ is preferably $-R^a$ (that is, a hydrocarbon group).

In Formula 1-1, it is preferable that $R^{18}$ be linked to $R^{14}$ bonded to the carbon atom to which $A_2$ is bonded, so as to form a ring. As the ring to be formed, an indole ring, a pyran ring, a thiopyran ring, a benzoxazole ring, or a benzimidazole ring is preferable, and an indole ring is more preferable from the viewpoint of improving visibility of exposed portions. These rings may further have a substituent.

It is preferable that $R^{16}$ and $R^{18}$ in Formula 1-1 be the same group. In a case where $R^{16}$ and $R^{18}$ each form a ring, it is preferable that the formed rings have the same structure except for $A_1$ and $A_2$.

It is preferable that $R^{15}$ and $R^{17}$ in Formula 1-1 be the same group. $R^{15}$ and $R^{17}$ are preferably $-R^a$ (that is, a hydrocarbon group), more preferably an alkyl group, and particularly preferably a substituted alkyl group.

From the viewpoint of improving water solubility of the compound represented by Formula 1-1, $R^{15}$ and $R^{17}$ are preferably a substituted alkyl group. Examples of the substituted alkyl group include a group represented by Formula (a1) to Formula (a4).

$$-W\left(R^{W0}-O\right)_{n_{W1}}-R^{W1} \qquad (a1)$$

$-R^{W2}-CO_2M$ (a2)

$-R^{W3}-PO_3M_2$ (a3)

$-R^{W4}-SO_3M$ (a4)

In Formula (a1) to Formula (a4), $R^{W0}$ represents an alkylene group having 2 to 6 carbon atoms, W represents a single bond or an oxygen atom, and $n_{W1}$ represents an integer of 1 to 45, $R^{W1}$ represents an alkyl group having 1 to 12 carbon atoms or $-C(=O)-R^{W5}$, $R^{W5}$ represents an alkyl group having 1 to 12 carbon atoms, $R^{W2}$ to $R^{W4}$ each independently represent a single bond or an alkylene group having 1 to 12 carbon atoms, and M represents a hydrogen atom, a sodium atom, a potassium atom, or an onium group.

Specific examples of the alkylene group represented by $R^{W0}$ in Formula (a1) include an ethylene group, a n-propylene group, an isopropylene group, a n-butylene group, an isobutylene group, a n-pentylene group, an isopentylene group, a n-hexyl group, and an isohexyl group. Among these, an ethylene group, a n-propylene group, an isopropylene group, or a n-butylene group is preferable, and a n-propylene group is more preferable.

$n_{W1}$ in Formula (a1) is preferably 1 to 10, more preferably 1 to 5, and particularly preferably 1 to 3.

Specific examples of the alkyl group represented by $R^{W1}$ in Formula (a1) include a methyl group, an ethyl group, a n-propyl group, an isopropyl group, a n-butyl group, an isobutyl group, a tert-butyl group, a n-pentyl group, an isopentyl group, a neopentyl group, a n-hexyl group, a n-octyl group, and a n-dodecyl group. Among these, a methyl group, an ethyl group, a n-propyl group, an isopropyl group, a n-butyl group, or a tert-butyl group is preferable, a methyl group or an ethyl group is more preferable, and a methyl group is particularly preferable.

The alkyl group represented by $R^{W5}$ in Formula (a1) is the same as the alkyl group represented by $R^{W1}$, and preferred aspects thereof are also the same.

Specific examples of the group represented by Formula (a1) will be shown below. However, the group represented by Formula (a1) is not limited to the following specific examples. **In** the following structural formulas, Me represents a methyl group, Et represents an ethyl group, and * represents a bonding site.

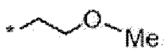 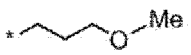 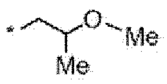 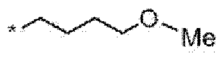 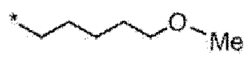

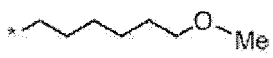 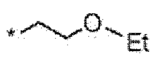 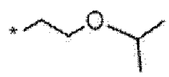 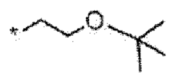

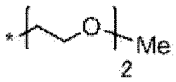 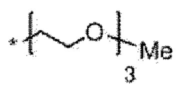 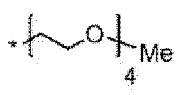 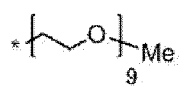 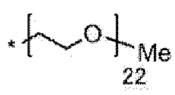

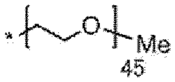 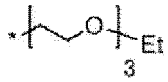 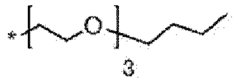 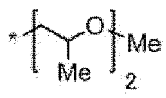 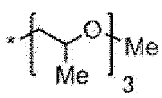

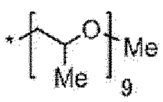 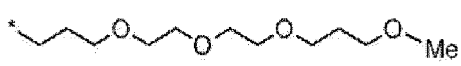

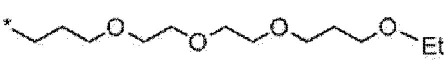 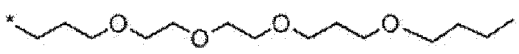

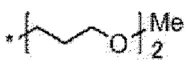 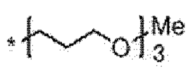 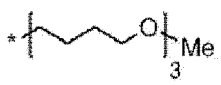

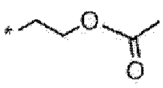 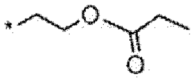 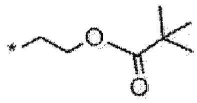 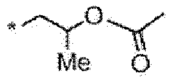 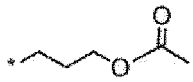

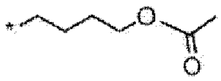 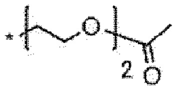 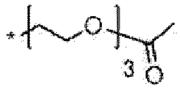 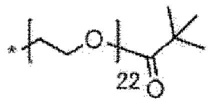

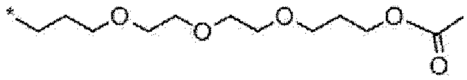

Specific examples of the alkylene group represented by $R^{W2}$ to $R^{W4}$ in Formula (a2) to Formula (a4) include a methylene group, an ethylene group, a n-propylene group, an isopropylene group, a n-butylene group, an isobutylene group, a n-pentylene group, an isopentylene group, a n-hexyl group, an isohexyl group, a n-octylene group, and a n-dodecylene group. Among these, an ethylene group, a n-propylene group, an isopropylene group, or a n-butylene group is preferable, and an ethylene group or a n-propylene group is more preferable.

In Formula (a3), two Ms may be the same as or different from each other.

Examples of the onium group represented by M in Formula (a2) to Formula (a4) include an ammonium group, an iodonium group, a phosphonium group, and a sulfonium group.

All of $CO_2M$ in Formula (a2), $PO_3M_2$ in Formula (a2), and $SO_3M$ in Formula (a4) may have an anion structure from which M is dissociated. The countercation of the anion structure may be $A_1^+$ or a cation that can be contained in $R^1$-L in Formula 1-1.

Among the groups represented by Formula (a1) to Formula (a4), the group represented by Formula (a1), Formula (a2), or Formula (a4) is preferable.

$n_{11}$ and $n_{12}$ in Formula 1-1 are preferably the same as each other, and preferably both represent an integer of 1 to 5, more preferably both represent an integer of 1 to 3, even more preferably both represent 1 or 2, and particularly preferably both represent 2.

$A_1$ and $A_2$ in Formula 1-1 each independently represent an oxygen atom, a sulfur atom, or a nitrogen atom. Among these, a nitrogen atom is preferable. $A_1$ and $A_2$ in Formula 1-1 are preferably the same atoms.

Za in Formula 1-1 represents a counterion that neutralizes charge. In a case where all of $R^{11}$ to $R^{18}$ and $R^1$-L are groups having a neutral charge, Za is a monovalent counteranion. Here, $R^{11}$ to $R^{18}$ and $R^1$-L may have an anion structure or a cation structure. For example, in a case where $R^{11}$ to $R^{18}$ and $R^1$-L contain two or more anion structures, Za can also be a countercation. In a case where the compound represented by Formula 1-1 has such a structure that the overall charge of the compound is neutral except for Za, Za is unnecessary. In a case where Za is a counteranion, examples of the counteranion include a sulfonate ion, a carboxylate ion, a tetrafluoroborate ion, a hexafluorophosphate ion, a p-toluenesulfonate ion, and a perchlorate ion. Among these, a tetrafluoroborate ion is preferable. In a case where Za is a countercation, examples of the countercation include an alkali metal ion, an alkaline earth metal ion, an ammonium ion, a pyridinium ion, and a sulfonium ion. Among these, a sodium ion, a potassium ion, an ammonium ion, a pyridinium ion, or a sulfonium ion is preferable, and a sodium ion, a potassium ion, or an ammonium ion is more preferable.

(Compound represented by Formula 1-2)

The decomposable compound as a sort of discoloring compound is preferably a compound represented by Formula 1-2. The compound represented by Formula 1-2 is a cyanine dye.

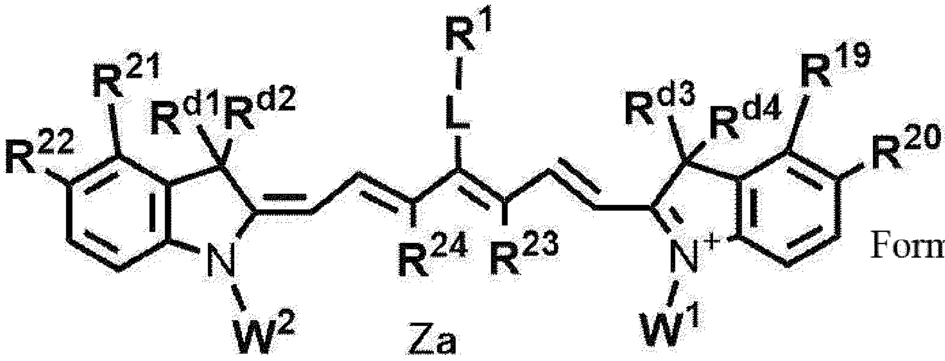

Formula 1-2

In Formula 1-2, $R^1$ represents a group that is represented by any one of Formula 2, Formula 3, or Formula 4, $R^{19}$ to $R^{22}$ each independently represent a hydrogen atom, a halogen atom, $-R^a$, $-OR^b$, -CN, $-SR^c$, or $-NR^dR^e$, $R^{23}$ and $R^{24}$ each independently represent $-R^a$, $R^a$ to $R^e$ each independently represent a hydrocarbon group, $R^{19}$ and $R^{20}$, $R^{21}$ and $R^{22}$, or $R^{23}$ and $R^{24}$ may be linked to each other to form a monocyclic or polycyclic ring, L represents an oxygen atom, a sulfur atom, or $-NR^{10}-$, $R^{10}$ represents a hydrogen atom, an alkyl group, or an aryl group, $R^{d1}$ to $R^{d4}$, $W^1$, and $W^2$ each independently represent an alkyl group which may have a substituent, and Za represents a counterion that neutralizes charge.

$R^1$ in Formula 1-2 has the same definition as $R^1$ in Formula 1-1, and preferred aspects thereof are also the same.

In Formula 1-2, $R^{19}$ to $R^{22}$ preferably each independently represent a hydrogen atom, a halogen atom, $-R^a$, $-OR^b$, or -CN. $R^{19}$ and $R^{21}$ are preferably a hydrogen atom or $-R^a$. $R^{20}$ and $R^{22}$ are preferably a hydrogen atom, $-R^a$, $-OR^b$, or -CN.

In Formula 1-2, $-R^a$ represented by $R^{19}$ to $R^{22}$ is preferably an alkyl group or an alkenyl group. In a case where all of $R^{19}$ to $R^{22}$ are $-R^a$, it is preferable that $R^{19}$ and $R^{20}$ and $R^{21}$ and $R^{22}$ be linked to each other to form a monocyclic or polycyclic ring. Examples of the ring formed of $R^{19}$ and $R^{20}$ or $R^{21}$ and $R^{22}$ linked to each other include a benzene ring and a naphthalene ring.

$R^{23}$ and $R^{24}$ in Formula 1-2 are preferably linked to each other to form a monocyclic or polycyclic ring. The ring formed of $R^{23}$ and $R^{24}$ linked to each other may be a monocyclic or polycyclic ring. Examples of the monocyclic ring to be formed include a cyclopentene ring, a cyclopentadiene ring, a cyclohexene ring, and a cyclohexadiene ring. Examples of the polycyclic ring include an indene ring.

$R^{d1}$ to $R^{d4}$ in Formula 1-2 are preferably an unsubstituted alkyl group. Furthermore, all of $R^{d1}$ to $R^{d4}$ are preferably the same group. Examples of the unsubstituted alkyl group include unsubstituted alkyl groups having 1 to 4 carbon atoms. Among these, a methyl group is preferable.

From the viewpoint of improving water solubility of the compound represented by Formula 1-2, $W^1$ and $W^2$ in Formula 1-2 preferably each independently represent a substituted alkyl group. Examples of the substituted alkyl group represented by $W^1$ and $W^2$ include groups represented by Formula (a1) to Formula (a4) described above in the section of "Compound represented by Formula 1-1", and preferred aspects thereof are also the same. From the viewpoint of on-press developability, $W^1$ and $W^2$ preferably each independently represent an alkyl group having a substituent. The substituent is preferably a group having at least $-(OCH_2CH_2)-$, a sulfo group, a salt of a sulfo group, a carboxy group, or a salt of a carboxy group.

In Formula 1-2, Za represents a counterion that neutralizes charge in the molecule. In a case where all of $R^{19}$ to $R^{22}$, $R^{23}$ and $R^{24}$, $R^{d1}$ to $R^{d4}$, $W^1$, $W^2$, and $R^1$-L are groups having a neutral charge, Za is a monovalent counteranion. Here, $R^{19}$ to $R^{22}$, $R^{23}$ and $R^{24}$, $R^{d1}$ to $R^{d4}$, $W^1$, $W^2$, and $R^1$-L may have an anion structure or a cation structure. For example, in a case where $R^{19}$ to $R^{22}$, $R^{23}$ and $R^{24}$, $R^{d1}$ to $R^{d4}$, $W^1$, $W^2$, and $R^1$-L contain two or more anion structures, Za can also be a countercation. In a case where the compound represented by Formula 1-2 has such a structure that the overall charge of the compound is neutral except for Za, Za is unnecessary. Examples of the case where Za is a counteranion are the same as such examples of Za in Formula 1-1, and preferred aspects thereof are also the same. Furthermore, examples of the case where Za is a countercation are the same as such examples of Za in Formula 1-1, and preferred aspects thereof are also the same.

(Compound represented by Formula 1-3 to compound represented by Formula 1-7)

From the viewpoint of decomposition properties and color developability, the decomposable compound as a sort of discoloring compound is preferably a compound represented by any one of Formula 1-3, Formula 1-4, Formula 1-5, Formula 1-6, or Formula 1-7, and more preferably a compound represented by any one of Formula 1-3, Formula 1-5, or Formula 1-6. The compound represented by Formula 1-3 to Formula 1-7 is a cyanine dye.

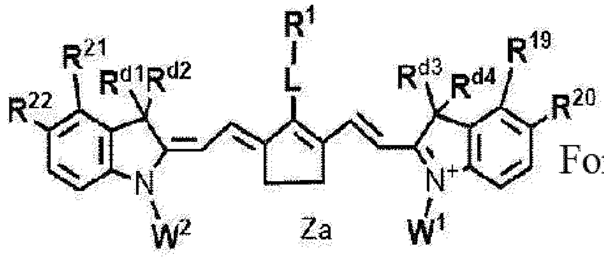

Formula 1-3

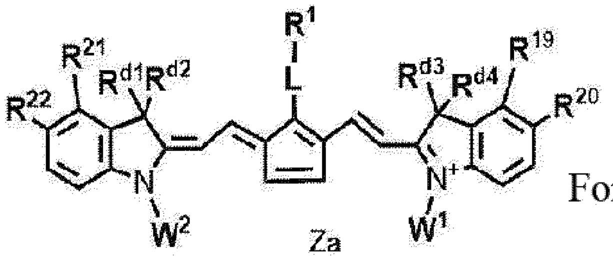

Formula 1-4

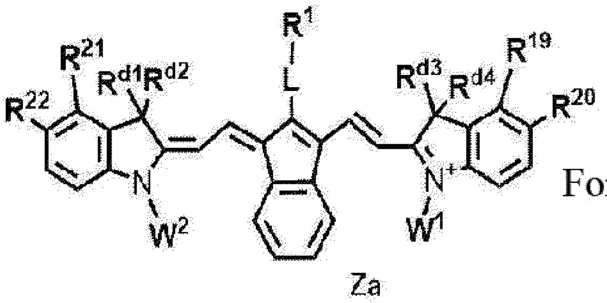

Formula 1-5

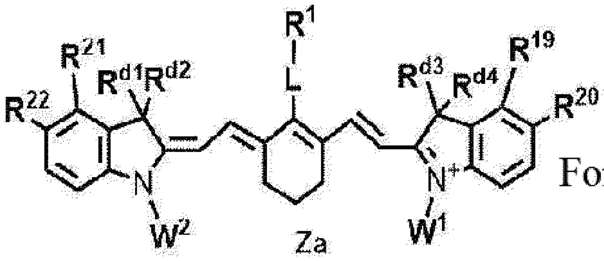

Formula 1-6

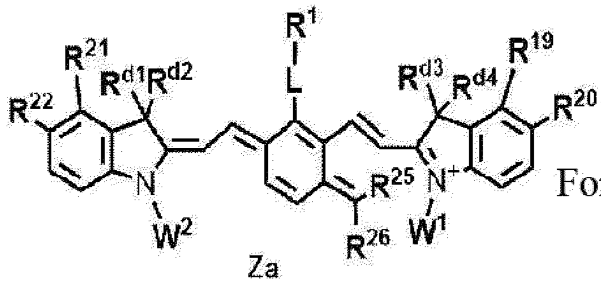

Formula 1-7

In Formula 1-3 to Formula 1-7, $R^1$ represents a group that is represented by any one of Formula 2, Formula 3, or Formula 4, $R^{19}$ to $R^{22}$ each independently represent a hydrogen atom, a halogen atom, $-R^a$, $-OR^b$, -CN, $-SR^c$, or $-NR^dR^e$, $R^{23}$ and $R^{24}$ each independently represent $-R^a$, $R^{25}$ and $R^{26}$ each independently represent a hydrogen atom, a halogen atom, or $-R^a$, $R^a$ to $R^e$ each independently represent a hydrocarbon group, $R^{19}$ and $R^{20}$, $R^{21}$ and $R^{22}$, $R^{23}$ and $R^{24}$, or $R^{25}$ and $R^{26}$ may be linked to each other to form a monocyclic or polycyclic ring, L represents an oxygen atom, a sulfur atom, or $-NR^{10}-$, $R^{10}$ represents a hydrogen atom, an alkyl group, or an aryl group, $R^{d1}$ to $R^{d4}$, $W^1$, and $W^2$ each independently represent an alkyl group which may have a substituent, and Za represents a counterion that neutralizes charge.

$R^1$, $R^{19}$ to $R^{22}$, $R^{d1}$ to $R^{d4}$, $W^1$, $W^2$, and L in Formula 1-3 to Formula 1-7 have the same definitions as $R^1$, $R^{19}$ to

$R^{22}$, $R^{d1}$ to $R^{d4}$, $W^1$, $W^2$, and L in Formula 1-2, and preferred aspects thereof are also the same. $R^{25}$ and $R^{26}$ in Formula 1-7 preferably each independently represent a hydrogen atom or an alkyl group, more preferably each independently represent an alkyl group, and particularly preferably each independently represent a methyl group.

Specific examples of the cyanine dye included in the decomposable compound will be shown below. However, the cyanine dye is not limited to the following specific examples.

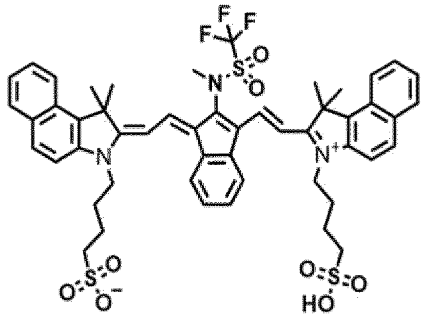

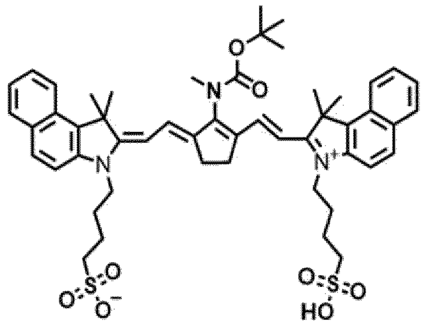

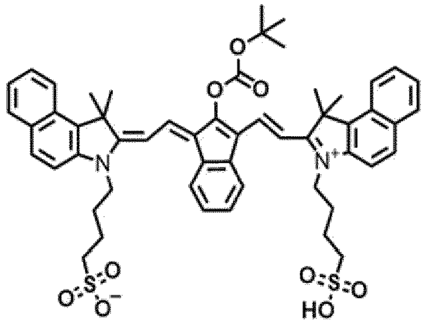

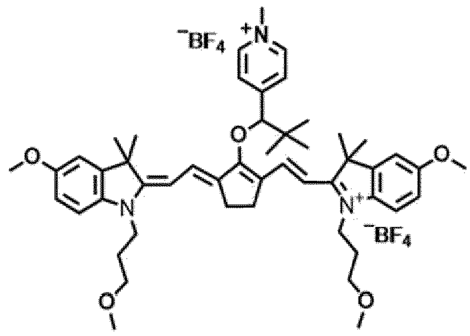

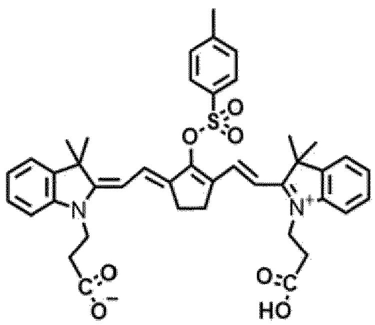

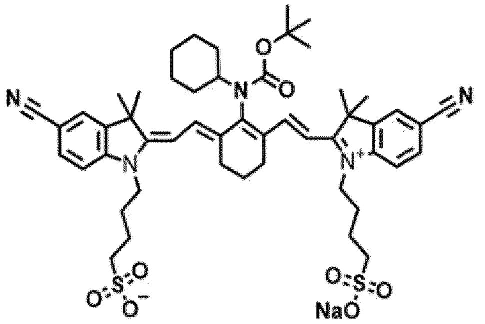

As the cyanine dye included in the decomposable compound, the infrared absorbing compound described in WO2019/219560A can be suitably used.

The discoloring compound may include an acid color developing agent. As the acid color developing agent, for example, it is possible to use the acid color developing agent that will be described below in the section of "Image-recording layer", and preferred aspects thereof are also the same. As the discoloring compound, the decomposable compound described above and the acid generator that will be described later may be used in combination.

The outermost layer may contain one kind of discoloring compound or two or more kinds of discoloring compounds.

From the viewpoint of color developability, the content of the discoloring compound in the outermost layer with respect to the total mass of the outermost layer is preferably 0.10% by mass to 50% by mass, more preferably 0.50% by mass to 30% by mass, and particularly preferably 1.0% by mass to 20% by mass.

From the viewpoint of color developability, a ratio of a content ($M^X$) of the discoloring compound in the outermost layer to a content ($M^Y$) of the infrared absorber in the image-recording layer ($M^X/M^Y$) is preferably 0.1 or more, more preferably 0.2 or more, and particularly preferably 0.3 or more and 3.0 or less.

[Other components]

The outermost layer may contain, as other components, components different from the above components. Examples of those other components include an oil sensitizing agent, an acid generator, and an infrared absorber.
The acid generator is a compound that generates an acid by light or heat. Examples of the acid generator include a compound that decomposes by exposure to infrared and generates an acid. The acid to be generated is preferably a strong acid having a pKa of 2 or less (for example, sulfonic acid or hydrochloric acid). The acid generated from the acid generator enables the acid color developing agent to discolor. As the acid generator, from the viewpoint of sensitivity and stability, an onium salt compound is preferable. Specific examples of onium salts suitable as the acid generator include the compounds described in paragraphs "0121" to "0124" of WO2016/047392A. The acid generator is preferably sulfonate, carboxylate, $BPh_4^-$, $BF_4^-$, $PF_6^-$, or $ClO_4^-$ of triarylsulfonium or diaryliodonium. Ph represents a phenyl group.
Examples of the infrared absorber include the infrared absorber that will be described below in the section of "Image-recording layer".

[Formation method]

The outermost layer can be formed by a known method (for example, a coating method). The coating amount (solid content) of the outermost layer is preferably 5 mg/m$^2$ to 2,000 mg/m$^2$, and more preferably 20 mg/m$^2$ to 1,000 mg/m$^2$. Herein, "solid content" refers to components other than solvents.

<<Brightness change>>

In a certain embodiment, in a case where the lithographic printing plate precursor is subjected to exposure to infrared at a wavelength of 830 nm at an energy density of 110 mJ/cm$^2$, a brightness change ΔL before and after the exposure is preferably 2.0 or more, more preferably 3.0 or more, even more preferably 5.0 or more, particularly preferably 8.0 or more, and most preferably 10.0 or more. In a case where the brightness change ΔL is in the above range, the visibility of exposed portions can be improved. The upper limit of the brightness change ΔL is not limited. The upper limit of the brightness change ΔL is, for example, 20.0. Especially, in a case where the outermost layer contains a discoloring compound, it is preferable that the brightness change ΔL satisfy the above range.
The brightness change ΔL is measured by the following method. By using Luxel PLATESETTER T-9800 manufactured by Fujifilm Global Graphic Systems Co., Ltd. that is equipped with an infrared semiconductor laser with a wavelength of 830 nm, the lithographic printing plate precursor is exposed under the conditions of output of 99.5%, outer drum rotation speed of 220 rpm (revolutions per minute), and resolution of 2,400 dpi (dots per inch, 1 inch = 25.4 mm (energy density: 110 mJ/cm$^2$). The exposure is performed in an environment at 25°C and 50% RH (relative humidity). The brightness change of the lithographic printing plate precursor before and after exposure is measured. The brightness is measured using a spectrocolorimeter eXact manufactured by X-Rite, Incorporated. Specifically, from the side of the outermost layer of the lithographic printing plate precursor, the L* value (brightness) in the L*a*b* color system is measured, and the absolute value of a difference between the L* value of an exposed portion and the L* value of a non-exposed portion is adopted as the brightness change ΔL.

<<Support>>

The on-press development type lithographic printing plate precursor according to an embodiment of the present invention has a support. The support to be used can be appropriately selected from known supports used in a lithographic printing plate precursor. As the support, a support having a hydrophilic surface is preferable.
As the support, an aluminum plate is preferable which has been roughened using a known method and has undergone an anodization treatment. Specifically, the support preferably has an aluminum plate and an anodic oxide film of aluminum disposed on the aluminum plate.
The anodic oxide film of aluminum is preferably positioned such that the anodic oxide film of aluminum is closer to the side of the image-recording layer than the aluminum plate. The anodic oxide film of aluminum preferably has micropores extending in a depth direction from a surface of the anodic oxide film on the side of the image-recording layer.
Hereinafter, preferred aspects of the support will be described with reference to the drawings. Fig. 1 is a schematic cross-sectional view of a support according to an embodiment. The aluminum support 12a shown in Fig. 1 has a structure in which an aluminum plate 18 and an anodic oxide film 20a of aluminum (hereinafter, also simply called "anodic oxide film 20a") are laminated in this order. The anodic oxide film 20a in the aluminum support 12a is positioned such that the anodic oxide film 20a is closer to the side of the image-recording layer than the aluminum plate 18. That is, it is preferable that the lithographic printing plate precursor according to a certain embodiment have at least an aluminum plate, an anodic oxide film of aluminum disposed on the aluminum plate, an image-recording layer, and an outermost layer in this

order.

Hereinafter, preferred aspects of the anodic oxide film 20a will be described. The anodic oxide film 20a is a film prepared on the surface of the aluminum plate 18 by an anodization treatment. The anodic oxide film 20a has ultrafine micropores 22a that are approximately perpendicular to the surface of the film and evenly distributed. The micropores 22a extend from a surface of the anodic oxide film 20a on the image-recording layer side (that is, a surface of the anodic oxide film 20a opposite to the aluminum plate 18) along the depth direction (that is, toward the aluminum plate 18).

Within the surface of the anodic oxide film 20a, the average diameter (that is, average opening diameter) of the micropores 22a is more than 10 nm and 100 nm or less. In a case where the average diameter of the micropores 22a within the surface of the anodic oxide film 20a exceeds 10 nm, the printing durability and the image visibility are improved. In a case where the average diameter of the micropores 22a within the surface of the anodic oxide film 20a is 100 nm or less, printing durability is improved. From the viewpoint of balance between printing durability, antifouling properties, and image visibility, the average diameter of the micropores 22a within the surface of the anodic oxide film 20a is preferably 15 nm to 60 nm, more preferably 20 nm to 50 nm, and particularly preferably 25 nm to 40 nm. The inner diameter of the micropores 22a may be wider or smaller than the opening diameter of the micropores 22a. The average diameter of the micropores 22a within the surface of the anodic oxide film 20a is a value determined by observing 4 sites within the surface of the anodic oxide film 20a with a field emission scanning electron microscope (FE-SEM) at 150,000X magnification, measuring the size (diameter) of 50 micropores existing in a range of 400 nm $\times$ 600 nm in the obtained 4 images, and calculating the average of the measured values. In a case where the shape of the observed micropores 22a is not circular, the equivalent circular diameter is used. "Equivalent circular diameter" is a diameter determined on an assumption that the opening portion is in the form of a circle having the same projected area as the projected area of the opening portion.

The shape of the micropores 22a in the depth direction is not limited. The micropores 22a shown in Fig. 1 have a substantially straight tubular shape (substantially cylindrical shape). The micropores 22a may have a conical shape that tapers along the depth direction (thickness direction). The shape of the bottom portion of the micropores 22a is not limited. The shape of the bottom portion of the micropores 22a may be a curved (convex) or planar shape.

In the support, the micropores may be each have a large diameter portion that extends to a position at a certain depth from the surface of the anodic oxide film and a small diameter portion that is in communication with a bottom portion of the large diameter portion and extends to a position at a certain depth from the communicate position with the large diameter portion. The term "large diameter" used for the large diameter portion and the term "small diameter" used for the small diameter portion mean a relative size relationship relative to the diameter of the pore portion. That is, the diameter of the large diameter portion may be larger than the diameter of the small diameter portion.

Fig. 2 is a schematic cross-sectional view of a support according to another embodiment. For example, as shown in Fig. 2, an aluminum support 12b has an aluminum plate 18 and an anodic oxide film 20b having micropores 22b each having a large diameter portion 24 and a small diameter portion 26. For example, the micropores 22b in the anodic oxide film 20b have the large diameter portion 24 that extends to a position at a depth of 10 nm to 1,000 nm (that is, a depth D shown in Fig. 2) from the surface of the anodic oxide film 20b and the small diameter portion 26 that is in communication with the bottom portion of the large diameter portion 24 and further extends from the communicate position with the large diameter portion 24 to a position at a depth of 20 nm to 2,000 nm. As specific aspects of the large diameter portion and the small diameter portion, for example, it is possible to use the aspects described in paragraphs "0107" to "0114" of JP2019-162855A.

In a certain embodiment, the support preferably has an aluminum plate and an anodic oxide film of aluminum disposed on the aluminum plate, the anodic oxide film is preferably at a position closer to a side of the image-recording layer than the aluminum plate and preferably has micropores extending in a depth direction from the surface of the anodic oxide film on the side of the image-recording layer, and the average diameter of the micropores within the surface of the anodic oxide film is preferably more than 10 nm and 100 nm or less. Furthermore, the micropores preferably each have a large diameter portion that extends to a position at a depth of 10 nm to 1,000 nm from the surface of the anodic oxide film and a small diameter portion that is in communication with a bottom portion of the large diameter portion and extends to a position at a depth of 20 nm to 2,000 nm from a communicate position with the large diameter portion, an average diameter of the large diameter portion within the surface of the anodic oxide film is preferably 15 nm to 100 nm, and an average diameter of the small diameter portion at the communicate position is preferably 13 nm or less.

[Manufacturing method of support]

As a manufacturing method of the support, for example, a manufacturing method is preferable in which the following steps are sequentially performed.

(1) Roughening treatment step: step of performing roughening treatment on aluminum plate

(2) Anodization treatment step: step of subjecting aluminum plate having undergone roughening treatment to anodization

(3) Pore widening treatment step: step of bringing aluminum plate having anodic oxide film obtained by anodization treatment step into contact with aqueous acid solution or aqueous alkali solution such that diameter of micropores in anodic oxide film increases

Hereinafter, the procedure of each step will be specifically described.

(Roughening treatment step)

The roughening treatment step is carried out, for example, by performing a roughening treatment including an electrochemical roughening treatment on the surface of the aluminum plate. The roughening treatment step is preferably performed before the anodization treatment step which will be described later. However, in a case where the surface of the aluminum plate already has a preferable shape, the roughening treatment step may not be performed. The roughening treatment step can be carried out by the method described in paragraphs "0086" to "0101" of JP2019-162855A.

(Anodization treatment step)

The procedure of the anodization treatment step is not particularly limited as long as the aforementioned micropores can be obtained, and can use known methods. In the anodization treatment step, for example, an aqueous solution of sulfuric acid, phosphoric acid, or oxalic acid can be used as an electrolytic solution. For example, the concentration of sulfuric acid is 100 g/L to 300 g/L. The conditions of the anodization treatment are appropriately set depending on the electrolytic solution used. Examples thereof include conditions in which the liquid temperature is 5°C to 70°C (preferably 10°C to 60°C), the current density is 0.5 A/dm$^2$ to 60 A/dm$^2$ (preferably 1 A/dm$^2$ to 60 A/dm$^2$), the voltage is 1 V to 100 V (preferably 5 V to 50 V), the electrolysis time is 1 second to 100 seconds (preferably 5 seconds to 60 seconds), and the film amount is 0.1 g/m$^2$ to 5 g/m$^2$ (preferably 0.2 g/m$^2$ to 3 g/m$^2$).

(Pore widening treatment step)

The pore widening treatment step is a treatment of enlarging the diameter of micropores present in the anodic oxide film formed by the aforementioned anodization treatment step. The pore widening treatment can be carried out by bringing the aluminum plate obtained by the anodization treatment step into contact with an aqueous acid solution or an aqueous alkali solution. The contact method is not particularly limited, and examples thereof include a dipping method and a spraying method.

<<Image-recording layer>>

The on-press development type lithographic printing plate precursor according to an embodiment of the present invention has an image-recording layer. The image-recording layer is preferably a negative tone image-recording layer. The image-recording layer preferably contains a polymerization initiator and a polymerizable compound, and more preferably contains an infrared absorber, a polymerization initiator, and a polymerizable compound.

[Infrared absorber]

It is preferable that the image-recording layer contain an infrared absorber. Examples of the infrared absorber include pigments and dyes.

Examples of the dye that is used as the infrared absorber include commercially available dyes and known dyes (for example, the dyes described in "Dye Handbooks" (edited by the Society of Synthetic Organic Chemistry, Japan, 1970)). Specific examples of the dye include an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium colorant, a pyrylium salt, and a metal thiolate complex.

Preferred examples of the dye include a cyanine dye, a squarylium colorant, a pyrylium salt, a nickel thiolate complex, and an indolenine cyanine dye. More preferred examples of the dye include a cyanine dye and an indolenine cyanine dye. Among these, a cyanine dye is particularly preferable.

The infrared absorber is preferably a cationic polymethine colorant having an oxygen atom, a nitrogen atom, or a halogen atom at the meso-position. Preferred examples of the cationic polymethine colorant include a cyanine dye, a pyrylium colorant, a thiopyrylium colorant, and an azulenium colorant. From the viewpoint of ease of availability and solubility in a solvent during an introduction reaction, the cationic polymethine colorant is preferably a cyanine dye.

Specific examples of the cyanine dye include the compounds described in paragraphs "0017" to "0019" of JP2001-133969A, the compounds in paragraphs "0016" to "0021" of JP2002-023360A, and the compounds in paragraphs "0012" to "0037" of JP2002-040638A. Preferred examples of the cyanine dye include the cyanine dye include the compounds in paragraphs "0034" to "0041" of JP2002-278057A and the compounds in paragraphs "0080" to "0086" of JP2008-195018A. Examples of particularly preferred cyanine dyes include the compounds described in paragraphs "0035" to "0043" of JP2007-90850A and the compounds described in paragraphs "0105" to "0113" of JP2012-206495A. Furthermore, the compounds described in paragraphs "0008" and "0009" of JP1993-5005A (JP-H05-5005A) and the compounds described in paragraphs "0022" to "0025" of JP2001-222101A can also be preferably used.

As the countercation of the cyanine dye, for example, the borate compound that will be described later may also be used.

As pigments, the compounds described in paragraphs "0072" and" 0076" of JP2008-195018A are preferable.

As the infrared absorber, an infrared absorber that decomposes by exposure to infrared (hereinafter, also called "decomposable infrared absorber") can be suitably used. As the infrared absorber that decomposes by exposure to infrared, the compounds described in JP2008-544322A, WO2016/027886A, WO2017/141882A, or WO2018/043259A can also be suitably used. In addition, in the image-recording layer, as an infrared absorber, the discoloring compound described above in the section of "Outermost layer" can also be suitably used. Preferred aspects of the discoloring compound used as an infrared absorber in the image-recording layer are the same as the preferred aspects of the discoloring compound described above in the section of "Outermost layer".

The image-recording layer may contain one kind of infrared absorber or two or more kinds of infrared absorbers. In addition, as the infrared absorber, a pigment and a dye may be used in combination.

The content of the infrared absorber with respect to the total mass of the image-recording layer is preferably 0.1% by mass to 10.0% by mass, and more preferably 0.5% by mass to 5.0% by mass. In a case where the outermost layer contains an infrared absorber, from the viewpoint of visibility over time, storage stability, and UV printing durability, the total content of the infrared absorber in the image-recording layer is preferably equal to or more than the total content of the infrared absorber in the outermost layer, and more preferably more than the total content of the infrared absorber in the outermost layer. The total content of the infrared absorber is expressed in mass.

[Polymerization initiator]

The image-recording layer preferably contains a polymerization initiator. Examples of the polymerization initiator include an electron-accepting polymerization initiator and an electron-donating polymerization initiator. The image-recording layer preferably contains an electron-accepting polymerization initiator, more preferably contains at least one kind of polymerization initiator selected from the group consisting of an electron-accepting polymerization initiator and an electron-donating polymerization initiator, and particularly preferably contains an electron-accepting polymerization initiator and an electron-donating polymerization initiator.

(Electron-accepting polymerization initiator)

The image-recording layer preferably contains an electron-accepting polymerization initiator. The electron-accepting polymerization initiator is a compound which accepts an electron by intermolecular electron migration in a case where electrons of an infrared absorber are excited by exposure to infrared, and generates a polymerization initiation species (for example, radicals).

Examples of the electron-accepting polymerization initiator include a compound that generates a polymerization initiation species (for example, radicals or cations) by either or both of light energy and heat energy (for example, a thermal polymerization initiator, a compound having a bond that requires low bond dissociation energy, and a photopolymerization initiator). The electron-accepting polymerization initiator is preferably a radical polymerization initiator and more preferably an onium salt compound. In addition, the electron-accepting polymerization initiator is preferably an infrared-sensitive polymerization initiator.

From the viewpoint of curing properties, preferred examples of the electron-accepting polymerization initiator include an oxime ester compound and an onium salt compound. Particularly, from the viewpoint of printing durability, an iodonium salt compound, a sulfonium salt compound, or an azinium salt compound is preferable, an iodonium salt compound or a sulfonium salt compound is more preferable, and an iodonium salt compound is particularly preferable.

As the iodonium salt compound, a diaryliodonium salt compound is preferable. Particularly, an electron-donating group, for example, a diphenyl iodonium salt compound substituted with an alkyl group or an alkoxyl group is more preferable. Furthermore, as the iodonium salt compound, an asymmetric diphenyl iodonium salt compound is preferable. Specific examples of the iodonium salt compound include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyl iodonium=hexafluorophosphate, 4-hexyloxyphenyl-2,4-diethoxyphenyl iodonium=tetrafluoroborate, 4-octyloxyphenyl-2,4,6-trimethoxyphenyl iodonium=1-perfluorobutane sulfonate, 4-octyloxyphenyl-2,4,6-trimethoxyphenyliodonium=hexafluorophosphate, and bis(4-t-butylphenyl)iodonium=hexafluorophosphate.

Examples of counteranions of the iodonium salt compound and the sulfonium salt compound include a sulfonate anion, a carboxylate anion, a tetrafluoroborate anion, a hexafluorophosphate anion, a p-toluene sulfonate anion, a tosylate anion, a sulfonamide anion, and a sulfonimide anion. Among the above, a sulfonamide anion or a sulfonimide anion is preferable, and a sulfonimide anion is more preferable. As the sulfonamide anion, an aryl sulfonamide anion is preferable. As the sulfonimide anion, a bisaryl sulfonimide anion is preferable. Specific examples of the sulfonamide anion and the sulfonimide anion include the compounds described in paragraph "0034" in WO2019/013268A. The contents of the above publication are incorporated into the present specification by reference.

From the viewpoint of color developability over time after exposure, developability, and UV printing durability of the lithographic printing plate to be obtained, the electron-accepting polymerization initiator is preferably at least one kind of compound selected from the group consisting of a compound represented by Formula (II) and a compound represented by Formula (III), and more preferably a compound represented by Formula (II). The compound represented by Formula (II) and the compound represented by Formula (III) are preferable because these compounds have excellent visibility.

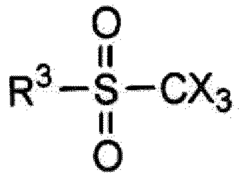

(II)

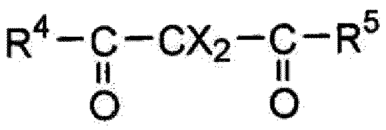

(III)

In Formula (II) and Formula (III), X represents a halogen atom, and $R^3$, $R^4$, and $R^5$ each independently represent a monovalent hydrocarbon group. The number of carbon atoms in the hydrocarbon group is preferably 1 to 20. In Formula (II), X preferably represents a halogen atom, and $R^3$ preferably represents an aryl group.

Examples of X in Formula (II) and Formula (III) include a fluorine atom, a chlorine atom, a bromine atom, and an iodine atom. X in Formula (II) and Formula (III) is preferably a bromine atom.

$R^3$, $R^4$, and $R^5$ in Formula (II) and Formula (III) preferably each independently represent an aryl group. From the viewpoint of excellent balance between sensitivity and storage stability, $R^3$, $R^4$, and $R^5$ more preferably each independently represent an aryl group substituted with an amide group.

The electron-accepting polymerization initiator is particularly preferably a compound represented by Formula (IV).

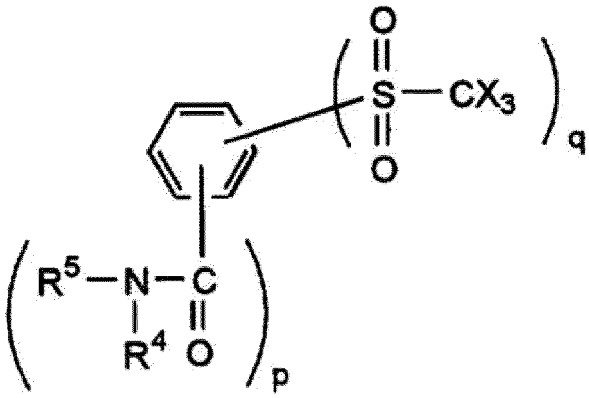

(IV)

In Formula (IV), X represents a halogen atom, $R^4$ and $R^5$ each independently represent a hydrogen atom or a monovalent hydrocarbon group having 1 to 20 carbon atoms, p and q each independently represent an integer of 1 to 5, and p + q is an integer of 2 to 6. X in Formula (IV) has the same definition as X in Formula (II).

Specific examples of the compound represented by Formula (II) will be shown below. However, the compound represented by Formula (II) is not limited to the following specific examples.

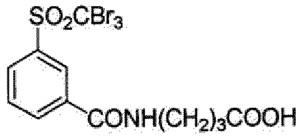 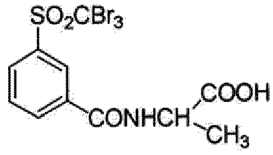 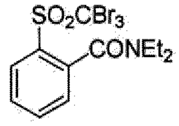

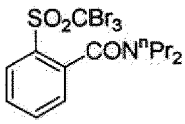 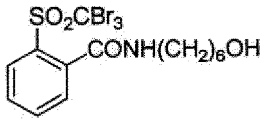 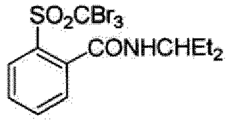

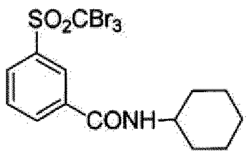 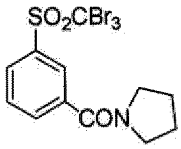 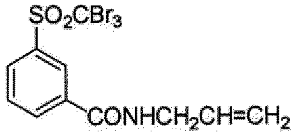

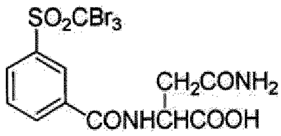 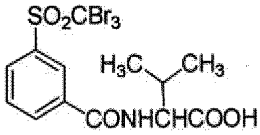 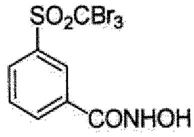

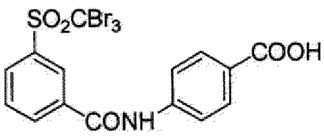 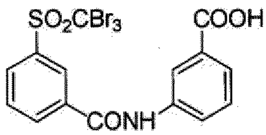 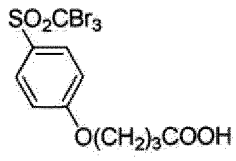

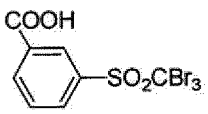 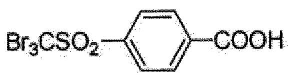 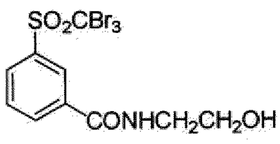

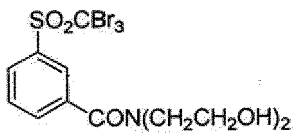 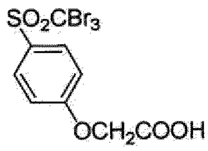 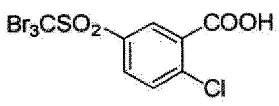

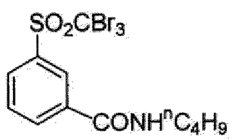 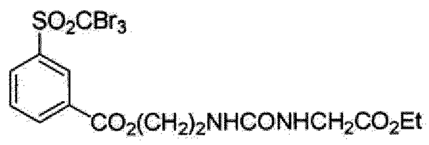

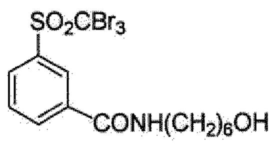 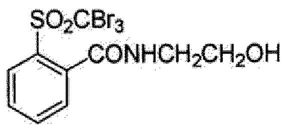

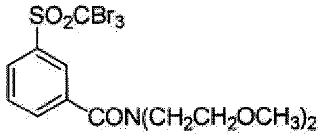
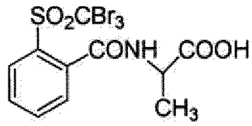

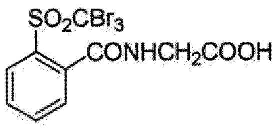
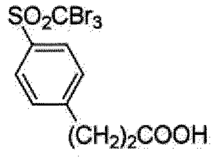
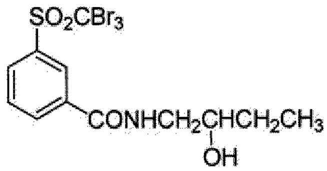

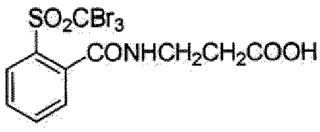
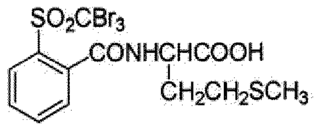

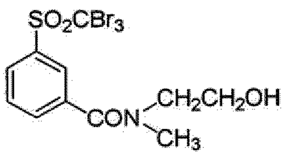
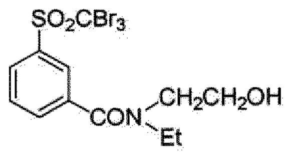
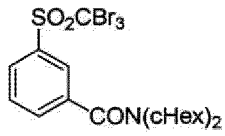

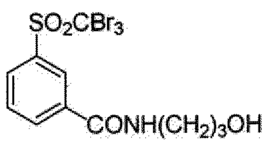
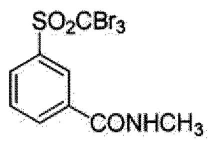
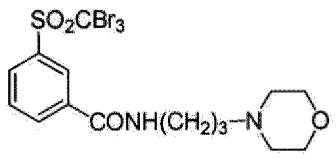

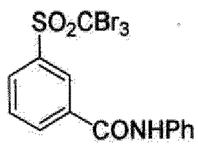
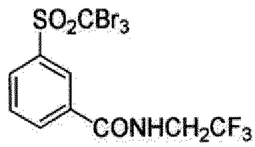
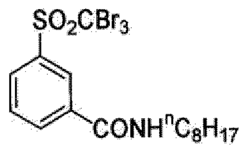

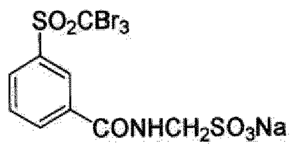
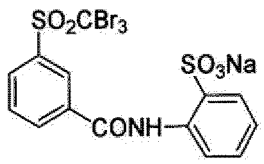
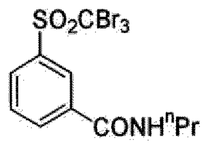

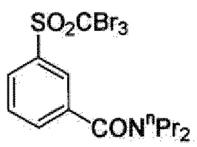
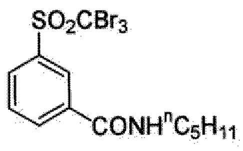
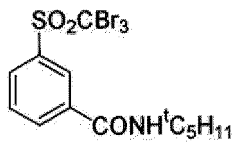

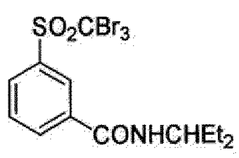
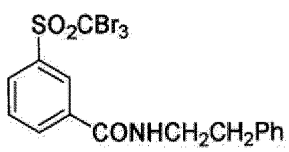
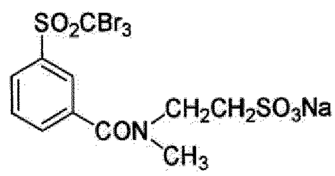

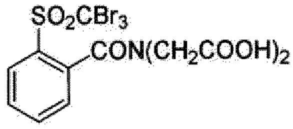 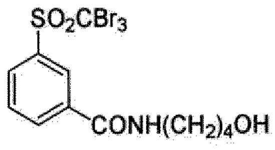

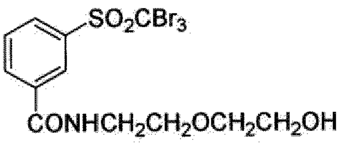 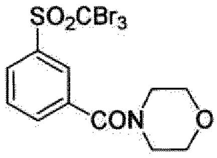 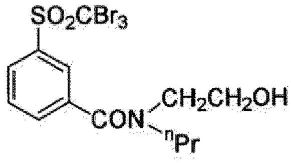

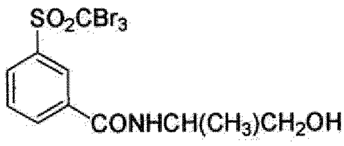 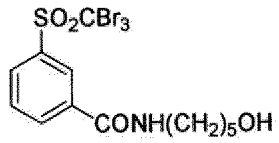

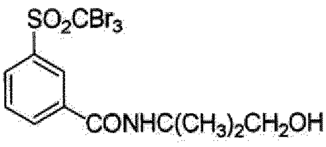 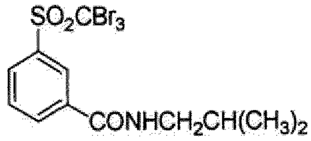

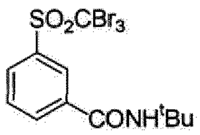 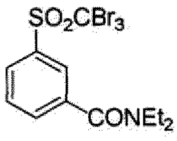 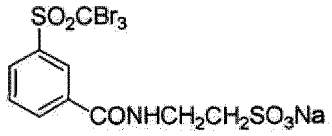

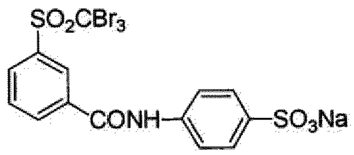 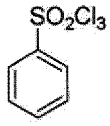 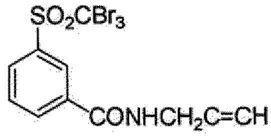

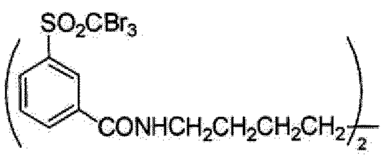 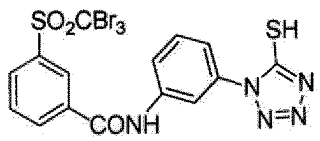

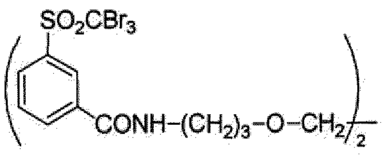 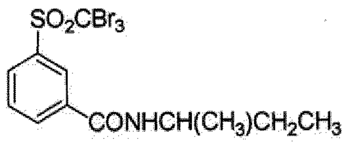

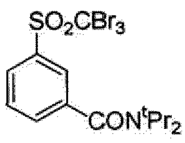 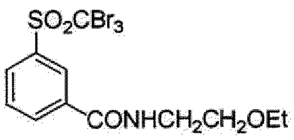 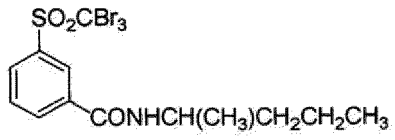

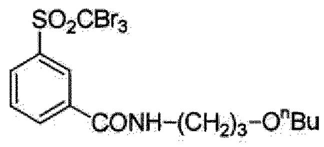
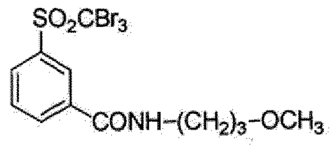
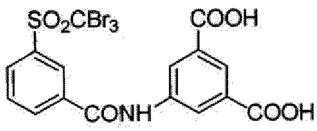
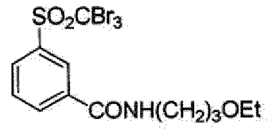
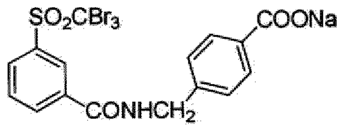
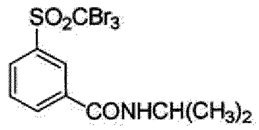
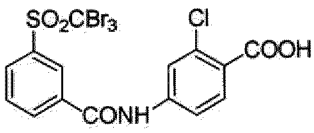
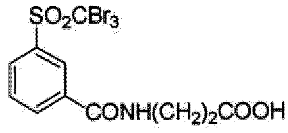
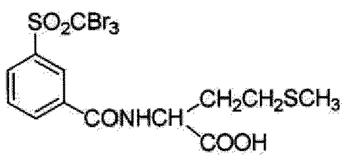
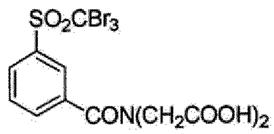
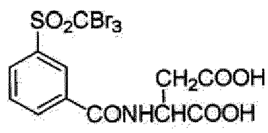
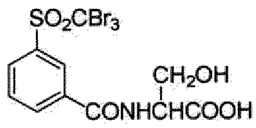
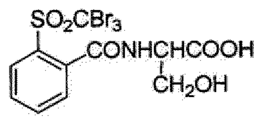
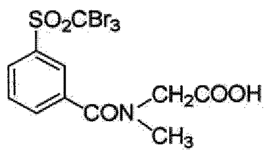
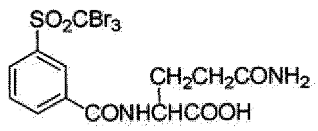
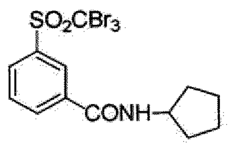
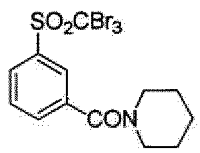
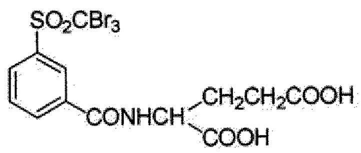
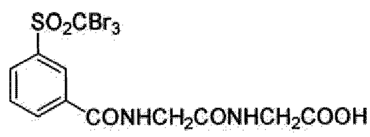
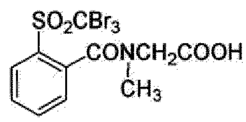
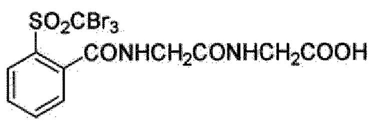
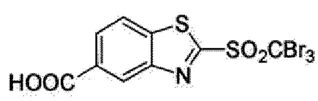

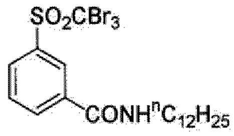
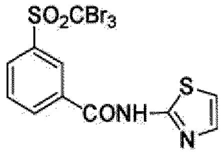
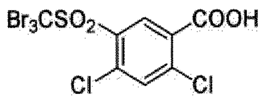

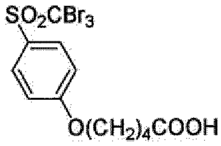
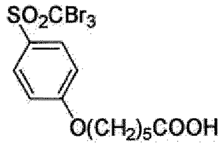

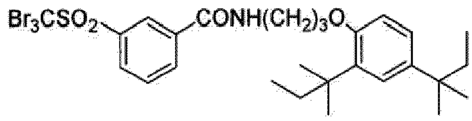
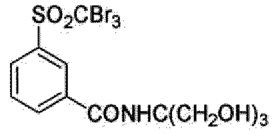

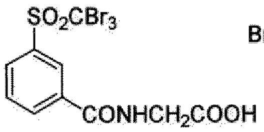
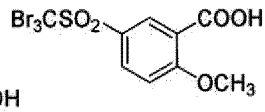
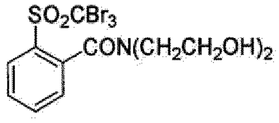

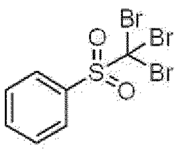
(IS-1)

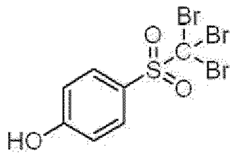
(IS-2)

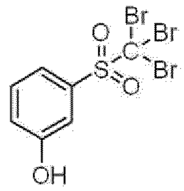
(IS-3)

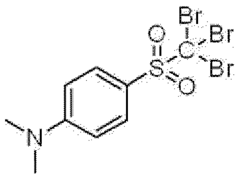
(IS-4)

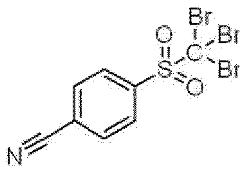
(IS-5)

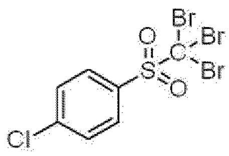
(IS-6)

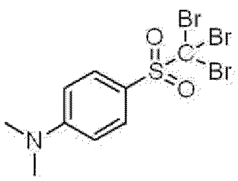
(IS-7)

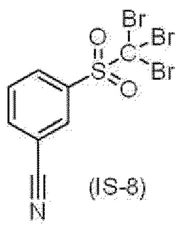
(IS-8)

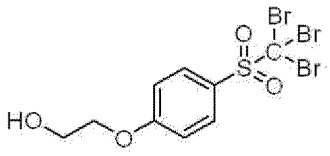
(IS-9)

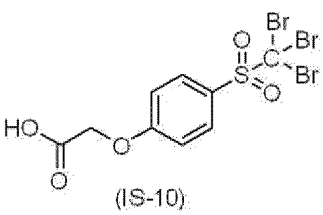
(IS-10)

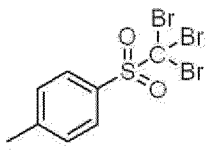
(IS-11)

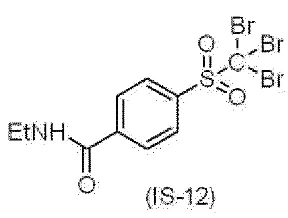
(IS-12)

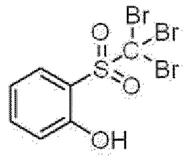

(IS-13)

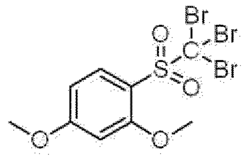

(IS-14)

From the viewpoint of improving sensitivity and making it difficult for plate missing to occur, the energy level of the lowest unoccupied molecular orbital (LUMO) of the electron-accepting polymerization initiator is preferably -3.00 eV or less, and more preferably -3.02 eV or less. The energy level of the lowest unoccupied molecular orbital (LUMO) of the electron-accepting polymerization initiator is preferably -3.80 eV or more, and more preferably -3.50 eV or more.

Herein, the energy level of the highest occupied molecular orbital (HOMO) and the energy level of the lowest unoccupied molecular orbital (LUMO) are calculated by the following methods. First, the counteranion in the compound as a subject of calculation is ignored. The structural optimization is carried out by DFT (B3LYP/6-31G(d)) using quantum chemical calculation software Gaussian 09. The molecular orbital (MO) energy is calculated by DFT (B3LYP/6-31+G(d,p)/CPCM (solvent = methanol)) based on the structure obtained by the structural optimization. By the following formula, the MO energy Ebare (unit: hartree) obtained by the above MO energy calculation is converted into Escaled (unit: eV) used as the values of HOMO and LUMO. In the following formula, 27.2114 is simply a coefficient for converting hartree into eV, and 0.823168 and -1.07634 are adjustment coefficients. These are determined such that the calculated values of HOMO and LUMO of the compound as a calculation object match the measured values.

$$\text{Formula: Escaled} = 0.823168 \times 27.2114 \times \text{Ebare} - 1.07634$$

The image-recording layer may contain one kind of electron-accepting polymerization initiator or two or more kinds of electron-accepting polymerization initiators.

The content of the electron-accepting polymerization initiator with respect to the total mass of the image-recording layer is preferably 0.1% by mass to 50% by mass, more preferably 0.5% by mass to 30% by mass, and particularly preferably 0.8% by mass to 20% by mass.

(Electron-donating polymerization initiator)

The image-recording layer preferably contains an electron-donating polymerization initiator. The electron-donating polymerization initiator is a compound which donates one electron by intermolecular electron migration to an orbit of an infrared absorber that has lost one electron in a case where electrons of the infrared absorber are excited or perform intramolecular migration by exposure to infrared, and thus generates polymerization initiation species (for example, radicals). The electron-donating polymerization initiator is preferably an electron-donating radical polymerization initiator.

From the viewpoint of printing durability, the image-recording layer preferably contains a borate compound as an electron-donating polymerization initiator. From the viewpoint of printing durability and color developability, the borate compound is preferably a tetraaryl borate compound or a monoalkyl triaryl borate compound, and more preferably a tetraaryl borate compound.

The countercation that the borate compound has is not limited. The countercation that the borate compound has is preferably an alkali metal ion or a tetraalkyl ammonium ion and more preferably a sodium ion, a potassium ion, or a tetrabutylammonium ion. The countercation that the borate compound has may also be a cationic polymethine colorant described above in the section of "Infrared absorber".

Preferred examples of the borate compound include sodium tetraphenyl borate.

Preferred specific examples (B-1 to B-9) of the electron-donating polymerization initiator will be shown below. In the following chemical formulas, Ph represents a phenyl group, and Bu represents a n-butyl group. Here, the electron-donating polymerization initiator is not limited to the following specific examples.

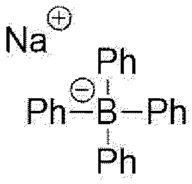
B - 1

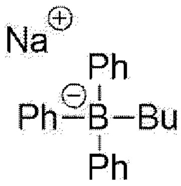
B - 2

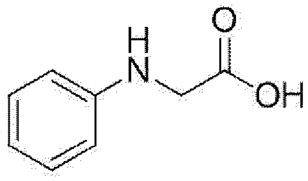
B - 3

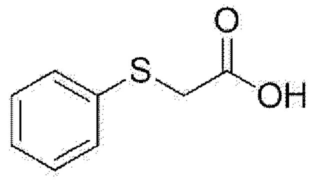
B - 4

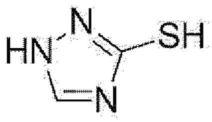
B - 5

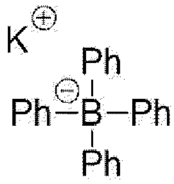
B - 6

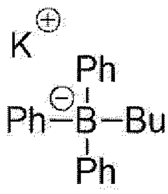
B - 7

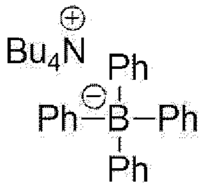
B - 8

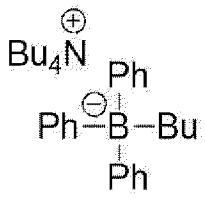
B - 9

From the viewpoint of sensitivity improvement and making it difficult for plate missing to occur, the energy level of the highest occupied molecular orbital (HOMO) of the electron-donating polymerization initiator is preferably -6.00 eV or more, more preferably -5.95 eV or more, and particularly preferably -5.93 eV or more. The energy level of the highest occupied molecular orbital (HOMO) of the electron-donating polymerization initiator is preferably -5.00 eV or less, and more preferably -5.40 eV or less.

The image-recording layer may contain one kind of electron-donating polymerization initiator or two or more kinds of electron-donating polymerization initiators.

From the viewpoint of sensitivity and printing durability, the content of the electron-donating polymerization initiator with respect to the total mass of the image-recording layer is preferably 0.01% by mass to 30% by mass, more preferably 0.05% by mass to 25% by mass, and particularly preferably 0.1% by mass to 20% by mass.

(Compound in which electron-donating polymerization initiator and electron-accepting polymerization initiator form ion pair)

In a certain embodiment, the image-recording layer preferably contains a compound (that is, a salt) in which the electron-donating polymerization initiator and the electron-accepting polymerization initiator form an ion pair. For example, the polymerization initiator is preferably a compound in which an anion in the electron-donating polymerization initiator and a cation in the electron-accepting polymerization initiator form an ion pair, more preferably a compound in which an onium cation and a borate anion form an ion pair, even more preferably a compound in which an iodonium cation or a sulfonium cation and a borate anion form an ion pair, and particularly preferably a compound in which a diaryliodonium cation or a triarylsulfonium cation and a tetraarylborate anion form an ion pair. Preferred aspects of the anion in the electron-donating polymerization initiator forming the ion pair are the same as preferred aspects of the anion in the electron-donating polymerization initiator described above. Preferred aspects of the cation in the electron-accepting polymerization initiator forming the ion pair are the same as preferred aspects of the cation in the electron-accepting polymerization initiator described above.

In a case where the image-recording layer contains an anion as an electron-donating polymerization initiator and a cation as an electron-accepting polymerization initiator (that is, in a case where the image-recording layer contains a compound in which an ion pair is formed as described above), the image-recording layer is regarded as containing an electron-accepting polymerization initiator and an electron-donating polymerization initiator. The compound in which an electron-donating polymerization initiator and an electron-accepting polymerization initiator form an ion pair may be used as an electron-donating polymerization initiator or an electron-accepting polymerization initiator. The compound in which an electron-donating polymerization initiator and an electron-accepting polymerization initiator form an ion pair may be used in combination with the aforementioned electron-donating polymerization initiator or used in combination with the aforementioned electron-accepting polymerization initiator.

(Content of polymerization initiator)

The image-recording layer may contain one kind of polymerization initiator or two or more kinds of polymerization

initiators. The content of the polymerization initiator with respect to the total mass of the image-recording layer is preferably 0.1% by mass to 50% by mass, more preferably 0.5% by mass to 30% by mass, and particularly preferably 0.8% by mass to 20% by mass.

(Preferred aspects of electron-donating polymerization initiator and infrared absorber)

From the viewpoints of sensitivity improvement and printing durability, in the image-recording layer, the energy level of the highest occupied molecular orbital (HOMO) of the infrared absorber - the energy level of the highest occupied molecular orbital (HOMO) of the electron-donating polymerization initiator is preferably 0.70 eV or less, and more preferably 0.70 eV to -0.10 eV. The negative sign means that the energy level of HOMO of the electron-donating polymerization initiator is higher than the energy level of HOMO of the infrared absorber.

(Preferred aspect of electron-accepting polymerization initiator and infrared absorber)

From the viewpoint of sensitivity improvement and printing durability, in the image-recording layer, the energy level of the lowest unoccupied molecular orbital (LUMO) of the electron-accepting polymerization initiator - the energy level of the lowest unoccupied molecular orbital (LUMO) of the infrared absorber is preferably 1.00 eV or less, more preferably 1.00 eV to -0.10 eV, and particularly preferably 0.80 eV to 0.30 eV. The negative sign means that the energy level of LUMO of the infrared absorber is higher than the energy level of LUMO of the electron-accepting polymerization initiator.

[Polymerizable compound]

It is preferable that the image-recording layer contain a polymerizable compound. Herein, "polymerizable compound" means a compound having a polymerizable group.

Examples of the polymerizable group include known polymerizable groups. The polymerizable group is preferably an ethylenically unsaturated group. The polymerizable group may be a radically polymerizable group or a cationically polymerizable group. The polymerizable group is preferably a radically polymerizable group. Examples of the radically polymerizable group include a (meth)acryloyl group, an allyl group, a vinylphenyl group, and a vinyl group. From the viewpoint of reactivity, a (meth)acryloyl group is preferable.

The molecular weight of the polymerizable compound (weight-average molecular weight in a case where there is a molecular weight distribution) is preferably 50 or more and less than 2,500.

The polymerizable compound may be, for example, a radically polymerizable compound or a cationically polymerizable compound. As the polymerizable compound, an addition polymerizable compound having at least one ethylenically unsaturated bond (that is, an ethylenically unsaturated compound) is preferable. The ethylenically unsaturated compound is preferably a compound having at least one ethylenically unsaturated bond on a terminal, and more preferably a compound having two or more ethylenically unsaturated bonds on a terminal.

The chemical form of the polymerizable compound may be a monomer, a prepolymer (for example, a dimer, a trimer, or an oligomer), or a mixture of these.

From the viewpoint of UV printing durability, the polymerizable compound preferably has 3 or more polymerizable groups, more preferably has 7 or more polymerizable groups, and particularly preferably has 10 or more polymerizable groups. From the viewpoint of UV printing durability of the lithographic printing plate to be obtained, the polymerizable compound preferably includes an ethylenically unsaturated compound having 3 or more (preferably 7 or more and more preferably 10 or more) ethylenically unsaturated groups, and more preferably includes a (meth)acrylate compound having 3 or more (preferably 7 or more and more preferably 10 or more) (meth)acryloyl groups.

(Oligomer)

The polymerizable compound preferably includes a polymerizable compound which is an oligomer (hereinafter, also simply called "oligomer"). Herein, "oligomer" means a polymerizable compound which has a molecular weight (weight-average molecular weight in a case where there is a molecular weight distribution) of 600 or more and 10,000 or less and at least one polymerizable group. From the viewpoint of excellent chemical resistance and excellent UV printing durability, the molecular weight of the oligomer is preferably 1,000 or more and 5,000 or less.

From the viewpoint of improving UV printing durability, the number of polymerizable groups in one molecule of the oligomer is preferably 2 or more, more preferably 3 or more, even more preferably 6 or more, and particularly preferably 10 or more. The upper limit of the number of polymerizable groups in the oligomer is not limited. The number of polymerizable groups in the oligomer is preferably 20 or less.

From the viewpoint of UV printing durability and on-press developability, an oligomer having 7 or more polymerizable groups and a molecular weight of 1,000 or more and 10,000 or less is preferable, and an oligomer having

7 or more and 20 or less polymerizable groups and a molecular weight of 1,000 or more and 5,000 or less is more preferable. **In** a case where the image-recording layer contains an oligomer as a polymerizable compound, the image-recording layer may also contain a polymer component that is likely to be generated in the process of manufacturing the oligomer.

From the viewpoint of UV printing durability, visibility, and on-press developability, the oligomer preferably includes at least one kind of compound selected from the group consisting of a compound having a urethane bond, a compound having an ester bond, and a compound having an epoxy residue, and more preferably includes a compound having a urethane bond. Herein, "epoxy residue" means a group having a structure formed of an epoxy group. Examples of the structure formed of an epoxy group include a structure obtained by a reaction between an acid group (for example, a carboxylic acid group) and an epoxy group.

-Compound having urethane bond-

As the compound having a urethane bond, which is an example of the oligomer, for example, a compound having at least a group represented by Formula (Ac-1) or Formula (Ac-2) is preferable, and a compound having at least a group represented by Formula (Ac-1) is more preferable.

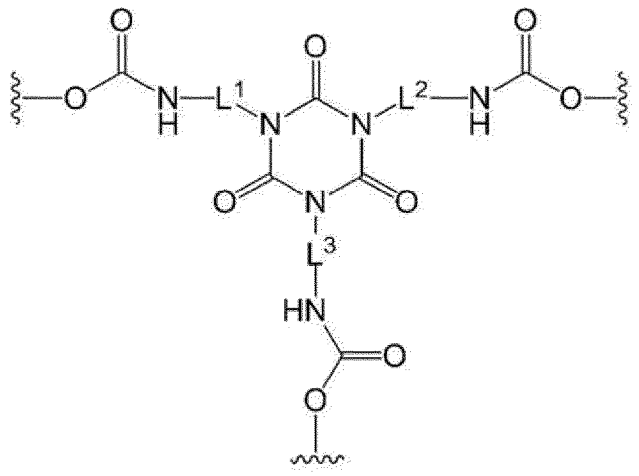

( Ac - 1 )

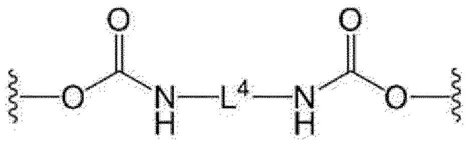

( Ac - 2 )

**In** Formula (Ac-1) and Formula (Ac-2), $L^1$ to $L^4$ each independently represent a divalent hydrocarbon group having 2 to 20 carbon atoms, and the portion of the wavy line represents a bonding position withother structures.

$L^1$ to $L^4$ in Formula (Ac-1) and Formula (Ac-2) preferably each independently represent an alkylene group having 2 to 20 carbon atoms, more preferably each independently represent an alkylene group having 2 to 10 carbon atoms, and particularly preferably each independently represent an alkylene group having 4 to 8 carbon atoms. The alkylene group may have a branched structure or a ring structure. The alkylene group is preferably a linear alkylene group.

The portion of the wavy line in Formula (Ac-1) or Formula (Ac-2) is preferably each independently directly bonded to the portion of the wavy line in a group represented by Formula (Ae-1) or Formula (Ae-2).

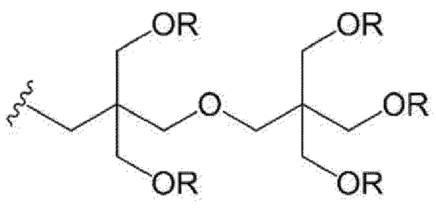

( Ae - 1 )

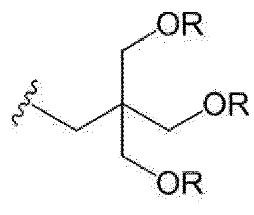

( Ae - 2 )

In Formula (Ae-1) and Formula (Ae-2), R each independently represent an acryloyloxy group or a methacryloyloxy group, and the portion of the wavy line represents a position bonding to the portion of the wavy line in Formula (Ac-1) and Formula (Ac-2).

As the compound having a urethane bond, a compound may also be used which is prepared by obtaining polyurethane by a reaction between a polyisocyanate compound and a polyol compound and introducing a polymerizable group into the polyurethane by a polymer reaction. For example, the compound having a urethane bond may be obtained by reacting a polyol compound having an acid group with a polyisocyanate compound to obtain a polyurethane oligomer and reacting this polyurethane oligomer with a compound having an epoxy group and a polymerizable group.

-Compound having ester bond-

The number of polymerizable groups in the compound having an ester bond, which is an example of oligomer, is preferably 3 or more, and more preferably 6 or more.

-Compound having epoxy residue-

As the compound having an epoxy residue, which is an example of oligomer, a compound containing a hydroxy group is preferable. The number of polymerizable groups in the compound having an epoxy residue is preferably 2 to 6, and more preferably 2 or 3. The compound having an epoxy residue can be obtained, for example, by reacting a compound having an epoxy group with an acrylic acid.

Commercially available products may be used as the oligomer. Examples of the commercially available products include UA-510H, UA-306H, UA-306I, and UA-306T (manufactured by KYOEISHA CHEMICAL Co., LTD.), UV-1700B, UV-6300B, and UV7620EA (manufactured by NIHON GOSEI KAKO Co., Ltd.), U-15HA (manufactured by SHIN-NAKAMURA CHEMICAL Co., LTD.), and EBECRYL450, EBECRYL657, EBECRYL885, EBECRYL800, EBECRYL3416, and EBECRYL860 (manufactured by DAICEL-ALLNEX LTD.). However, the commercially available products of the oligomer are not limited to the above commercially available product.

From the viewpoint of improving chemical resistance and UV printing durability and further suppressing the residues of on-press development, the content of the oligomer with respect to the total mass of polymerizable compounds in the image-recording layer is preferably 30% by mass to 100% by mass, more preferably 50% by mass to 100% by mass, and particularly preferably 80% by mass to 100% by mass.

(Low-molecular-weight polymerizable compound)

The polymerizable compound may further include a polymerizable compound other than the oligomer. From the viewpoint of chemical resistance, the polymerizable compound other than the oligomer is preferably a low-molecular-weight polymerizable compound. The chemical form of the low-molecular-weight polymerizable compound may be a monomer, a dimer, a trimer, or a mixture of these. From the viewpoint of chemical resistance, the low-molecular-weight polymerizable compound is preferably at least one kind of compound selected from the group consisting of a polymerizable compound having three or more ethylenically unsaturated groups and a polymerizable compound having an isocyanuric ring structure.

Herein, "low-molecular-weight polymerizable compound" refers to a polymerizable compound having a molecular weight (weight-average molecular weight in a case where there is a molecular weight distribution) of 50 or more and less than 600. From the viewpoint of excellent chemical resistance, excellent UV printing durability, and excellence in suppression of residues of on-press development, the molecular weight of the low-molecular-weight polymerizable compound is preferably 100 or more and less than 600, more preferably 300 or more and less than 600, and particularly preferably 400 or more and less than 600.

In a case where the polymerizable compound includes, in addition to an oligomer, a low-molecular-weight polymerizable compound as the polymerizable compound other than an oligomer, from the viewpoint of chemical resistance, UV printing durability, and suppression of residues of on-press development, the ratio of the content of the oligomer (total content in a case where the polymerizable compound includes two or more kinds of oligomers) to the content of the low-molecular-weight polymerizable compound (total content in a case where the polymerizable compound includes two or more kinds of low-molecular-weight polymerizable compounds) (that is, oligomer/low-molecular-weight polymerizable compound) is preferably 10/1 to 1/10, more preferably 10/1 to 3/7, and even more preferably 10/1 to 7/3, based on mass.

As the polymerizable compound, the polymerizable compounds described in paragraphs ".0082" to "0086" of WO2019/013268A may be used.

The image-recording layer may contain one kind of polymerizable compound or two or more kinds of polymerizable compounds. From the viewpoint of UV printing durability, the image-recording layer preferably contains two or more kinds of polymerizable compounds.

The content of the polymerizable compound (total content of polymerizable compounds in a case where the image-recording layer contains two or more kinds of polymerizable compounds) with respect to the total mass of the

image-recording layer is preferably 5% by mass to 75% by mass, more preferably 10% by mass to 70% by mass, and particularly preferably 15% by mass to 60% by mass.

[Particles]

From the viewpoint of developability and UV printing durability, it is preferable that the image-recording layer contain particles. The particles may be inorganic particles or organic particles. The image-recording layer preferably contains organic particles as particles, and more preferably contains resin particles as particles. As the inorganic particles, for example, known inorganic particles can be used. As the inorganic particles, metal oxide particles (for example, silica particles or titania particles) can be suitably used.

(Resin particles)

Examples of the resin particles include particles containing an addition polymerization-type resin (that is, addition polymerization-type resin particles), particles containing a polyaddition-type resin (that is, polyaddition-type resin particles), and particles containing a polycondensation-type resin (that is, polycondensation-type resin particles). As the resin particles, the addition polymerization-type resin particles or the polyaddition-type resin particles are preferable. From the viewpoint of enabling thermal fusion, the resin particles may also be particles containing a thermoplastic resin (that is, thermoplastic resin particles).

The resin particles may be in the form of, for example, microcapsules or a microgel (that is, crosslinked resin particles).

The resin particles are preferably at least one kind of resin particles selected from the group consisting of thermoplastic resin particles, thermal reactive resin particles, resin particles having a polymerizable group, microcapsules encapsulating a hydrophobic compound, and a microgel (crosslinked resin particles). Among these, resin particles having a polymerizable group are preferable. In a particularly preferred embodiment, the resin particles have at least one ethylenically unsaturated group. The above resin particles bring about effects of improving the printing durability of an exposed portion and improving the on-press developability of a non-exposed portion.

-Themoplastic resin particles-

As the thermoplastic resin particles, the thermoplastic resin particles described in Research Disclosure No. 33303 published in January 1992, JP1997-123387A (JP-H09-123387A), JP1997-131850A (JP-H09-131850A), JP1997-171249A (JP-H09-171249A), JP1997-171250A (JP-H09-171250A), or EP931647B are preferable.

Specific examples of resins constituting the thermoplastic resin particles include homopolymers or copolymers of monomers (for example, ethylene, styrene, vinyl chloride, methyl acrylate, ethyl acrylate, methyl methacrylate, ethyl methacrylate, vinylidene chloride, acrylonitrile, vinylcarbazole, and acrylates or methacrylates having polyalkylene structures) and mixtures of these.

From the viewpoint of ink receptivity and UV printing durability, the thermoplastic resin particles preferably contain a resin that has a constitutional unit formed of an aromatic vinyl compound and a nitrile group-containing constitutional unit.

The aromatic vinyl compound may be any compound having a structure in which a vinyl group is bonded to an aromatic ring. Examples of the aromatic vinyl compound include a styrene compound and a vinyl naphthalene compound. As the aromatic vinyl compound, a styrene compound is preferable, and styrene is more preferable. Examples of the styrene compound include styrene, p-methylstyrene, p-methoxystyrene, β-methylstyrene, p-methyl-β-methylstyrene, α-methylstyrene, and p-methoxy-β-methylstyrene.

From the viewpoint of ink receptivity, the content of the constitutional unit formed of an aromatic vinyl compound is preferably larger than the content of a nitrile group-containing constitutional unit that will be described later. The content of the constitutional unit formed an aromatic vinyl compound with respect to the total mass of the thermoplastic resin in the thermoplastic resin particles is preferably 15% by mass to 85% by mass, and particularly preferably 30% by mass to 70% by mass.

The nitrile group-containing constitutional unit is preferably introduced using a monomer having a nitrile group. Examples of the monomer having a nitrile group include an acrylonitrile compound. Preferred examples of the monomer having a nitrile group include (meth)acrylonitrile. As the nitrile group-containing constitutional unit, a constitutional unit formed of (meth)acrylonitrile is preferable.

From the viewpoint of ink receptivity, the content of the nitrile group-containing constitutional unit is preferably smaller than the content of the constitutional unit formed of an aromatic vinyl compound. The content of the nitrile group-containing constitutional unit with respect to the total mass of the thermoplastic resin in the thermoplastic resin particles is preferably 55% by mass to 90% by mass, and more preferably 60% by mass to 85% by mass.

In a case where the thermoplastic resin particles contain a resin having the constitutional unit formed of an aromatic vinyl compound and the nitrile group-containing constitutional unit, the content ratio between the constitutional unit formed of an aromatic vinyl compound and the nitrile group-containing constitutional unit (that is, constitutional unit formed of aromatic vinyl compound:nitrile group-containing constitutional unit) is preferably 5:5 to 9:1, and more preferably 6:4 to 8:2, based on mass.

From the viewpoint of UV printing durability and chemical resistance, the thermoplastic resin contained in the thermoplastic resin particles preferably further has a constitutional unit formed of a N-vinyl heterocyclic compound. Examples of the N-vinyl heterocyclic compound include N-vinylpyrrolidone, N-vinylcarbazole, N-vinylpyrrole, N-vinylphenothiazine, N-vinylsuccinic acid imide, N-vinylphthalimide, N-vinylcaprolactam, and N-vinylimidazole. As the N-vinyl heterocyclic compound, N-vinylpyrrolidone is preferable.

The content of the constitutional unit formed of a N-vinyl heterocyclic compound with respect to the total mass of the thermoplastic resin in the thermoplastic resin particles is preferably 5% by mass to 50% by mass, and more preferably 10% by mass to 40% by mass.

The thermoplastic resin contained in the thermoplastic resin particles may further have an acidic group-containing constitutional unit. From the viewpoint of on-press developability and ink receptivity, it is preferable that the thermoplastic resin contained in the thermoplastic resin particles do not have an acidic group-containing constitutional unit. Specifically, the content of the acidic group-containing constitutional unit in the thermoplastic resin with respect to the total mass of the thermoplastic resin in the thermoplastic resin particles is preferably 20% by mass or less, more preferably 10% by mass or less, and particularly preferably 5% by mass or less. The lower limit of the content is not particularly limited, and may be 0% by mass.

The acid value of the thermoplastic resin contained in the thermoplastic resin particles is preferably 160 mg KOH/g or less, more preferably 80 mg KOH/g or less, and particularly preferably 40 mg KOH/g or less. The lower limit of the acid value is not particularly limited, and may be 0 mg KOH/g. Herein, the acid value is determined by the measurement method based on "JIS K0070: 1992".

From the viewpoint of ink receptivity, the thermoplastic resin contained in the thermoplastic resin particles may have a hydrophobic group-containing constitutional unit. Examples of the hydrophobic group include an alkyl group, an aryl group, and an aralkyl group. As the hydrophobic group-containing constitutional unit, for example, a constitutional unit formed of an alkyl (meth)acrylate compound, an aryl (meth)acrylate compound, or an aralkyl (meth)acrylate compound is preferable, and a constitutional unit formed of an alkyl (meth)acrylate compound is more preferable.

**In** the thermoplastic resin contained in the thermoplastic resin particles, the content of the hydrophobic group-containing constitutional unit with respect to the total mass of the thermoplastic resin in the thermoplastic resin particles is preferably 5% by mass to 50% by mass, and more preferably 10% by mass to 30% by mass.

From the viewpoint of UV printing durability and on-press developability, the thermoplastic resin contained in the thermoplastic resin particles preferably has a hydrophilic group. The hydrophilic group is not particularly limited as long as it is a hydrophilic structure. Examples of the hydrophilic group include an acid group (for example, a carboxy group), a hydroxy group, an amino group, a nitrile group, and a group having a polyalkylene oxide structure. From the viewpoint of UV printing durability and on-press developability, the hydrophilic group is preferably a group having a polyalkylene oxide structure, a group having a polyester structure, or a sulfonic acid group, more preferably a group having a polyalkylene oxide structure or a sulfonic acid group, and particularly preferably a group having a polyalkylene oxide structure.

From the viewpoint of on-press developability, the polyalkylene oxide structure is preferably a polyethylene oxide structure, a polypropylene oxide structure, or a poly(ethylene oxide/propylene oxide) structure.

From the viewpoint of on-press developability, the group having a polyalkylene oxide structure preferably has a polypropylene oxide structure, and more preferably has a polyethylene oxide structure and a polypropylene oxide structure.

From the viewpoint of on-press developability, the number of alkylene oxide structures in the polyalkylene oxide structure is preferably 2 or more, more preferably 5 or more, even more preferably 5 to 200, and particularly preferably 8 to 150.

The hydrophilic group is preferably a group represented by Formula PO.

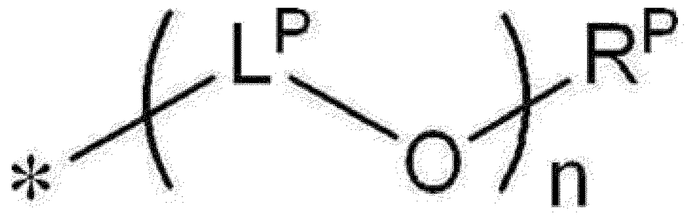

Formula PO

In Formula PO, $L^P$ each independently represent an alkylene group, $R^P$ represents a hydrogen atom or an alkyl group, and n represents an integer of 1 to 100.
In Formula PO, $L^P$ preferably each independently represent an ethylene group, a 1-methylethylene group, or a 2-methylethylene group, and more preferably each independently represent an ethylene group.
In Formula PO, $R^P$ is preferably a hydrogen atom or an alkyl group having 1 to 18 carbon atoms, more preferably a hydrogen atom or an alkyl group having 1 to 10 carbon atoms, even more preferably a hydrogen atom or an alkyl group having 1 to 4 carbon atoms, and particularly preferably a hydrogen atom or a methyl group.
In Formula PO, n is preferably an integer of 1 to 10, and more preferably an integer of 1 to 4.
The content of the hydrophilic group-containing constitutional unit with respect to the total mass of the thermoplastic resin in the thermoplastic resin particles is preferably 5% by mass to 60% by mass, and more preferably 10% by mass to 30% by mass.
The resin contained in the thermoplastic resin particles may further have other constitutional units. The resin can contain, as those other constitutional units, constitutional units other than the constitutional units described above. Examples thereof include constitutional units formed of an acrylamide compound or a vinyl ether compound.
In the thermoplastic resin, the content of those other constitutional units with respect to the total mass of the thermoplastic resin in the thermoplastic resin particles is preferably 5% by mass to 50% by mass, and more preferably 10% by mass to 30% by mass.

-Thermal reactive resin particles-

Examples of the thermal reactive resin particles include resin particles having a thermal reactive group. The thermal reactive resin particles form a hydrophobic region through crosslinking by a thermal reaction and the change in functional groups that occurs during crosslinking.
As long as a chemical bond is formed, functional groups that cause any reaction may be adopted as the thermal reactive group. The thermal reactive group is preferably a polymerizable group. Preferred examples of the thermal reactive group include an ethylenically unsaturated group that causes a radical polymerization reaction (for example, an acryloyl group, a methacryloyl group, a vinyl group, and an allyl groups), a cationically polymerizable group (for example, a vinyl group, a vinyloxy group, an epoxy group, and an oxetanyl group), an isocyanate group or a blocked isocyanate group that causes an addition reaction, an epoxy group, a vinyloxy group, an active hydrogen atom-containing functional group that is a reaction partner thereof (for example, an amino group, a hydroxy group, and a carboxy group), a carboxy group that causes a condensation reaction, a hydroxy group or an amino group that is a reaction partner of the carboxy group, an acid anhydride that causes a ring-opening addition reaction, and an amino group or a hydroxy group which is a reaction partner of the acid anhydride.
The resin having a thermal reactive group may be an addition polymerization-type resin, a polyaddition-type resin, or a polycondensation-type resin. The resin having a thermal reactive group may be a thermoplastic resin.

-Microcapsules-

As the microcapsules, for example, microcapsules are preferable which encapsulate at least some of the constituent components (preferably a hydrophobic compound) of the image-recording layer as described in JP2001-277740A and JP2001-277742A. In the image-recording layer containing microcapsules as resin particles, a hydrophobic component (that is, a hydrophobic compound) among the constituent components of the image-recording layer is preferably encapsulated in the microcapsules, and a hydrophilic component (that is, a hydrophilic compound) is on the outside of the microcapsules.

-Microgel-

The microgel (crosslinked resin particles) can contain some of the constituent components of the image-recording layer, in at least one of the surface or the interior of the microgel. From the viewpoint of sensitivity of the lithographic printing plate precursor and printing durability of the lithographic printing plate to be obtained, a reactive microgel having a polymerizable group on the surface thereof is particularly preferable. In order to obtain microcapsules containing a constituent component of the image-recording layer, known synthesis methods can be used.

-Polyaddition-type resin particles-

As the resin particles, from the viewpoint of printing durability, antifouling properties, and storage stability of the lithographic printing plate to be obtained, polyaddition-type resin particles are preferable which are obtained by a reaction between a polyvalent isocyanate compound that is an adduct of a polyhydric phenol compound having two or more hydroxy groups in a molecule and isophorone diisocyanate and a compound having active hydrogen.

As the polyhydric phenol compound, a compound having a plurality of benzene rings having a phenolic hydroxyl group is preferable.

As the compound having active hydrogen, a polyol compound or a polyamine compound is preferable, a polyol compound is more preferable, and at least one kind of compound selected from the group consisting of propylene glycol, glycerin, and trimethylolpropane is still more preferable.

As the active hydrogen compound, water can also be used. **In** a case where water is used as the active hydrogen compound, the amine generated by the reaction between an isocyanato group and water can form a urea bond to form particles.

Preferred examples of the resin particles obtained by the reaction between a polyvalent isocyanate compound that is an adduct of a polyhydric phenol compound having two or more hydroxy groups in a molecule and isophorone diisocyanate and a compound having active hydrogen include the resin particles described in paragraphs "0230" to "0234" of WO2018/043259A.

From the viewpoint of printing durability, receptivity, on-press developability, and suppression of the occurrence of development residues during on-press development, the resin particles preferably contain a polyaddition-type resin having a urea bond, more preferably contain a polyaddition-type resin having a structure obtained by reacting at least an isocyanate compound represented by Formula (Iso) with water, and particularly preferably contain a polyaddition-type resin that has a structure obtained by reacting at least an isocyanate compound represented by Formula (Iso) with water and has a polyethylene oxide structure and a polypropylene oxide structure as polyoxyalkylene structures. Furthermore, the particles containing the polyaddition-type resin having a urea bond are preferably a microgel.

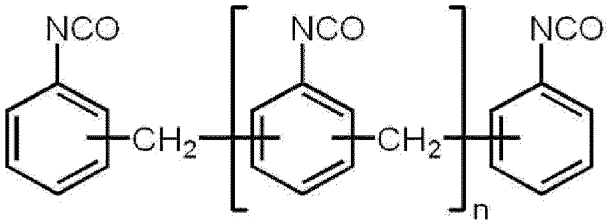

(Iso)

**In** Formula (Iso), n represents an integer of 0 to 10.

An example of the reaction between the isocyanate compound represented by Formula (Iso) and water is the reaction shown below. **In** the following example reaction, a 4,4-isomer in which n = 0 is used. As shown below, in a case where the isocyanate compound represented by Formula (Iso) is reacted with water, the isocyanate group is partially hydrolyzed by water, which generates an amino group. The generated amino group reacts with the isocyanate group, which generates a urea bond and leads to the formation of a dimer. Furthermore, the following reaction is repeated to form a polyaddition-type resin having a urea bond. **In** the following reaction, by adding a compound reactive with an isocyanate group (that is, a compound having active hydrogen: for example, an alcohol compound or an amine compound), it is possible to introduce the structure of an alcohol compound, an amine compound, or the like to the polyaddition-type resin having a urea bond. Preferred examples of the compound having active hydrogen include the aforementioned compound having active hydrogen.

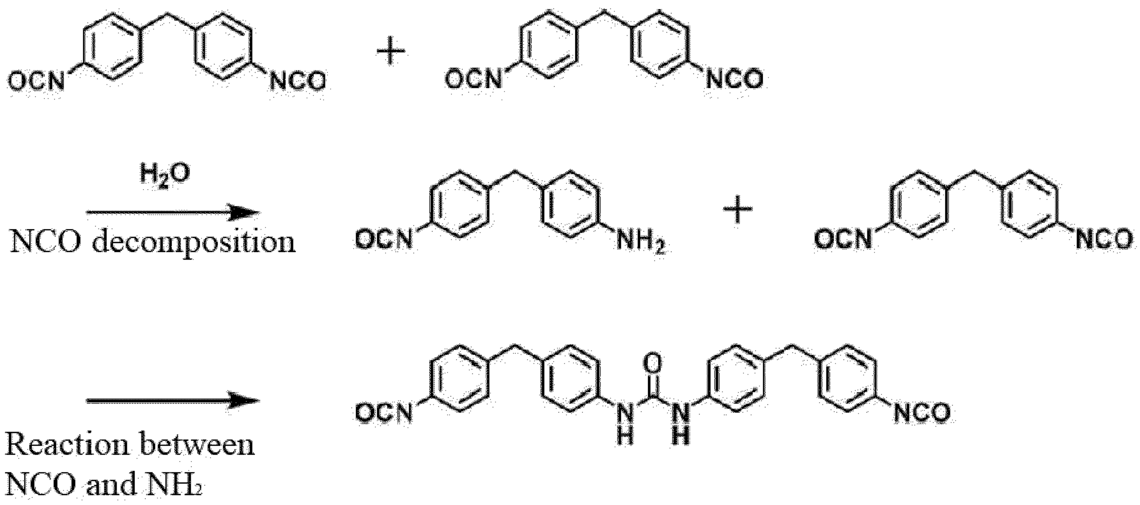


The polyaddition-type resin having a urea bond preferably has an ethylenically unsaturated group, and more preferably has a group represented by Formula (PETA).

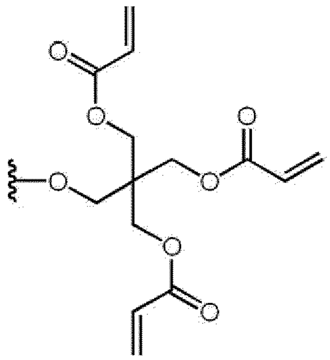
( PETA )

In Formula (PETA), the portion of the wavy line represents a bonding position with other structures.

-Addition polymerization-type resin particles-

As the resin particles, from the viewpoint of printing durability and solvent resistance of the lithographic printing plate to be obtained, addition polymerization-type resin particles are preferable which have a hydrophobic main chain and include both i) constitutional unit having a nitrile group directly bonded to the hydrophobic main chain and ii) constitutional unit having a pendant group including a hydrophilic polyalkylene oxide segment. Specifically, the particles described in paragraph "0156" of JP2019-64269A are preferable.

-Group represented by Formula Z-

It is preferable that the resin particles have a group represented by Formula Z as a hydrophilic group.

*-Q-W-Y: Formula Z

In formula Z, Q represents a divalent linking group, W represents a divalent group having a hydrophilic structure or a divalent group having a hydrophobic structure, and Y represents a monovalent group having a hydrophilic structure or a monovalent group having a hydrophobic structure, either W or Y has a hydrophilic structure, and * represents a bonding site with another structure. It is preferable that any one of the hydrophilic structures included in Formula Z include a polyalkylene oxide structure.
Q in Formula Z is preferably a divalent linking group having 1 to 20 carbon atoms, and more preferably a divalent linking group having 1 to 10 carbon atoms.
Furthermore, Q in Formula Z is preferably an alkylene group, an arylene group, an ester bond, an amide bond, or a group formed by combining two or more of these, and more preferably a phenylene group, an ester bond, or an amide

bond.

The divalent group having a hydrophilic structure represented by W in Formula Z is preferably a group having a polyalkylene oxide structure, and more preferably a polyalkyleneoxy group or a group in which $-CH_2CH_2NR^W-$ is bonded to one terminal of a polyalkyleneoxy group. $R^W$ represents a hydrogen atom or an alkyl group.

The divalent group having a hydrophobic structure represented by W in Formula Z is preferably $-R^{WA}-$, $-O-R^{WA}-O-$, $-R^WN-R^{WA}-NR^W-$, $-OC(=O)-R^{WA}-O-$, or $-OC(=O)-R^{WA}-O-$. $R^{WA}$ each independently represent a linear, branched, or cyclic alkylene group having 6 to 120 carbon atoms, a haloalkylene group having 6 to 120 carbon atoms, an arylene group having 6 to 120 carbon atoms, an alkarylene group having 7 to 120 carbon atoms (that is, a divalent group formed by removing one hydrogen atom from an alkylaryl group), or an aralkylene group having 7 to 120 carbon atoms. $R^W$ represents a hydrogen atom or an alkyl group.

The monovalent group having a hydrophilic structure represented by Y in Formula Z is preferably -OH, -C(=O)OH, a polyalkyleneoxy group having a hydrogen atom or an alkyl group on a terminal, or a group in which $-CH_2CH_2N(R^W)-$ is bonded to one terminal of a polyalkyleneoxy group having a hydrogen atom or an alkyl group on the other terminal. The monovalent group having a hydrophilic structure is preferably a monovalent group having a polyalkylene oxide structure, a polyalkyleneoxy group having a hydrogen atom or an alkyl group on a terminal, or a group in which $-CH^2CH^2N(R^W)-$ is bonded to one terminal of a polyalkyleneoxy group having a hydrogen atom or an alkyl group on the other terminal. $R^W$ represents a hydrogen atom or an alkyl group.

The monovalent group having a hydrophobic structure represented by Y in Formula Z is preferably a linear, branched, or cyclic alkyl group having 6 to 120 carbon atoms, a haloalkyl group having 6 to 120 carbon atoms, an aryl group having 6 to 120 carbon atoms, an alkaryl group having 7 to 120 carbon atoms (alkylaryl group), an aralkyl group having 7 to 120 carbon atoms, $-OR^{WB}$, $-C(=O)OR^{WB}$, or $-OC(=O)R^{WB}$. $R^{WB}$ represents an alkyl group having 6 to 20 carbon atoms.

From the viewpoint of printing durability, receptivity, and on-press developability, in the resin particles having a group represented by formula Z, W is more preferably a divalent group having a hydrophilic structure, Q is more preferably a phenylene group, an ester bond, or an amide bond, W is more preferably a polyalkyleneoxy group, and Y is more preferably a polyalkyleneoxy group having a hydrogen atom or an alkyl group on a terminal. The group represented by Formula Z may function as a dispersible group for improving the dispersibility of the resin particles.

-Resin particles having polymerizable group-

From the viewpoint of printing durability and on-press developability, the resin particles preferably have a polymerizable group (preferably an ethylenically unsaturated group). Particularly, the resin particles more preferably include resin particles having a polymerizable group on the surface thereof. Using the resin particles having a polymerizable group makes it easy to suppress plate missing (preferably UV plate missing) and improves printing durability (preferably UV printing durability) as well.

From the viewpoint of printing durability, it is preferable that the resin particles be resin particles having a hydrophilic group and a polymerizable group. The polymerizable group may be a cationically polymerizable group or a radically polymerizable group. From the viewpoint of reactivity, the polymerizable group is preferably a radically polymerizable group. The polymerizable group is not particularly limited as long as it is a polymerizable group. From the viewpoint of reactivity, an ethylenically unsaturated group is preferable, a vinylphenyl group (styryl group), a (meth)acryloxy group, or a (meth)acrylamide group is more preferable, and a (meth)acryloxy group is particularly preferable. In addition, it is preferable that the resin constituting the resin particles having a polymerizable group have a polymerizable group-containing constitutional unit. The polymerizable group may be introduced into the surface of the resin particles by a polymer reaction.

-Synthesis of resin particles-

The synthesis method of the resin particles is not particularly limited, and may be a method that makes it possible to synthesize particles with various resins described above. Examples of the synthesis method of the resin particles include known synthesis methods of resin particles, such as an emulsion polymerization method, a suspension polymerization method, a dispersion polymerization method, a soap-free polymerization method, and a microemulsion polymerization method. For the synthesis of the resin particles, a known microcapsule synthesis method or a known microgel (crosslinked resin particle) synthesis method may be used.

(Average particle diameter of particles)

The average particle diameter of the particles is preferably 0.01 $\mu$m to 3.0 $\mu$m, more preferably 0.03 $\mu$m to 2.0 $\mu$m, and particularly preferably 0.10 $\mu$m to 1.0 $\mu$m. In a case where the average particle diameter of the particles is in the above range, excellent resolution and excellent temporal stability are obtained. The average particle diameter of the

particles is measured using a light scattering method or by capturing an electron micrograph of the particles, measuring the particle diameter of a total of 5,000 particles in the photograph, and calculating the average thereof. For nonspherical particles, the equivalent circular diameter of the particles in a photograph is adopted. Unless otherwise specified, the average particle diameter of the particles means a volume average particle diameter.

(Contents of particles)

The image-recording layer may contain one kind of particles or two or more kinds of particles. From the viewpoint of developability and printing durability, the content of the particles (preferably resin particles) with respect to the total mass of the image-recording layer is preferably 5% by mass to 90% by mass, more preferably 10% by mass to 90% by mass, even more preferably 20% by mass to 90% by mass, and particularly preferably 50% by mass to 90% by mass.

[Coloring compound]

It is preferable that the image-recording layer contain a coloring compound that can have a coloring reaction with a decomposition product generated by the exposure of the image-recording layer. Preferred examples of the coloring compound include a compound represented by Formula 1C and a compound represented by Formula 2C, which will be described later. "Coloring reaction" means a chemical reaction accompanying a phenomenon of color development or discoloration.

The decomposition product generated by the exposure of the image-recording layer is not particularly limited. From the viewpoint of visibility of exposed portions, the decomposition product is preferably a decomposition product generated by the exposure of a polymerization initiator or a decomposition product generated by the exposure of an infrared absorber, more preferably a decomposition product generated by the exposure of a polymerization initiator, and particularly preferably a decomposition product generated by the exposure of an electron-donating polymerization initiator. The decomposition product generated by the exposure of the image-recording layer includes not only the decomposition products generated by the exposure but also a compound generated by the decomposition or modification that the decomposition product generated by exposure further goes through.

From the viewpoint of visibility of exposed portions, the coloring reaction is preferably a complex-forming reaction, and more preferably a boron complex-forming reaction. An example of the coloring reaction will be shown below. The following coloring reaction is a reaction between Curcumin as a coloring compound and boric acid as a decomposition product generated by the exposure of the image-recording layer, the boric acid being generated by the decomposition of sodium tetrapheny lborate (TPB). Due to keto-enol tautomerism, an enol tautomer of curcumin is generated as equilibrium. The reaction between the enol tautomer and the boric acid generates a boron complex (Complex), and a coloring reaction from curcumin (yellow) to a boron complex (red) occurs. What is shown in the following coloring reaction is an example where TPB is hydrolyzed to boric acid. For example, curcumin may form a complex together with diphenyl monohydroxyborate, monophenyl dihydroxyborate, or the like, or triphenyl borate may be coordinated as a zero-valent ligand to enol-type curcumin to form a complex.

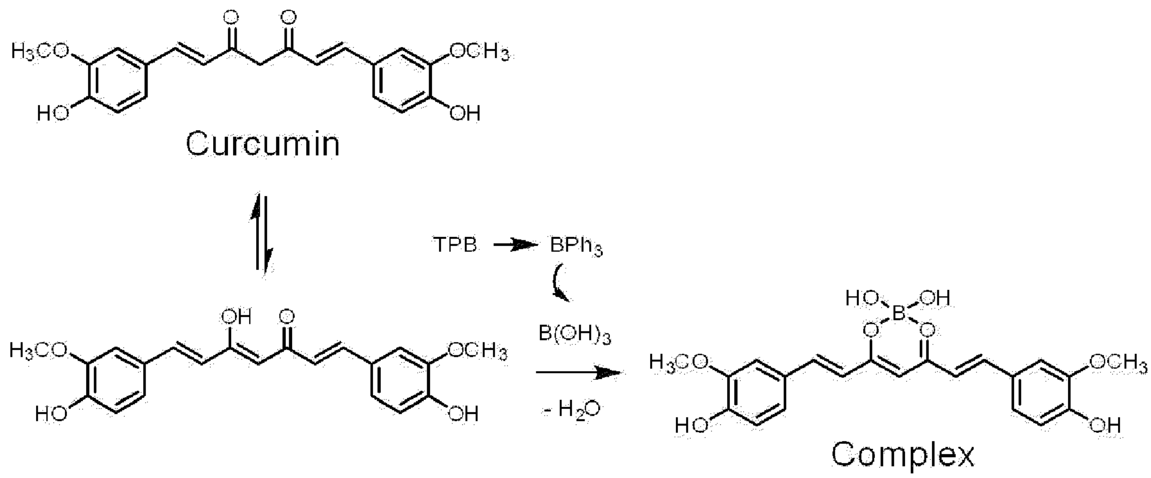


From the viewpoint of visibility of exposed portions and tone reproducibility, the coloring compound is preferably a compound having one or more ketone structures, more preferably a compound having one or more 1,3-diketone structures, β-hydroxyketone structures, or β-aminoketone structures, even more preferably a compound having one or more 1,3-diketone structures or β-hydroxyketone structures, and particularly preferably a compound having one or

more 1,3-diketone structures.

Examples of the coloring compound also include a compound having one or more 1-hydroxy-3-amino structures or 1-hydroxy-3-imino structures.

From the viewpoint of visibility of exposed portions and tone reproducibility, the coloring compound is preferably a compound having an aromatic ring structure, more preferably a compound having two or more aromatic ring structures, even more preferably a compound having two to four aromatic ring structures, and particularly preferably a compound having two aromatic ring structures. As the aromatic ring structure, from the viewpoint of visibility of exposed portions and tone reproducibility, for example, at least one kind of structure selected from the group consisting of a benzene ring structure and a naphthalene ring structure is preferable, and a benzene ring structure is more preferable.

The coloring compound may be a salt or a hydrate.

In the coloring reaction, in a case where a complex is formed by the reaction between the coloring compound and the decomposition product generated by the exposure of the image-recording layer, the coloring compound may form a ligand of the complex. The ligand may be a monodentate ligand or a polydentate ligand. From the viewpoints of complex forming properties, visibility of exposed portions, and tone reproducibility, the ligand is preferably a polydentate ligand, more preferably a bidentate ligand, a tridentate ligand, a tetradentate ligand, a pentadentate ligand, or a hexadentate ligand, even more preferably a bidentate ligand, a tridentate ligand, or a tetradentate ligand, particularly preferably a bidentate ligand or a tridentate ligand, and most preferably a bidentate ligand.

The image-recording layer preferably contains, as the coloring compound, a compound represented by Formula 1C or a compound represented by Formula 2C, and more preferably contains a compound represented by Formula 1C. After the exposure, the compound represented by Formula 1C or the compound represented by Formula 2C preferably reacts with the decomposition product generated by the exposure of the image-recording layer to form a complex which has the compound represented by Formula 1C or the compound represented by Formula 2C as a zero-valent ligand or has an anion obtained by removing one hydrogen atom from the compound represented by Formula 1C or the compound represented by Formula 2C as a monovalent ligand, and more preferably reacts with the decomposition product generated by the exposure of the image-recording layer to form a complex having an anion obtained by removing one hydrogen atom from the compound represented by Formula 1C or the compound represented by Formula 2C as a monovalent ligand.

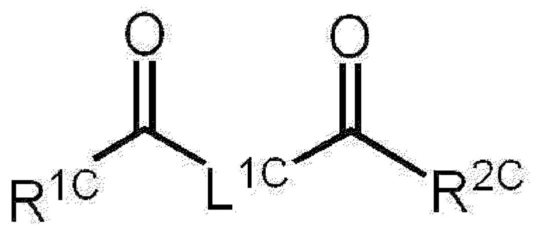

Formula 1C

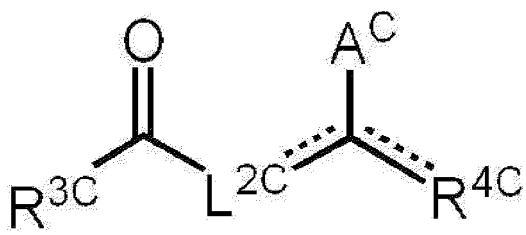

Formula 2C

In Formula 1C and Formula 2C, $R^{1C}$ to $R^{4C}$ each independently represent a monovalent organic group, $L^{1C}$ and $L^{2C}$ each independently represent a divalent organic group, $A^C$ represents OH or $NR^{5C}R^{6C}$, $R^{5C}$ and $R^{6C}$ each independently represent a hydrogen atom or a monovalent organic group, and the portion of a dotted line represents a portion which may be a double bond.

In Formula 1C, two or more of $R^{1C}$, $L^{1C}$, and $R^{2C}$ may be bonded to form a ring structure. In Formula 2C, two or more of $R^{3C}$, $L^{2C}$, $R^{4C}$, $R^{5C}$, and $R^{6C}$ may be bonded to form a ring structure.

From the viewpoint of visibility of exposed portions and tone reproducibility, $R^{1C}$ and $R^{2C}$ in Formula 1C preferably each independently represent a monovalent organic group having an aromatic ring, more preferably each independently represent an aryl group or an alkenyl group having an aryl group, and particularly preferably each independently represent a 2-arylvinyl group. The aryl group may have a substituent. From the viewpoint of visibility of exposed portions and tone reproducibility, the aryl group is preferably an aryl group which has one or more groups selected from the group consisting of a hydroxy group and an alkoxy group as substituents, more preferably a phenyl group which has one or more groups selected from the group consisting of a hydroxy group and an alkoxy group as substituents, and particularly preferably a phenyl group which has a hydroxy group and an alkoxy group as substituents.

The carbon number (number of carbon atoms) of each of $R^{1C}$ and $R^{2C}$ in Formula 1C is preferably 6 to 50, more preferably 6 to 20, and particularly preferably 8 to 20.

It is preferable that $R^{1C}$ and $R^{2C}$ in Formula 1C be the same group.

From the viewpoint of visibility of exposed portions and tone reproducibility, $L^{1C}$ in Formula 1C is preferably an alkylene group or an alkylene group having an acyloxy group, and more preferably a methylene group or an acyloxymethylene group. From the viewpoint of visibility of exposed portions, the acyloxy group is preferably an acyloxy group

having 1 to 10 carbon atoms, more preferably an acyloxy group having 1 to 4 carbon atoms, and particularly preferably an acetoxy group.

From the viewpoint of visibility of exposed portions and tone reproducibility, $R^{3C}$ in Formula 2C preferably a monovalent organic group having an aromatic ring, and more preferably an aryl group or an alkenyl group having an aryl group.

In Formula 2C, from the viewpoint of visibility of exposed portions and tone reproducibility, $L^{2C}$ and $R^{4C}$ are preferably bonded to form an aromatic ring, and more preferably bonded to form a benzene ring.

$R^{3C}$ and $R^{4C}$ in Formula 2C preferably each independently have 6 to 50 carbon atoms, more preferably each independently have 6 to 30 carbon atoms, and particularly preferably each independently have 6 to 20 carbon atoms.

In a case where $L^{2C}$ in Formula 2C is not bonded to $R^{4C}$, from the viewpoint of visibility of exposed portions and tone reproducibility, $L^{2C}$ is preferably an alkylene group or an alkylene group having an acyloxy group, and more preferably a methylene group or an acyloxymethylene group. From the viewpoint of visibility of exposed portions, the acyloxy group is preferably an acyloxy group having 1 to 10 carbon atoms, more preferably an acyloxy group having 1 to 4 carbon atoms, and particularly preferably an acetoxy group.

It is preferable that $L^{2C}$ in Formula 2C be bonded to $R^{4C}$ to form a ring member of an aromatic ring structure.

From the viewpoint of visibility of exposed portions and tone reproducibility, the compound represented by Formula 2C is preferably a compound having a 1-hydroxyanthraquinone structure or a 1-aminoanthraquinone structure, and more preferably a compound having a 1-hydroxyanthraquinone structure.

From the viewpoint of visibility of exposed portions and tone reproducibility, $A^C$ in Formula 2C is preferably OH or $NHR^{6C}$, and more preferably OH.

$R^{5C}$ in $NR^{5C}R^{6C}$ in Formula 2C is preferably a hydrogen atom, an alkyl group, or an aryl group, more preferably a hydrogen atom or an alkyl group, and particularly preferably a hydrogen atom.

$R^{6C}$ in $NR^{5C}R^{6C}$ in Formula 2C is preferably a hydrogen atom, an alkyl group, or an anthraquinolyl group, more preferably an anthraquinolyl group, and particularly preferably a 1-anthraquinolyl group.

Preferred examples of the coloring compound include curcumin, demethoxycurcumin, alizarin, iminodiantraquinone, carminic acid, azomethine H, 1,3-bis(4-methoxyphenyl)-1,3-propanedione, 4-methoxychalcone, 1,3-bis(4-dimethylaminophenyl)-1,3-propanedione, and acetoxycurcumin.

The image-recording layer may contain one kind of coloring compound or two or more kinds of coloring compounds. The image-recording layer may contain one kind of compound represented by Formula 1C or two or more kinds of compounds represented by Formula 1C. The image-recording layer may contain one kind of compound represented by Formula 2C or two or more kinds of compounds represented by Formula 2C. By the coloring reaction, one kind of complex or two or more kinds of complexes may be formed.

From the viewpoint of visibility of exposed portions and tone reproducibility, the content of the coloring compound with respect to the total mass of the image-recording layer is preferably 0.001% by mass to 5% by mass, more preferably 0.01% by mass to 3% by mass, even more preferably 0.05% by mass to 2.5% by mass, and particularly preferably 0.05% by mass to 1.0% by mass.

From the viewpoint of visibility of exposed portions and tone reproducibility, the content of the compound represented by Formula 1C and the compound represented by Formula 2C with respect to the total mass of the image-recording layer is preferably 0.001% by mass to 5% by mass, more preferably 0.01% by mass to 3% by mass, even more preferably 0.05% by mass to 2.5% by mass, and particularly preferably 0.05% by mass to 1.0% by mass.

From the viewpoint of visibility of exposed portions and tone reproducibility, the content of the complex in the image-recording layer exposed to infrared having a wavelength of 830 nm at an energy density of 110 $mJ/cm^2$ with respect to the total mass of the image-recording layer is preferably 0.0001% by mass to 10% by mass, more preferably 0.001% by mass to 5% by mass, even more preferably 0.005% by mass to 2.5% by mass, and particularly preferably 0.005% by mass to 1.0% by mass.

The molar ratio of a content $M^C$ of the coloring compounds (preferably the compound represented by Formula 1C and the compound represented by Formula 2C) in the image-recording layer to a content $M^1$ of the polymerization initiator in the image-recording layer (that is, $M^C/M^I$) is preferably 0.001 to 1, more preferably 0.01 to 0.8, and particularly preferably 0.05 to 0.5.

The molar ratio of a content $M^C$ of the coloring compounds (preferably the compound represented by Formula 1C and the compound represented by Formula 2C) in the image-recording layer to a content $M^{DI}$ of the Electron-donating polymerization initiator in the image-recording layer (that is, $M^C/M^{DI}$) is preferably 0.001 to 1.5, more preferably 0.01 to 1, and particularly preferably 0.05 to 0.8.

[Other components]

The image-recording layer may contain components different from the above components, as other components. Examples of those other components include a binder polymer, a color developing agent, a chain transfer agent, a

low-molecular-weight hydrophilic compound, an oil sensitizing agent, a plasticizer, and other additives.

(Binder polymer)

As necessary, the image-recording layer may contain a binder polymer. Herein, "binder polymer" refers to a polymer other than resin particles, that is, a polymer that is not in the form of particles. The ammonium salt-containing polymer in an oil sensitizing agent and a polymer used as a surfactant are excluded from the binder polymer.
As the binder polymer, known binder polymers (for example, a (meth) acrylic resin, a polyvinyl acetal resin, and a polyurethane resin) used for the image-recording layer of a lithographic printing plate precursor can be suitably used. As an example of the binder polymer, a binder polymer that is used for an on-press development type lithographic printing plate precursor (hereinafter, also called binder polymer for on-press development) will be specifically described.
As the binder polymer for on-press development, a binder polymer having an alkylene oxide chain is preferable. The binder polymer having an alkylene oxide chain may have a poly(alkylene oxide) moiety in a main chain or side chain. In addition, the binder polymer having an alkylene oxide chain may be a graft polymer having poly(alkylene oxide) in a side chain or a block copolymer of a block composed of a poly(alkylene oxide)-containing repeating unit and a block composed of an (alkylene oxide)-free repeating unit. In a case where the binder polymer has a poly(alkylene oxide) moiety in the main chain, a polyurethane resin is preferable. In a case where the binder polymer has a poly(alkylene oxide) moiety in the side chain, examples of polymers include a (meth)acrylic resin, a polyvinyl acetal resin, a polyurethane resin, a polyurea resin, a polyimide resin, a polyamide resin, an epoxy resin, a polystyrene resin, a novolac-type phenol resin, a polyester resin, synthetic rubber, and natural rubber. Among these, a (meth)acrylic resin is particularly preferable.
Preferred examples of the binder polymer include a polymer compound which has a polyfunctional thiol having functionalities of 6 or more and 10 or less as a nucleus and a polymer chain that is bonded to the nucleus by a sulfide bond and has a polymerizable group (hereinafter, this compound will be also called star-shaped polymer compound). As the star-shaped polymer compound, for example, the compounds described in JP2012-148555A can be preferably used.
Examples of the star-shaped polymer compound include the compound described in JP2008-195018A that has a polymerizable group such as an ethylenically unsaturated bond for improving the film hardness of an image area in a main chain or side chain and preferably in a side chain. The polymerizable group of the star-shaped polymer compound forms crosslinks between the molecules of the star-shaped polymer compound, which facilitates curing.
As the polymerizable group, an ethylenically unsaturated group (for example, a (meth)acryloyl group, a vinyl group, an allyl group, or a vinyl phenyl group (styryl group)) or an epoxy group is preferable, a (meth)acryloyl group, a vinyl group, or a vinyl phenyl group (styryl group) is more preferable from the viewpoint of polymerization reactivity, and a (meth) acryloyl group is particularly preferable. These groups can be introduced into the binder polymer by a polymer reaction or copolymerization. Specifically, for example, it is possible to use a reaction between a polymer having a carboxy group in a side chain and glycidyl methacrylate or a reaction between a polymer having an epoxy group and an ethylenically unsaturated group-containing carboxylic acid such as methacrylic acid.
The polystyrene-equivalent weight-average molecular weight (Mw) of the binder polymer that is determined by GPC is preferably 2,000 or more, more preferably 5,000 or more, and particularly preferably 10,000 to 300,000.
As the binder polymer, as necessary, a hydrophilic polymer such as polyacrylic acid or polyvinyl alcohol described in JP2008-195018A can be used in combination. In addition, a lipophilic polymer and a hydrophilic polymer can be used in combination.
The image-recording layer may contain one kind of binder polymer or two or more kinds of binder polymers.
The content of the binder polymer with respect to the total mass of the image-recording layer is preferably 1% by mass to 90% by mass, and more preferably 5% by mass to 80% by mass.

(Color developing agent)

The image-recording layer preferably contains a color developing agent, and more preferably contains an acid color developing agent. The image-recording layer preferably contains a leuco compound (also called leuco colorant) as a color developing agent.
"Color developing agent" means a compound that has a property of developing or removing color by a stimulus, for example, light or an acid, and thus changing the color of the image-recording layer.
Herein, "acid color developing agent" means a compound having a property of developing or removing color by being heated in a state of accepting an electron accepting compound (for example, a proton of an acid or the like) and thus changing the color of the image-recording layer. The acid color developing agent is preferably a colorless compound which has a partial skeleton such as lactone, lactam, sultone, spiropyran, an ester, or an amide and allows such a partial skeleton to rapidly open the ring or to be cleaved when coming into contact with an electron accepting compound.
Examples of the acid color developing agent include the compounds described in paragraphs "0184" to "0191" of JP2019-18412A.

From the viewpoint of color developability, the color developing agent is preferably at least one kind of compound selected from the group consisting of a spiropyran compound, a spirooxazine compound, a spirolactone compound, and a spirolactam compound.

From the viewpoint of visibility, the color of a colorant after color development preferably has maximum absorption wavelength in the range of 450 nm to 650 nm. The tint is preferably red, purple, blue, or dark green.

From the viewpoint of color developability and visibility of exposed portions, the acid color developing agent is preferably a leuco colorant. The leuco colorant is not particularly limited as long as it has a leuco structure. The leuco colorant preferably has a spiro structure, and more preferably has a spirolactone ring structure. From the viewpoint of color developability and visibility of exposed portions, the leuco colorant is preferably a leuco colorant having a phthalide structure or a fluoran structure. From the viewpoint of color developability and visibility of exposed portions, the leuco colorant having a phthalide structure or a fluoran structure is preferably a compound represented by any one of Formula (Le-1), Formula (Le-2), or Formula (Le-3), and more preferably a compound represented by Formula (Le-2).

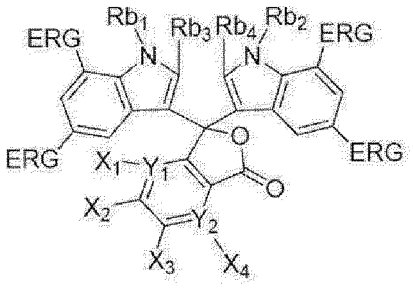

(Le-1)

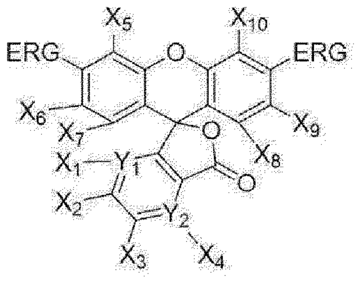

(Le-2)

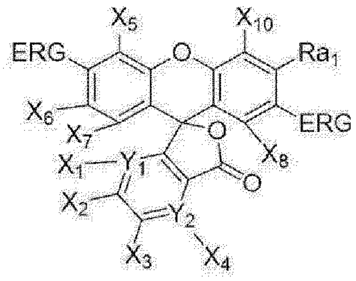

(Le-3)

In Formula (Le-1) to Formula (Le-3), ERG each independently represent an electron-donating group, $X_1$ to $X_4$ each independently represent a hydrogen atom, a halogen atom, or a dialkylanilino group, $X_5$ to $X_{10}$ each independently represent a hydrogen atom, a halogen atom, or a monovalent organic group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent a hydrogen atom, an alkyl group, or an aryl group.

From the viewpoint of color developability and visibility of exposed portions, the electron-donating groups represented by ERG in Formula (Le-1) to Formula (Le-3) is preferably an amino group, an alkylamino group, an arylamino group, a dialkylamino group, a monoalkyl monoarylamino group, a diarylamino group, an alkoxy group, an aryloxy group or an alkyl group, more preferably an amino group, alkylamino group, arylamino group, dialkylamino group, monoalkyl monoarylamino group, diarylamino group, alkoxy group, or an aryloxy group, even more preferably an arylamino group, a monoalkyl monoarylamino group, or a diarylamino group, and particularly preferably an arylamino group or a monoalkyl monoarylamino group.

From the viewpoint of color developability and visibility of exposed portions, $X_1$ to $X_4$ in Formula (Le-1) to Formula (Le-3) preferably each independently represent a hydrogen atom or a chlorine atom, and more preferably each independently represent a hydrogen atom.

From the viewpoint of color developability and visibility of exposed portions, $X_5$ to $X_{10}$ in Formula (Le-2) or Formula (Le-3) preferably each independently represent a hydrogen atom, a halogen atom, an alkyl group, an aryl group, an amino group, an alkylamino group, an arylamino group, a dialkylamino group, a monoalkyl monoarylamino group, a diarylamino group, a hydroxy group, an alkoxy group, an aryloxy group, an acyl group, an alkoxycarbonyl group, an aryloxycarbonyl group, or a cyano group, more preferably each independently represent a hydrogen atom, a halogen atom, an alkyl group, an aryl group, an alkoxy group, or an aryloxy group, even more preferably each independently represent a hydrogen atom, a halogen atom, an alkyl group, or an aryl group, and particularly preferably each independently represent a hydrogen atom.

From the viewpoint of color developability and visibility of exposed portions, it is preferable that at least one of $Y_1$ or $Y_2$ in Formula (Le-1) to Formula (Le-3) be C, and it is more preferable that both of $Y_1$ and $Y_2$ be C.

From the viewpoint of color developability and visibility of exposed portions, $Ra_1$ in Formula (Le-3) is preferably an alkyl group or an alkoxy group, more preferably an alkoxy group, and particularly preferably a methoxy group.

From the viewpoint of color developability and visibility of exposed portions, $Rb_1$ to $Rb_4$ in Formula (Le-1) preferably each independently represent a hydrogen atom or an alkyl group, more preferably each independently represent an alkyl group, and particularly preferably each independently represent a methyl group.

Furthermore, from the viewpoint of color developability and visibility of exposed portions, the leuco colorant having a phthalide structure or a fluoran structure is preferably a compound represented by any one of Formula (Le-4),

Formula (Le-5), or Formula (Le-6), and more preferably a compound represented by Formula (Le-5).

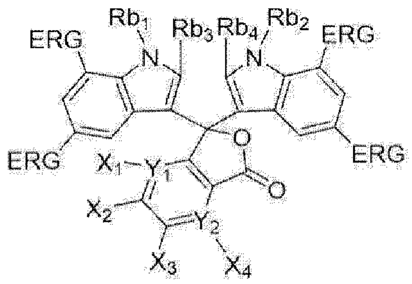

(Le-4)

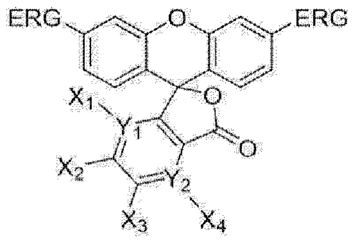

(Le-5)

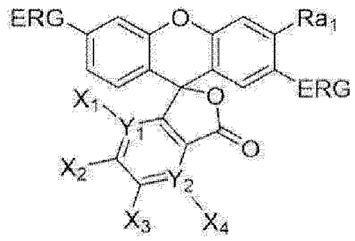

(Le-6)

In Formula (Le-4) to Formula (Le-6), ERG each independently represent an electron-donating group, $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent a hydrogen atom, an alkyl group, or an aryl group.

ERG, $X_1$ to $X_4$, $Y_1$, $Y_2$, $Ra_1$, and $Rb_1$ to $Rb_4$ in Formula (Le-4) to Formula (Le-6) have the same definitions as ERG, $X_1$ to $X_4$, $Y_1$, $Y_2$, $Ra_1$, and $Rb_1$ to $Rb_4$ in Formula (Le-1) to Formula (Le-3) respectively, and preferred aspects thereof are also the same.

Furthermore, from the viewpoint of color developability and visibility of exposed portions, the leuco colorant having a phthalide structure or a fluoran structure is preferably a compound represented by any one of Formula (Le-7), Formula (Le-8), or Formula (Le-9), and more preferably a compound represented by Formula (Le-8).

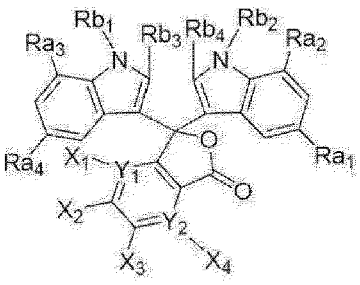

(Le-7)

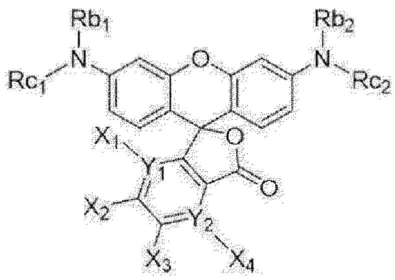

(Le-8)

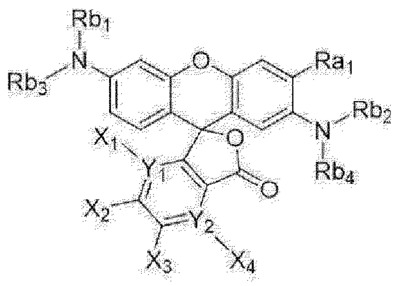

(Le-9)

In Formula (Le-7) to Formula (Le-9), $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ to $Ra_4$ each independently represent a hydrogen atom, an alkyl group, or an alkoxy group, $Rb_1$ to $Rb_4$ each independently represent a hydrogen atom, an alkyl group, or an aryl group, and $Rc_1$ and $Rc_2$ each independently represent an aryl group.

$X_1$ to $X_4$, $Y_1$, and $Y_2$ in Formula (Le-7) to Formula (Le-9) have the same definition as $X_1$ to $X_4$, $Y_1$, and $Y_2$ in Formula (Le-1) to Formula (Le-3) respectively, and preferred aspects thereof are also the same.

From the viewpoint of color developability and visibility of exposed portions, $Ra_1$ to $Ra_4$ in Formula (Le-7) preferably each independently represent an alkyl group or an alkoxy group, more preferably each independently represent an alkoxy group, and particularly preferably each independently represent a methoxy group.

From the viewpoint of color developability and visibility of exposed portions, $Rb_1$ to $Rb_4$ in Formula (Le-7) to Formula (Le-9) preferably each independently represent a hydrogen atom, an alkyl group, or an aryl group substituted with an alkyl group or alkoxy group, more preferably each independently represent a hydrogen atom or an alkyl group, and particularly preferably each independently represent a hydrogen atom or a methyl group.

From the viewpoint of color developability and visibility of exposed portions, $Rc_1$ and $Rc_2$ in Formula (Le-8) preferably each independently represent a phenyl group or an alkylphenyl group, and more preferably each independently represent a phenyl group.

In Formula (Le-8), from the viewpoint of color developability and visibility of exposed portions, $X_1$ to $X_4$ preferably each represent a hydrogen atom, and $Y_1$ and $Y_2$ preferably each represent C.

From the viewpoint of color developability and visibility of exposed portions, $Rb_1$ and $Rb_2$ in Formula (Le-8)

preferably each independently represent a hydrogen atom, an alkyl group, or an aryl group substituted with an alkyl group or an alkoxy group, more preferably each independently represent a hydrogen atom or an alkyl group.

The alkyl group in Formula (Le-1) to Formula (Le-9) may be linear or branched. The alkyl group in Formula (Le-1) to Formula (Le-9) may have a ring structure.

The number of carbon atoms in the alkyl group in Formula (Le-1) to Formula (Le-9) is preferably 1 to 20, more preferably 1 to 8, even more preferably 1 to 4, and particularly preferably 1 or 2.

The number of carbon atoms in the aryl group in Formula (Le-1) to Formula (Le-9) is preferably 6 to 20, more preferably 6 to 10, and particularly preferably 6 to 8.

Each of the groups in Formula (Le-1) to Formula (Le-9) (for example, a monovalent organic group, an alkyl group, an aryl group, a dialkylanilino group, an alkylamino group, and an alkoxy group) may have a substituent. Examples of the substituent include an alkyl group, an aryl group, a halogen atom, an amino group, an alkylamino group, an arylamino group, a dialkylamino group, a monoalkyl monoarylamino group, a diarylamino group, a hydroxy group, an alkoxy group, an aryloxy group, an acyl group, an alkoxycarbonyl group, an aryloxycarbonyl group, and a cyano group. These substituents may be further substituted with the substituents described above.

Examples of the leuco colorant having the phthalide structure or the fluoran structure that are suitably used include the following compounds.

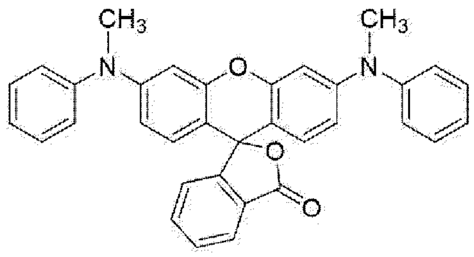

S - 1

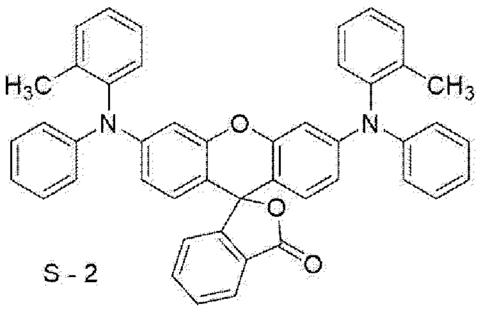

S - 2

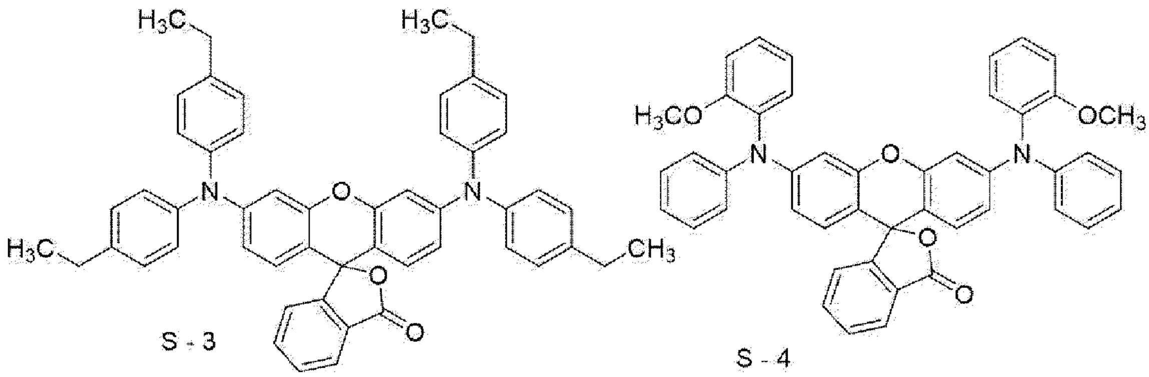

S - 3

S - 4

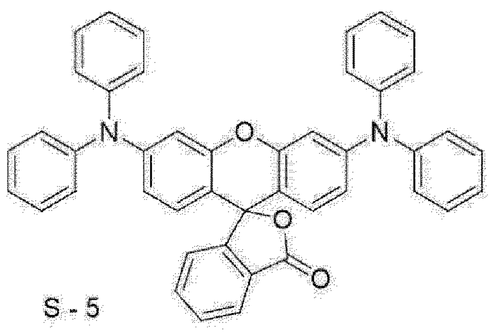

S - 5

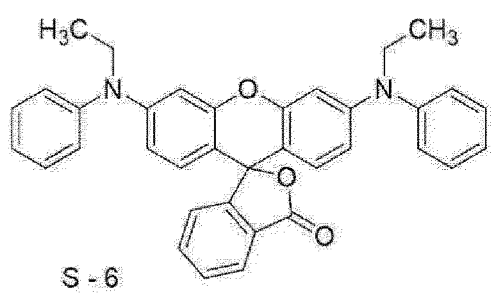

S - 6

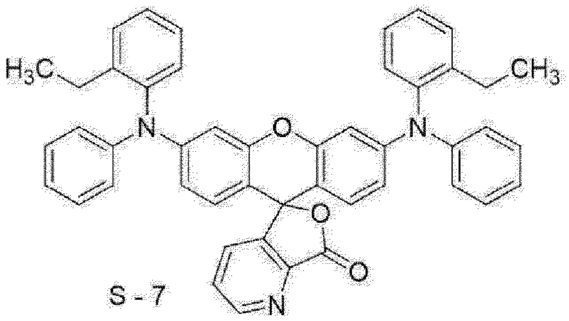

S - 7

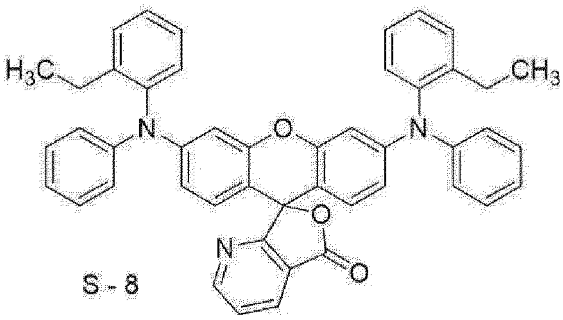

S - 8

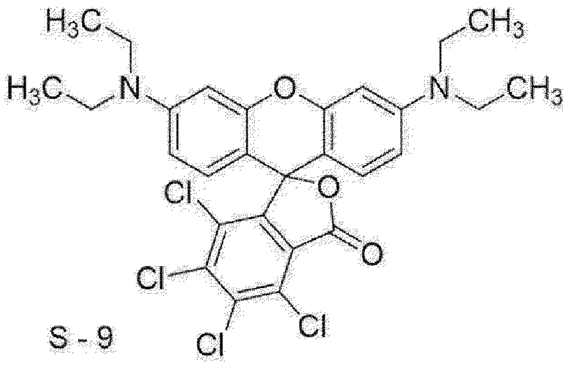

S - 9

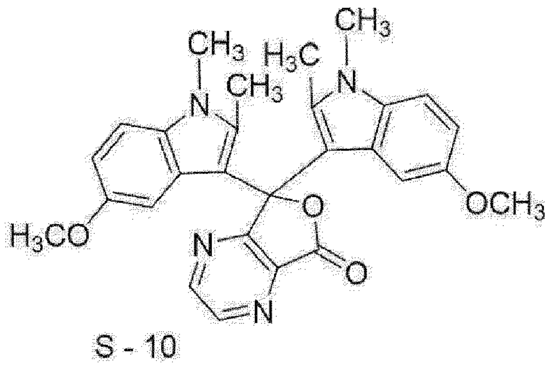

S - 10

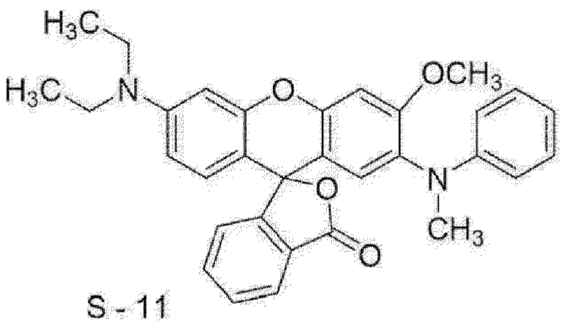

S - 11

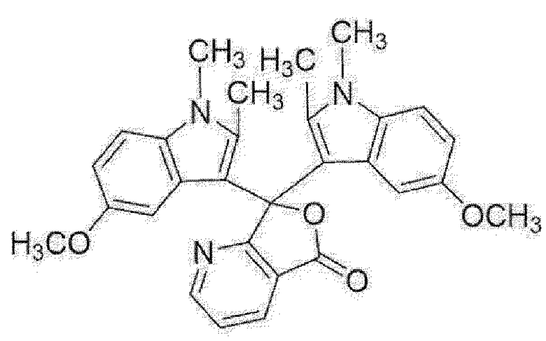

S - 12

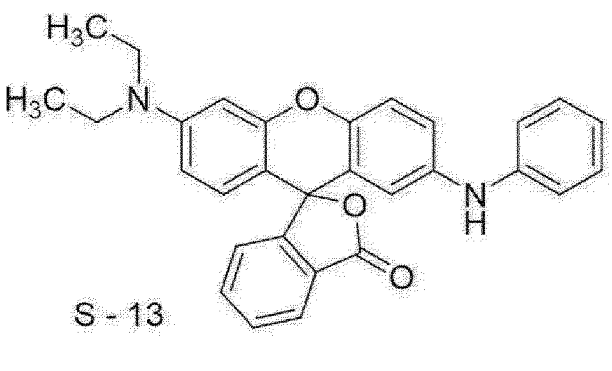

S - 13

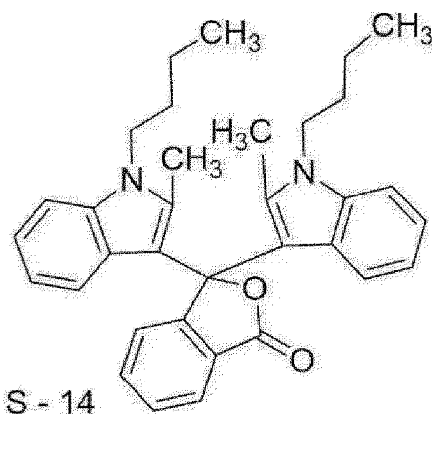

S - 14

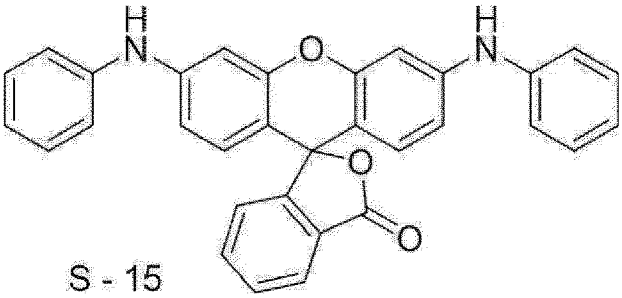

S - 15

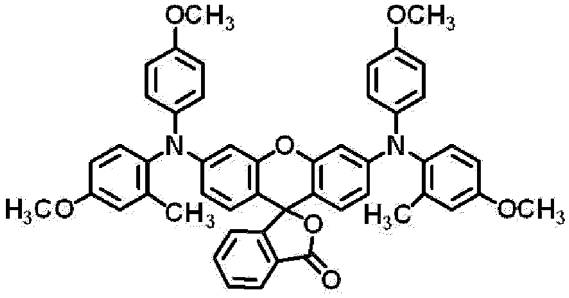

S - 16

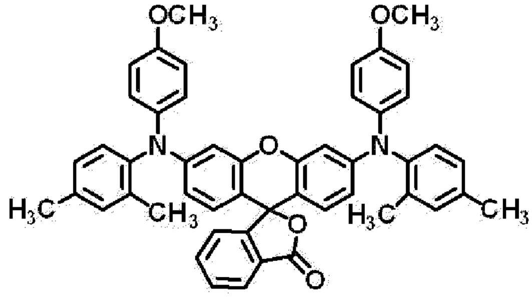

S - 17

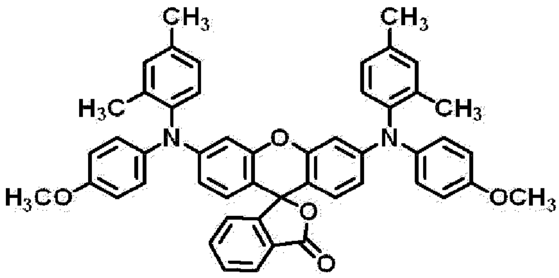

S - 18

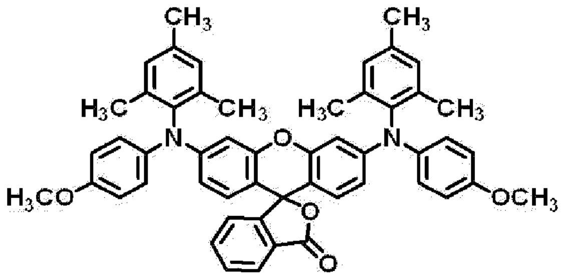

S - 19

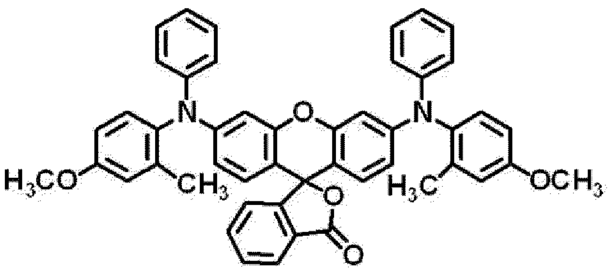

S - 20

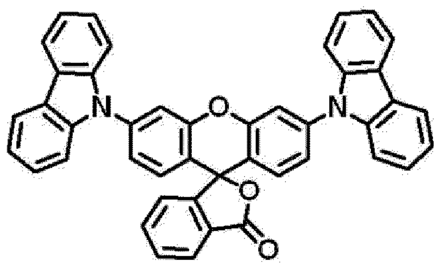

S - 21

As the acid color developing agent, the products on the market (that is, commercially available products) can also be used. Examples of the commercially available products include ETAC, RED500, RED520, CVL, S-205, BLACK305, BLACK400, BLACK100, BLACK500, H-7001, GREEN300, NIRBLACK78, BLUE220, H-3035, BLUE203, ATP, H-1046, and H-2114 (all manufactured by Fukui Yamada Chemical Co., Ltd.), ORANGE-DCF, Vermilion-DCF, PINK-DCF, RED-DCF, BLMB, CVL, GREEN-DCF, and TH-107 (all manufactured by Hodogaya Chemical Co., Ltd.), ODB, ODB-2, ODB-4, ODB-250, ODB-BlackXV, Blue-63, Blue-502, GN-169, GN-2, Green-118, Red-40, and Red-8 (all manufactured by Yamamoto Chemicals, Inc.), and crystal violet lactone (manufactured by Tokyo Chemical Industry Co., Ltd.). Among these commercially available products, ETAC, S-205, BLACK305, BLACK400, BLACK100, BLACK500, H-7001, GREEN300, NIRBLACK78, H-3035, ATP, H-1046, H-2114, GREEN-DCF, Blue-63, GN-169, and crystal violet lactone are preferable because these form a film having excellent visible light absorbance.

From the viewpoint of color developability and visibility of exposed portions, examples of suitably used a leuco colorant include the following compounds.

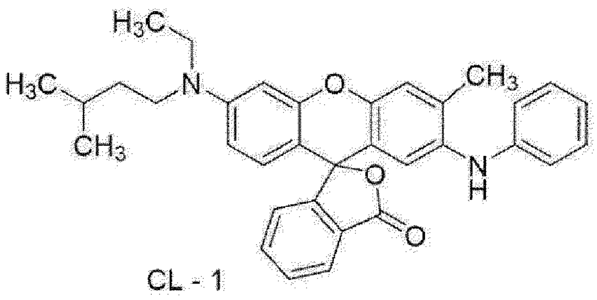

CL - 1

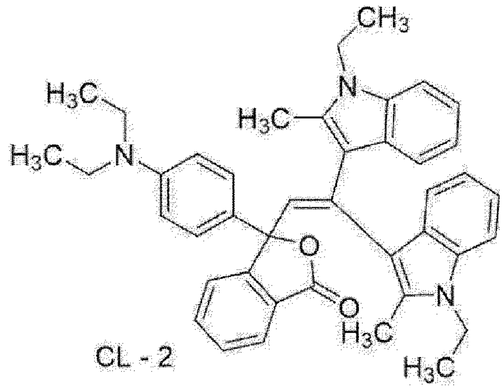

CL - 2

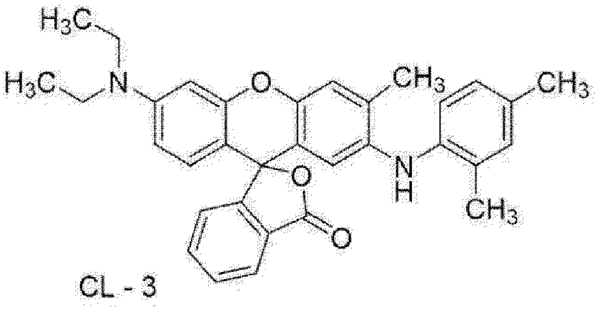

CL - 3

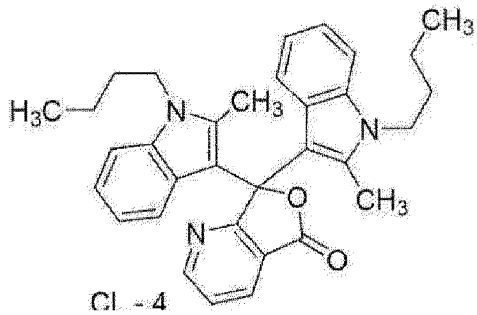

CL - 4

The image-recording layer may contain one kind of color developing agent or two or more kinds of color developing agents. The content of the color developing agent with respect to the total mass of the image-recording layer is preferably 0.5% by mass to 10% by mass, and more preferably 1% by mass to 5% by mass.

(Chain transfer agent, low-molecular-weight hydrophilic compound, oil sensitizing agent, and other additives)

The components that can be used in the image-recording layer are described in, for example, paragraph "0082" of JP2019-162855A.

[Formation method]

The image-recording layer can be formed by a known method (for example, a coating method). The coating amount (solid content) of the image-recording layer is preferably 100 mg/$m^2$ to 3,000 mg/$m^2$, and more preferably 300 mg/$m^2$ to 1,500 mg/$m^2$.

<<Undercoat layer>>

The on-press development type lithographic printing plate precursor preferably has an undercoat layer between the image-recording layer and the support. **In** the technical field relating to the present invention, the undercoat layer may also be called interlayer. The undercoat layer enhances the adhesion between the support and the image-recording layer in an exposed portion, and enables the image-recording layer to be easily peeled from the support in a non-exposed portion of the undercoat layer. Therefore, the undercoat layer contributes to the improvement of developability without deteriorating printing durability. Furthermore, in the case of exposure to infrared laser, by functioning as a heat insulating layer, the undercoat layer can prevent sensitivity reduction resulting from the diffusion of heat generated by exposure to the support.

Examples of compounds contained in the undercoat layer include polymers having adsorbent group that can be adsorbed onto the surface of the support and hydrophilic groups. In order to improve adhesiveness to the image-recording layer, the compounds contained in the undercoat layer are preferably polymers having adsorbent groups and hydrophilic groups plus crosslinking groups. The compounds contained in the undercoat layer may be low-molecular-weight compounds or polymers. As necessary, as the compounds contained in the undercoat layer, two or more kinds of

compounds may be used by being mixed together.

In a case where the compounds contained in the undercoat layer are polymers, the polymers are preferably a copolymer of a monomer having an adsorbent group, a monomer having a hydrophilic group, and a monomer having a crosslinking group is preferable.

As the adsorbent group, a phenolic hydroxyl group, a carboxy group, $-PO_3H_2$, $-OPO_3H_2$, $-CONHSO_2-$, $-SO_2NHSO_2-$, or $-COCH_2COCH_3$ is preferable.

As the hydrophilic group, a sulfo group or a salt thereof and a salt of a carboxy group are preferable.

As the crosslinking group, an acryloyl group, a methacryloyl group, an acrylamide group, a methacrylamide group, or an allyl group is preferable.

The polymer may have a crosslinking group introduced by the formation of a salt of a polar substituent of the polymer and a compound that has a substituent having charge opposite to that of the polar substituent and an ethylenically unsaturated bond. The polymer may be a monomer other than the above, and is preferably further copolymerized with a hydrophilic monomer.

Specifically, for example, silane coupling agents having addition polymerizable ethylenic double bond reactive groups described in JP1998-282679A (JP-H10-282679A) and phosphorus compounds having ethylenic double bond reactive groups described in JP1990-304441A (JP-H02-304441A) are suitable. The low-molecular-weight compounds or polymer compounds having crosslinking groups (preferably ethylenically unsaturated bonding groups), functional groups that interact with the surface of the support, and hydrophilic groups described in JP2005-238816A, JP2005-125749A, JP2006-239867A, and JP2006-215263A are also preferably used. More preferred examples thereof include the high-molecular-weight polymers having adsorbent groups that can be adsorbed onto the surface of the support, hydrophilic groups, and crosslinking groups described in JP2005-125749A and JP2006-188038A.

The content of ethylenically unsaturated bonding group in the polymer contained in the undercoat layer is preferably 0.1 mmol to 10.0 mmol per 1 g of the polymer, and more preferably 0.2 mmol to 5.5 mmol per 1 g of the polymer.

The weight-average molecular weight (Mw) of the polymer contained in the undercoat layer is preferably 5,000 or more, and more preferably 10,000 to 300,000.

[Hydrophilic compound]

From the viewpoint of developability, it is preferable that the undercoat layer contain a hydrophilic compound. As the hydrophilic compound, for example, known hydrophilic compounds used for the undercoat layer can be used.

Preferred examples of the hydrophilic compound include phosphonic acids having an amino group such as carboxymethyl cellulose and dextrin, an organic phosphonic acid, an organic phosphoric acid, an organic phosphinic acid, amino acids, and a hydrochloride of an amine having a hydroxy group.

Preferred examples of the hydrophilic compound include a compound having an amino group or a functional group capable of inhibiting polymerization and a group that interacts with the surface of the support (for example, 1,4-diazabicyclo[2.2.2]octane (DABCO), 2,3,5,6-tetrahydroxy-p-quinone, chloranil, sulfophthalic acid, ethylenediaminetetraacetic acid (EDTA) or a salt thereof, hydroxyethyl ethylenediaminetriacetic acid or a salt thereof, dihydroxyethyl ethylenediaminediacetic acid or a salt thereof, and hydroxyethyl iminodiacetic acid or a salt thereof).

From the viewpoint of scratch and contamination suppressiveness, it is preferable that the undercoat layer contain hydroxycarboxylic acid or a salt thereof as a hydrophilic compound.

Herein, "hydroxycarboxylic acid" is the generic term for organic compounds having one or more carboxy groups and one or more hydroxy groups in one molecule. These compounds are also called hydroxy acid, oxy acid, oxycarboxylic acid, or alcoholic acid (see Iwanami Dictionary of Physics and Chemistry, 5th Edition, published by Iwanami Shoten, Publishers. (1998)).

The hydroxycarboxylic acid or a salt thereof is preferably represented by Formula (HC).

$$R^{HC}(OH)_{mhc}(COOM^{HC})_{nhc}: \qquad \text{Formula (HC)}$$

In Formula (HC), $R^{HC}$ represents an (mhc + nhc)-valent organic group, $M^{HC}$ each independently represent a hydrogen atom, an alkali metal, or an onium, and mhc and nhc each independently represent an integer of 1 or more. In a case where nhc is 2 or more, Ms may be the same as or different from each other.

Examples of the (mhc + nhc)-valent organic group represented by $R^{HC}$ in Formula (HC) include an (mhc + nhc)-valent hydrocarbon group. The hydrocarbon group may have a substituent and/or a linking group. Examples of the hydrocarbon group include an (mhc + nhc)-valent group derived from aliphatic hydrocarbon (for example, an alkylene group, an alkanetriyl group, an alkanetetrayl group, an alkanepentayl group, an alkenylene group, an alkenetriyl group, an alkenetetrayl group, and alkenepentayl group, an alkynylene group, an alkynetriyl group, alkynetetrayl group, and an alkynepentayl group) and an (mhc + nhc)-valent group derived from aromatic hydrocarbon (for example, an arylene group, an arenetriyl group, an arenetetrayl group, and an arenepentayl group). Examples of the substituent include an alkyl

group, an alkenyl group, an alkynyl group, an aralkyl group, and an aryl group. Specific examples of the substituent include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, eicosyl group, isopropyl group, isobutyl group, s-butyl group, t-butyl group, isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group, a methoxymethyl group, a methoxyethoxyethyl group, an allyloxymethyl group, a phenoxymethyl group, an acetyloxymethyl group, a benzoyloxymethyl group, a benzyl group, a phenethyl group, an $\alpha$-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group, a 3-butynyl group, a phenyl group, a biphenyl group, a naphthyl group, a tolyl group, a xylyl group, a mesityl group, a cumenyl group, a methoxyphenyl group, an ethoxyphenyl group, a phenoxyphenyl group, an acetoxyphenyl group, a benzoyloxyphenyl group, a methoxycarbonylphenyl group, an ethoxycarbonylphenyl group, and a phenoxycarbonylphenyl group. The linking group is a linking group composed of at least one atom selected from the group consisting of a hydrogen atom, a carbon atom, an oxygen atom, a nitrogen atom, a sulfur atom, and a halogen atom. The number of atoms of the linking group is preferably 1 to 50. Specific examples of the linking group include an alkylene group, a substituted alkylene group, an arylene group, and a substituted arylene group. The linking group may have a structure in which a plurality of the aforementioned divalent groups is linked by at least one kind of bond selected from the group consisting of an amide bond, an ether bond, a urethane bond, a urea bond, and an ester bond.

Examples of the alkali metal represented by $M^{HC}$ in Formula (HC) include lithium, sodium, and potassium. Among these, sodium is particularly preferable. Examples of the onium represented by $M^{HC}$ in Formula (HC) include ammonium, phosphonium, and sulfonium. Among these, ammonium is particularly preferable. From the viewpoint of scratch and contamination suppressiveness, $M^{HC}$ is preferably an alkali metal or an onium, and more preferably an alkali metal.

The sum of mhc and nhc in Formula (HC) is preferably 3 or more, more preferably 3 to 8, and particularly preferably 4 to 6.

The molecular weight of the hydroxycarboxylic acid or a salt thereof is preferably 600 or less, more preferably 500 or less, and particularly preferably 300 or less. The molecular weight of the hydroxycarboxylic acid or a salt thereof is preferably 76 or more.

Examples of the hydroxycarboxylic acid constituting the hydroxycarboxylic acid or a salt of the hydroxycarboxylic acid include gluconic acid, glycolic acid, lactic acid, tartronic acid, hydroxybutyrate (for example, 2-hydroxybutyrate, 3-hydroxybutyrate, and $\gamma$-hydroxybutyrate), malic acid, tartaric acid, citramalic acid, citric acid, isocitric acid, leucine acid, mevalonic acid, pantoic acid, ricinoleic acid, ricineraidic acid, cerebronic acid, quinic acid, shikimic acid, a monohydroxybenzoic acid derivative (for example, salicylic acid, creosotic acid (homosalicylic acid, and hydroxy(methyl) benzoate), vanillic acid, or syringic acid), a dihydroxybenzoic acid derivative (for example, pyrocatechuic acid, resorcylic acid, protocatechuic acid, gentisic acid, and orsellinic acid), a trihydroxybenzoic acid derivative (for example, gallic acid), a phenyl acetate derivative (for example, mandelic acid, benzilic acid, and atrolactic acid), and a hydrocinnamic acid derivative (for example, melilotic acid, phloretic acid, coumaric acid, umbellic acid, caffeic acid, ferulic acid, sinapic acid, cerebronic acid, and carminic acid).

As the hydroxycarboxylic acid or a hydroxycarboxylic acid constituting a salt of the hydroxycarboxylic acid, from the viewpoint of scratch and contamination suppressiveness, a compound having two or more hydroxy groups is preferable, a compound having 3 or more hydroxy groups is more preferable, a compound having 5 or more hydroxy groups is even more preferable, and a compound having 5 to 8 hydroxy groups is particularly preferable.

As the compound having one carboxy group and two or more hydroxy groups, gluconic acid or shikimic acid is preferable. As the compound having two carboxy groups and one hydroxy group, citric acid or malic acid is preferable. As compound having two or more carboxy groups and two or more hydroxy groups, tartaric acid is preferable. Among the above, gluconic acid is particularly preferable as the hydroxycarboxylic acid.

The undercoat layer may contain one kind of hydrophilic compound or two or more kinds of hydrophilic compounds. **In** a case where the undercoat layer contains a hydrophilic compound (preferably hydroxycarboxylic acid or a salt thereof), the content of the hydrophilic compound (preferably hydroxycarboxylic acid or a salt thereof) with respect to the total mass of the undercoat layer is preferably 0.01% by mass to 50% by mass, more preferably 0.1% by mass to 40% by mass, and particularly preferably 1.0% by mass to 30% by mass.

-Range of application of hydrophilic compound-

As described below, the hydrophilic compound (preferably hydroxycarboxylic acid or a salt thereof) can be used not only as a component the undercoat layer but also as a component of layer other than the undercoat layer.

From the viewpoint of scratch and contamination suppressiveness, it is preferable that the hydrophilic compound (preferably hydroxycarboxylic acid or a salt thereof) be contained in a layer on the aluminum support which is a sort of

support. The layer on the aluminum support is preferably a layer disposed on the side where the image-recording layer is formed. Furthermore, the layer on the aluminum support is more preferably a layer in contact with the aluminum support. Preferred examples of the layer on the aluminum support (preferably a layer in contact with the aluminum support) the undercoat layer or the image-recording layer.

The hydrophilic compound (preferably hydroxycarboxylic acid or a salt thereof) may be contained in a layer (for example, the outermost layer or the image-recording layer) other than the layer in contact with the aluminum support. **In** a certain embodiment, from the viewpoint of scratch and contamination suppressiveness, it is preferable that the image-recording layer contain hydroxycarboxylic acid or a salt thereof.

An aspect is also preferable in which the surface of the aluminum support on the image-recording layer side is treated with a composition (for example, an aqueous solution or the like) containing at least hydroxycarboxylic acid or a salt thereof. In the above aspect, at least some of the hydroxycarboxylic acid or a salt thereof used for treatment can be detected in a state of being contained in the layer on the image-recording layer side (for example, the image-recording layer or the undercoat layer) that is in contact with the aluminum support. In a case where the layer on the side of the image-recording layer in contact with the aluminum support contains hydroxycarboxylic acid or a salt thereof, the surface of the aluminum support on the side of the image-recording layer can be hydrophilized. Furthermore, in a case where the layer on the side of the image-recording layer that is in contact with the aluminum support contains hydroxycarboxylic acid or a salt thereof, and it is easy for the surface of the aluminum support on the image-recording layer side to have a water contact angle of 110° or less measured by an airborne water droplet method, which result in excellent scratch and contamination suppressiveness.

[Other components]

In order to prevent contamination over time, the undercoat layer may contain, for example, a chelating agent, a secondary or tertiary amine, and a polymerization inhibitor, in addition to the following compounds for an undercoat layer.

[Formation method]

The undercoat layer can be formed by a known method (for example, a coating method). The coating amount (solid content) of the undercoat layer is preferably 0.1 mg/$m^2$ to 300 mg/$m^2$, and more preferably 5 mg/$m^2$ to 200 mg/$m^2$.

<<Use>>

The on-press development type lithographic printing plate precursor is a lithographic printing plate precursor that can be used for on-press development. The on-press development type lithographic printing plate precursor can form, for example, a lithographic printing plate through an exposure step and an on-press development step that will be described later. The obtained lithographic printing plate can be used for various printing methods.

<Method of preparing lithographic printing plate and lithographic printing method>

The method of preparing a lithographic printing plate according to an embodiment of the present invention includes a step of exposing the on-press development type lithographic printing plate precursor according to an embodiment of the present invention in the shape of an image (hereinafter, this step will be also called "exposure step") and a step of removing the image-recording layer in a non-image area by supplying at least one material selected from the group consisting of printing ink and dampening water on a printer (hereinafter, this step will be also called "on-press development step"). There is provided a method of preparing a lithographic printing plate by using an on-press development type lithographic printing plate precursor in which discoloration caused by exposure to ozone is suppressed.

The lithographic printing method according described herein includes a step of exposing the on-press development type lithographic printing plate precursor in the shape of an image (that is, an exposure step), a step of removing the image-recording layer in a non-image area by supplying at least one material selected from the group consisting of a printing ink and dampening water on a printer such that a lithographic printing plate is prepared (that is, an on-press development step), and a step of performing printing by using the obtained lithographic printing plate (hereinafter, also called "printing step"). Described herein is a printing method using an on-press development type lithographic printing plate precursor in which discoloration caused by exposure to ozone is suppressed.

Hereinafter, each step will be specifically described.

<<Exposure step>>

In the exposure step, the on-press development type lithographic printing plate precursor is exposed in the shape

of an image. By the exposure of the on-press development type lithographic printing plate precursor in the shape of an image, an exposed portion and a non-exposed portion are formed. For example, in a case where a negative tone image-recording layer is used as an image-recording layer, an exposed portion of the negative tone image-recording layer forms an image area, and a non-exposed portion of the negative tone image-recording layer forms a non-image area. The on-press development type lithographic printing plate precursor used in the method of preparing a lithographic printing plate and the printing method is the same as the on-press development type lithographic printing plate precursor described above in the section of "On-press development type lithographic printing plate precursor".

The lithographic printing plate precursor is preferably exposed to a laser through a transparent original picture having a linear image or a halftone dot image or exposed in the shape of an image by laser light scanning according to digital data.

The wavelength of a light source to be used is preferably 750 nm to 1,400 nm. As the light source having a wavelength of 750 nm to 1,400 nm, a solid-state laser or a semiconductor laser that radiates infrared is suitable. In a case where an infrared laser is used, the output is preferably 100 mW or higher, the exposure time per pixel is preferably 20 microseconds or less, and the amount of irradiation energy is preferably 10 $mJ/cm^2$ to 300 $mJ/cm^2$. In addition, in order to shorten the exposure time, a multibeam laser device is preferably used. The exposure mechanism may be, for example, any one of an in-plane drum method, an external surface drum method, or a flat head method.

The exposure can be carried out by a common method using, for example, a platesetter. The exposure may be carried out on a printer after the lithographic printing plate precursor is mounted on the printer. The exposure may be performed before the lithographic printing plate precursor is mounted on the printer.

<<On-press development step>>

In the on-press development step, at least one material selected from the group consisting of a printing ink and dampening water is supplied on a printer to remove the image-recording layer in a non-image area.

The on-press development step is performed after the lithographic printing plate precursor is mounted on the printer. In a case where at least one material selected from the group consisting of a printing ink and dampening water is supplied on the printer, at the initial stage during printing, the image-recording layer of a non-image area (for example, a non-exposed portion) is removed by being dissolved or dispersed in the printing ink and/or the dampening water, and the hydrophilic surface is exposed. On the other hand, the image-recording layer of the remaining image area (for example, the exposed portion) forms a printing ink-receiving portion having lipophilic surface. The lithographic printing plate precursor having undergone on-press development is used as it is for printing a number of sheets.

In the on-press development step, the printing ink or the dampening water may be supplied first. In order to prevent the dampening water from being contaminated by the components of the removed image-recording layer, it is preferable to supply the printing ink first. As the printing ink, known printing inks can be used. Preferred examples of the printing ink include an oil-based ink or ultraviolet-curable ink (UV ink). As the dampening water, known dampening water can be used.

<<Printing step>>

In the printing step, printing is performed using the obtained lithographic printing plate. In the printing step, information may be printed on a recording medium by using the obtained lithographic printing plate. The printing step preferably includes a step of supplying a printing ink to the lithographic printing plate to print information on a recording medium. Examples of the printing ink used for printing include the printing ink described above in the section of "On-press development step". Examples of the recording medium include paper. Examples of the information include characters, numbers, reference numerals, drawings, and patterns. In the printing step, as necessary, dampening water may be supplied. The printing step may be continuously performed without stopping the printer.

<<Other steps>>

In the method of preparing a lithographic printing plate according to an embodiment of the present invention or in the lithographic printing method, as necessary, the entire surface of the lithographic printing plate precursor may be heated before the exposure step, in the middle of the exposure step, or during a period of time from the exposure step to the on-press development step. In a case where the lithographic printing plate precursor is heated as above, an image-forming reaction in the image-recording layer is accelerated, which can result in advantages such as improvement of sensitivity and printing durability and stabilization of sensitivity. Heating before the on-press development step is preferably carried out under a mild condition of 150°C or lower. In a case where heating is performed under the above conditions, for example, it is possible to prevent a problem of curing of the non-image area. For heating after the on-press development step, it is preferable to use an extremely severe condition which is preferably in a range of 100°C to 500°C, for example. In a case

where heating is performed in such a temperature range, a sufficient image-strengthening action is obtained, and it is possible to suppress problems such as the deterioration of the support or the thermal decomposition of the image area.

Examples

Hereinafter, the present invention will be specifically described with reference to examples. Unless otherwise specified, "part" and "%" are based on mass.

<Raw materials>

The raw materials used in examples and comparative examples will be shown below. In the following section, sometimes overlapping raw materials (for example, chemical structure and manufacturing method) will not be described.

<<Support (1)>>

An aluminum alloy plate made of a material 1S having a thickness of 0.3 mm was subjected to (A-a) Mechanical roughening treatment (brush grain method) to (A-i) Desmutting treatment in aqueous acidic solution described in paragraphs "0126" to "0134" of JP2012-158022A.

Then, an anodic oxide film was formed by performing (A-j) First-stage anodization treatment to (A-m) Third-stage anodization treatment described in paragraphs "0135" to "0138" of JP2012-158022A by appropriately adjusting the treatment conditions, thereby obtaining a support (1).

A rinsing treatment was performed between all the treatment steps. After the rinsing treatment, water was drained using a nip roller.

The details of the obtained support (1) are as below.

Value of the brightness L* of micropores within surface of anodic oxide film in L*a*b* color system: 83
Average diameter of large diameter portion of micropores within surface of oxide film: 35 nm (depth 100 nm)
Average diameter of small diameter portion of micropores at communicate position: 10 nm (depth 1,000 nm)
Ratio of depth of large diameter portion to average diameter of large diameter portion: 2.9

<<Support (2)>>

(a) Alkaline etching treatment

An aqueous solution of caustic soda having a caustic soda concentration of 26% by mass and an aluminum ion concentration of 6.5% by mass was sprayed onto the aluminum plate at a temperature of 70°C, thereby performing an etching treatment. Then, rinsing was performed by means of spraying. The amount of dissolved aluminum within the surface to be subjected to the electrochemical roughening treatment later was 5 $g/m^2$.

(b) Desmutting treatment using aqueous acidic solution (first desmutting treatment)

Next, a desmutting treatment was performed using an aqueous acidic solution. In the desmutting treatment, a 150 g/L aqueous sulfuric acid solution was used as the aqueous acidic solution. The liquid temperature was 30°C. The desmutting treatment was performed for 3 seconds by spraying the aqueous acidic solution onto the aluminum plate. Then, a rinsing treatment was performed.

(c) Electrochemical roughening treatment

Next, an electrochemical roughening treatment was performed using alternating current and an electrolytic solution having a hydrochloric acid concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride.

The waveform of the alternating current was a sine wave in which positive and negative waveforms are symmetrical, the frequency was 50 Hz, the ratio of the anodic reaction time and the cathodic reaction time in one cycle of the alternating current was 1: 1, and the current density was 75 $A/dm^2$ in terms of the peak current value of the alternating

current waveform. In addition, the quantity of electricity was 450 $C/dm^2$ which was the total quantity of electricity used for the aluminum plate to have an anodic reaction, and the electrolysis treatment was performed 4 times by conducting electricity of 112.5 $C/dm^2$ for 4 seconds at each treatment session. A carbon electrode was used as the counter electrode of the aluminum plate. Then, a rinsing treatment was performed.

(d) Alkaline etching treatment

An aqueous solution of caustic soda having a caustic soda concentration of 5% by mass and an aluminum ion concentration of 0.5% by mass was sprayed onto the aluminum plate having undergone the electrochemical roughening treatment at a temperature of 45°C, thereby performing an etching treatment. The amount of dissolved aluminum within the surface having undergone the electrochemical roughening treatment was 0.2 $g/m^2$. Then, a rinsing treatment was performed.

(e) Desmutting treatment using aqueous acidic solution

Next, a desmutting treatment was performed using an aqueous acidic solution. Specifically, the desmutting treatment was performed for 3 seconds by spraying the aqueous acidic solution onto the aluminum plate. In the desmutting treatment, an aqueous solution having a sulfuric acid concentration of 170 g/L and an aluminum ion concentration of 5 g/L was used as aqueous acidic solution. The liquid temperature was 30°C.

(f) First-stage anodization treatment

By using an anodization treatment device 610 for direct current electrolysis having the structure shown in Fig. 3, a first-stage anodization treatment (also called first anodization treatment) was performed. Specifically, the first anodization treatment was performed under the conditions described in the column of "First anodization treatment" shown in the following Table 1, thereby forming an anodic oxide film having a predetermined film amount.

Hereinafter, the anodization treatment device 610 shown in Fig. 3 will be described.

In the anodization treatment device 610 shown in Fig. 3, an aluminum plate 616 is transported as indicated by the arrow in Fig. 3. In a power supply tank 612 containing an electrolytic solution 618, the aluminum plate 616 is positively (+) charged by a power supply electrode 620. Then, the aluminum plate 616 is transported upwards by a roller 622 in the power supply tank 612, makes a turn downwards by a nip roller 624, then transported toward an electrolytic treatment tank 614 containing an electrolytic solution 626, and makes a turn by a roller 628 to move in the horizontal direction. Subsequently, the aluminum plate 616 is negatively (-) charged by an electrolysis electrode 630. As a result, an anodic oxide film is formed on the surface of the aluminum plate 616. The aluminum plate 616 exits from the electrolytic treatment tank 614 and is then transported for the next step. In the anodization treatment device 610, the roller 622, the nip roller 624, and the roller 628 constitute a direction change unit. Furthermore, in the inter-tank portion between the power supply tank 612 and the electrolytic treatment tank 614, the aluminum plate 616 is transported in a ridge shape and an inverted U shape by the roller 622, the nip roller 624, and the roller 628. The power supply electrode 620 and the electrolysis electrode 630 are connected to a direct current power source 634. A cell wall 632 is disposed between the power supply tank 612 and the electrolytic treatment tank 614.

(g) Pore widening treatment

Under the conditions shown in the following Table 1, the aluminum plate having undergone the above anodization treatment was immersed in an aqueous solution of caustic soda at a temperature of 40°C and having a caustic soda concentration of 5% by mass and an aluminum ion concentration of 0.5% by mass, thereby performing a pore widening treatment. Then, rinsing was performed by means of spraying.

(h) Second anodization treatment

By using the anodization treatment device 610 for direct current electrolysis having the structure shown in Fig. 3, a second-stage anodization treatment (also called second anodization treatment) was performed. Specifically, the second anodization treatment was performed under the conditions described in the column of "Second anodization treatment" shown in the following Table 1, thereby forming an anodic oxide film having a predetermined film amount.

By the above method, a support (2) was prepared.

For the obtained support (2), Table 2 shows the brightness L* of the micropores within the surface of the anodic oxide film in the L* a*b * color system, the average diameter and depth of the large diameter portion of the micropores within the surface of the oxide film, the average diameter (nm) and depth of the small diameter portion of the micropores at a

communicate position, the depth (nm) of the large diameter portion and the small diameter portion, the micropore density, and the thicknesses of the anodic oxide film (also called film thicknesses) from the bottom portion of the small diameter portion to the surface of the aluminum plate.

In Table 1, Film amount (AD) in the column of "First anodization treatment" and Film amount (AD) in the column of "Second anodization treatment" represent the amount of film obtained by each treatment. As electrolytic solutions, the aqueous solutions containing the components in Table 1 were used.

[Table 1]

| Support (2) | First anodization treatment | | | | | | |
|---|---|---|---|---|---|---|---|
| | Liquid type | Liquid component | Liquid concentration (g/L) | Temperature (°C) | Current density (Å/$dm^2$) | Time (s) | Film amount (g/$m^2$) |
| | Phosphoric acid | $H_3PO_4$ | 15 | 35 | 4.5 | 12 | 1 |
| | Pore widening treatment | | | | | | |
| | Liquid component | | Temperature (°C) | Time (s) | | | |
| | NaOH5%/Al0.5% | | 40°C | 3s | | | |
| | Second anodization treatment | | | | | | |
| | Liquid type | Liquid component | Liquid concentration (g/L) | Temperature (°C) | Current density (Å/$dm^2$) | Time (s) | Film amount (g/$m^2$) |
| | Sulfuric acid | $H_2SO_4$/Al | 170/5 | 50 | 15 | 10.5 | 1.4 |

[Table 2]

| Support (2) | Large diameter portion | | | | Small diameter portion | | | Micropore density (number/$\mu m^2$) | Film thickness (nm) | Brightness L* |
|---|---|---|---|---|---|---|---|---|---|---|
| | Average diameter (nm) | Average diameter of bottom portion (nm) | Shape | Depth (nm) | Average diameter at communicate position (nm) | Shape | Depth (nm) | | | |
| | 35 | 35 | Straight tubular | 100 | 10 | | 570 | 320 | 1,000 | 80 |

<<Support (3)>>

A Hydro 1052 aluminum alloy web (available from Norsk Hydro ASA, Norway) having a thickness of 0.28 mm was used as an aluminum plate, and the surface was treated in the following sequence, and the liquid concentration of electrochemical roughening treatment and the alkaline etching amount after the electrochemical roughening treatment were changed, thereby preparing a support (3).

-Alkaline etching treatment-

An aqueous solution of caustic soda having a caustic soda concentration of 26% by mass and an aluminum ion concentration of 6.5% by mass was sprayed onto the aluminum plate at a temperature of 70°C, thereby performing an etching treatment. Then, rinsing was performed by means of spraying. The amount of dissolved aluminum within the surface to be subjected to the electrochemical roughening treatment later was 5 g/$m^2$.

-Desmutting treatment using aqueous acidic solution-

Next, a desmutting treatment was performed using an aqueous acidic solution. In the desmutting treatment, a 150 g/L aqueous sulfuric acid solution was used as the aqueous acidic solution. The liquid temperature was 30°C. The desmutting treatment was performed for 3 seconds by spraying the aqueous acidic solution onto the aluminum plate. Then, a rinsing treatment was performed.

-Electrochemical roughening treatment-

Next, an electrochemical roughening treatment was performed using alternating current and an electrolytic solution having a hydrochloric acid concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride.

The waveform of the alternating current was a sine wave in which positive and negative waveforms are symmetrical, the frequency was 50 Hz, the ratio of the anodic reaction time and the cathodic reaction time in one cycle of the alternating current was 1:1, and the current density was 75 A/$dm^2$ in terms of the peak current value of the alternating current waveform. In addition, the quantity of electricity was 450 C/$dm^2$ which was the total quantity of electricity used for the aluminum plate to have an anodic reaction, and the electrolysis treatment was performed 4 times by conducting electricity of 112.5 C/$dm^2$ for 4 seconds at each treatment session. A carbon electrode was used as the counter electrode of the aluminum plate. Then, a rinsing treatment was performed.

-Alkaline etching treatment-

An aqueous solution of caustic soda having a caustic soda concentration of 5% by mass and an aluminum ion concentration of 0.5% by mass was sprayed onto the aluminum plate having undergone the electrochemical roughening treatment at a temperature of 45°C, thereby performing an etching treatment. Then, a rinsing treatment was performed.

-Desmutting treatment using aqueous acidic solution-

Next, a desmutting treatment was performed using an aqueous acidic solution. Specifically, the desmutting treatment was performed for 3 seconds by spraying the aqueous acidic solution onto the aluminum plate. In the desmutting treatment, an aqueous solution having a sulfuric acid concentration of 170 g/L and an aluminum ion concentration of 5 g/L was used as aqueous acidic solution. The liquid temperature was 35°C.

-Anodization treatment-

Then, the aluminum plate was anodized twice. Each of the anodization treatment baths contained about 100 L of an anodization solution. During the first anodization, each sheet was treated for 21.3 seconds under the conditions of an electrolyte concentration of 175 g/L, a temperature of 60°C, and a current density of 5.8 A/$dm^2$. During the second anodization, each sheet was treated for 18 seconds under the conditions of an electrolyte concentration of 280 g/L, a temperature of 23°C, and a current density of 10 A/$dm^2$. The first anodization process for forming an outer aluminum oxide layer was performed using phosphoric acid as an electrolyte, and the second anodization process for forming an inner aluminum oxide layer was performed using sulfuric acid as an electrolyte.

<<Support (4)>>

In order to remove the rolling oil on the surface of an aluminum plate (material: JIS A 1050) having a thickness of 0.3 mm, the aluminum plate was subjected to a degreasing treatment at 50°C for 30 seconds by using a 10% by mass aqueous sodium aluminate solution. Then, by using three bundled nylon brushes having a bristle diameter of 0.3 mm and a water suspension of pumice having a median diameter of 25 μm (specific gravity: 1.1 g/cm$^3$), graining was performed on the surface of the aluminum, and then the aluminum plate was thoroughly rinsed with water. The plate was etched by being immersed in a 25% by mass aqueous sodium hydroxide solution at 45°C for 9 seconds, rinsed with water, then further immersed in a 20% by mass aqueous nitric acid solution at 60°C for 20 seconds, and rinsed with water. At this time, the amount of the grained surface etched was about 3 g/m$^2$.

Then, an electrochemical roughening treatment was continuously performed using an alternating current voltage of 60 Hz. At this time, a 1% by mass aqueous nitric acid solution was used as an electrolytic solution (containing 0.5% by mass of aluminum ions), and the liquid temperature was 50°C. By using a light source of alternating current having a trapezoidal rectangular waveform and a carbon electrode as a counter electrode, an electrochemical roughening treatment was performed under the conditions of a time TP taken for the current value to reach the peak from zero of 0.8 msec and the duty ratio of 1:1. As an auxiliary anode, ferrite was used. The current density was 30 A/dm$^2$ in terms of the peak value of current, and 5% of the current coming from the power source was allowed to flow into the auxiliary anode. The quantity of electricity during the nitric acid electrolysis was 175 C/dm$^2$, which was the quantity of electricity used when the aluminum plate was an anode. Then, rinsing was performed by means of spraying.

Subsequently, by using a 0.5% by mass aqueous solution of hydrochloric acid (containing 0.5% by mass of aluminum ions) at a liquid temperature of 50°C as an electrolytic solution, an electrochemical roughening treatment was performed by the same method as the nitric acid electrolysis under the condition of a quantity of electricity of 50 C/dm$^2$ that was used when the aluminum plate was an anode. Then, the aluminum plate was rinsed with water by spraying.

Thereafter, by using a 15% by mass sulfuric acid (containing 0.5% by mass of aluminum ions) as an electrolytic solution, a 2.5 g/m$^2$ direct current anodic oxide film was provided on the plate at a current density of 15 A/dm$^2$, followed by rinsing with water and drying.

Subsequently, in order to ensure the hydrophilicity of the non-image area, the aluminum plate was treated with silicate at 60°C for 10 seconds by using a 2.5% by mass aqueous solution of No. 3 sodium silicate and then rinsed with water, thereby obtaining a support (4). The amount of Si adhered was 10 mg/m$^2$. The centerline average roughness (Ra) of the support (4) measured using a needle having a diameter of 2 μm was 0.51 μm.

<<Coating liquid (1) for undercoat layer>>

·Compound for undercoat layer (P-1, 11% by mass aqueous solution): 0.10502 parts
·Sodium gluconate: 0.07000 parts
·Surfactant (EMALEX 710, manufactured by NIHON EMULSION Co., Ltd.): 0.00159 parts
·Preservative (BIOHOPE L, manufactured by K·I Chemical Industry Co., LTD.): 0.00149 parts
·Water: 2.87190 parts

(P-1)

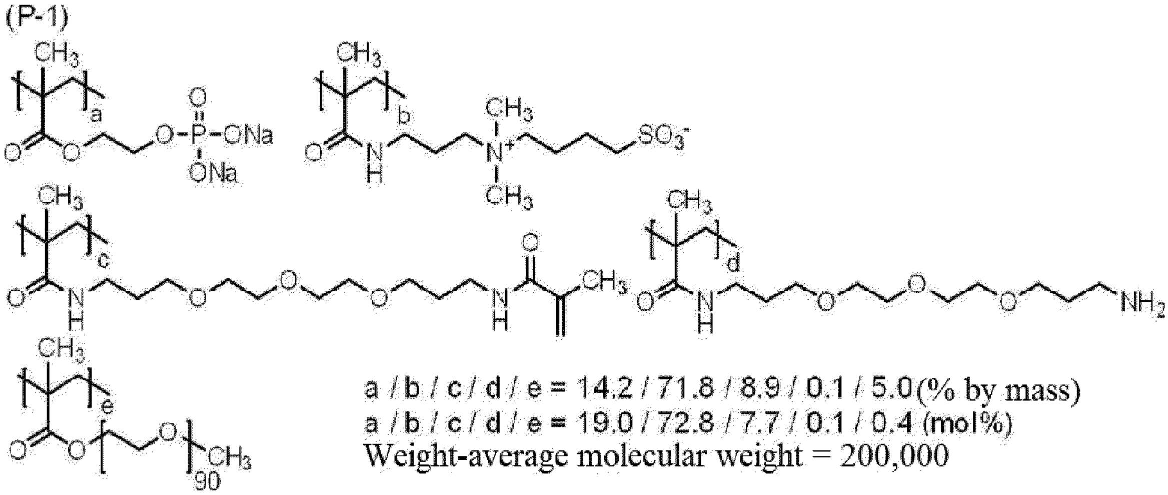

a / b / c / d / e = 14.2 / 71.8 / 8.9 / 0.1 / 5.0 (% by mass)
a / b / c / d / e = 19.0 / 72.8 / 7.7 / 0.1 / 0.4 (mol%)
Weight-average molecular weight = 200,000

<<Coating liquid (2) for undercoat layer>>

·Compound for undercoat layer (P-1, 11% by mass aqueous solution): 0.10502 parts
·Hydroxyethyl diiminodiacetic acid: 0.01470 parts
·Sodium ethylenediaminetetraacetate: 0.06575 parts
·Surfactant (EMALEX 710, manufactured by NIHON EMULSION Co., Ltd.): 0.00159 parts
·Preservative (BIOHOPE L, manufactured by K·I Chemical Industry Co., LTD.): 0.00149 parts
·Water: 2.86144 parts

<<Coating liquid (3) for undercoat layer>>

The coating liquid (1) for an undercoat layer described in paragraph "0136" of JP2012-66577A was used as a coating liquid (3) for an undercoat layer.

<<Coating liquid (4) for undercoat layer>>

·Compound for undercoat layer (P-1, 11% by mass aqueous solution): 0.0788 parts
·Hydroxyethyl diiminodiacetic acid: 0.0280 parts
·Sodium ethylenediaminetetraacetate tetrahydrate: 0.0499 parts
·Surfactant (EMALEX 710, manufactured by NIHON EMULSION Co., Ltd.): 0.0016 parts
·Preservative (BIOHOPE L, manufactured by K·I Chemical Industry Co., LTD.): 0.0015 parts
·Water: 2.8701 parts

<<Coating liquid (5) for undercoat layer>>

·Compound for undercoat layer (P-1, 11% by mass aqueous solution): 0.0788 parts
·Sodium gluconate: 0.0700 parts
·Surfactant (EMALEX 710, manufactured by NIHON EMULSION Co., Ltd.): 0.0016 parts
·Preservative (BIOHOPE L, manufactured by K·I Chemical Industry Co., LTD.): 0.0015 parts
·Water: 2.8780 parts

<<Coating liquid (1) for image-recording layer>>

·Infrared absorber (IR-1): 0.02000 parts
·Color developing agent (S-1): 0.02500 parts
·Electron-accepting polymerization initiator (Int-1): 0.11000 parts
·Electron-donating polymerization initiator (TPB): 0.02500 parts
·Polymerizable compound (M-1): 0.27500 parts
·Anionic surfactant (A-1): 0.00600 parts
·Fluorine-based surfactant (W-1): 0.00416 parts
·2-Butanone: 4.3602 parts
·1-Methoxy-2-propanol: 4.4852 parts
·Methanol: 2.2838 parts
·Microgel liquid 1: 2.3256 parts

IR-1

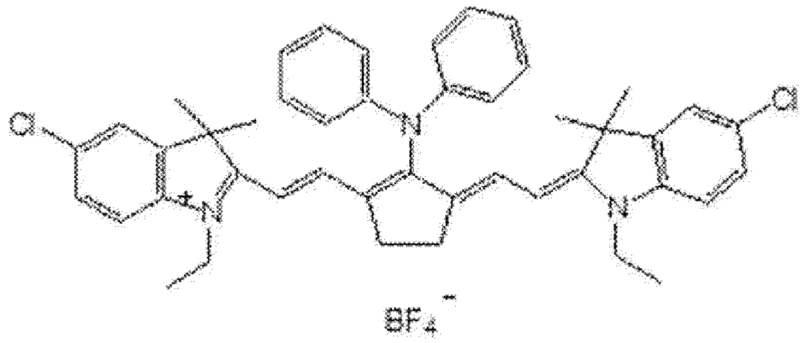

The energy level of HOMO of the infrared absorber (IR-1) is -5.35 eV. The energy level of LUMO of the infrared absorber (IR-1) is -3.75 eV.

S-1

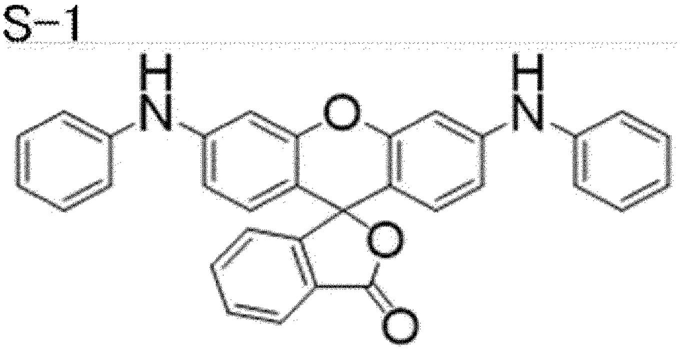

Int-1

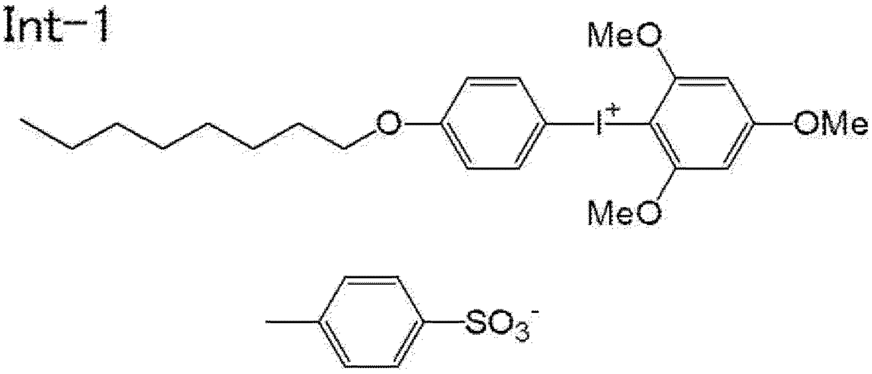

The energy level of HOMO of the electron-accepting polymerization initiator (Int-1) is -6.70 eV. The energy level of LUMO of the electron-accepting polymerization initiator (Int-1) is -3.08 eV. "Me" in the chemical formula of the electron-accepting polymerization initiator (Int-1) represents a methyl group.

TPB

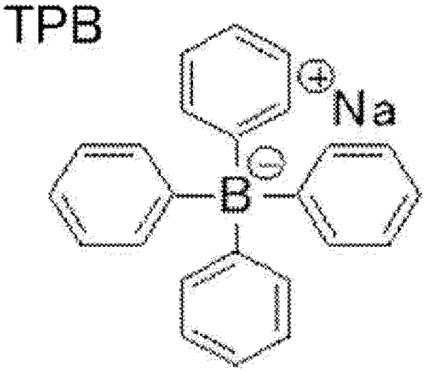

The energy level of HOMO of the electron-donating polymerization initiator (TPB) is -5.90 eV.

A-1

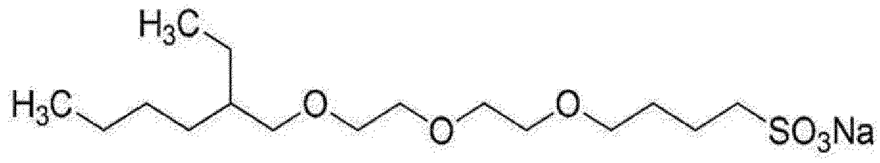

W-1

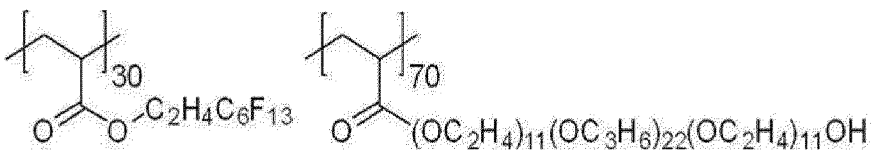

W - 1
Mw = 13,000

[Synthesis method of polymerizable compound M-1]

A mixed solution of TAKENATE D-160N (polyisocyanate trimethylolpropane adduct, manufactured by Mitsui Chemicals, Inc., 4.7 parts), ARONIX M-403 (manufactured by TOAGOSEI CO., LTD., amount yielding the ratio of NCO value of TAKENATE D-160N:hydroxyl number of ARONIX M-403 = 1:1), t-butylbenzoquinone (0.02 parts), and methyl ethyl ketone (11.5 parts) was heated at 65°C. NEOSTANN U-600 (bismuth-based polycondensation catalyst, manufactured by NITTO KASEI CO., LTD., 0.11 parts) was added to the reaction solution, and the reaction solution was heated at 65°C for 4 hours. The reaction solution was cooled to room temperature (25°C), and methyl ethyl ketone was added thereto, thereby synthesizing a urethane acrylate solution having a solid content of 50% by mass. By using recycling GPC (instrument: LC908-C60, column: JAIGEL-1H-40 and 2H-40 (manufactured by Japan Analytical Industry Co., Ltd.)) and tetrahydrofuran (THF) as an eluent, molecular weight fractionation of the urethane acrylate solution was performed. The weight-average molecular weight was 20,000.

[Synthesis method of microgel liquid 1]

A microgel liquid 1 was synthesized by the following procedure.

(Preparation of polyvalent isocyanate compound)

Bismuth tris(2-ethylhexanoate) (NEOSTAN U-600, manufactured by NITTO KASEI CO., LTD., 0.043 parts) was added to a suspension solution containing isophorone diisocyanate (17.78 parts, 80 molar equivalents) and the following polyhydric phenol compound (1) (7.35 parts, 20 molar equivalents) in ethyl acetate (25.31 parts), and the obtained solution was stirred. The reaction temperature was set to 50°C at a point in time when heat release subsided, and the solution was stirred for 3 hours, thereby obtaining an ethyl acetate solution of the polyvalent isocyanate compound (1) (50% by mass).

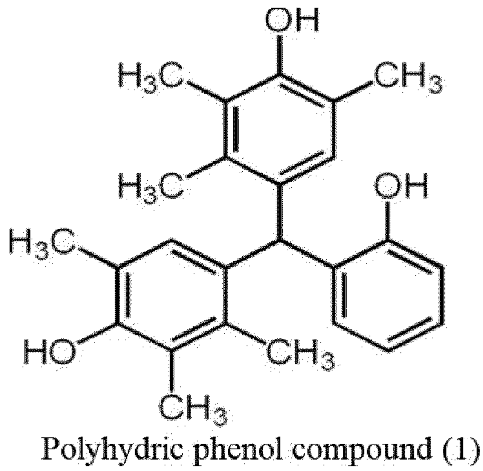

Polyhydric phenol compound (1)

(Preparation of microgel)

The following oil-phase components and water-phase components were mixed together and emulsified at 12,000 rpm for 10 minutes by using a homogenizer. The obtained emulsion was stirred at 45°C for 4 hours, a 10% by mass aqueous solution of 5.20 g of 1,8-diazabicyclo[5.4.0]undec-7-ene-octylate (U-CAT SA102, manufactured by San-Apro Ltd.) was added thereto, and the solution was stirred at room temperature for 30 minutes and left to stand at 45°C for 24 hours. By using distilled water, the concentration of solid contents was adjusted to 20% by mass, thereby obtaining an aqueous dispersion of a microgel (1). The average particle diameter thereof measured by a light scattering method was 0.28 μm.

-Oil-phase component-

·(Component 1) ethyl acetate: 12.0 parts
·(Component 2) an adduct obtained by adding trimethylolpropane (6 molar equivalents) and xylene diisocyanate (18 molar equivalents) and then adding polyoxyethylene having one methylated terminal (1 molar equivalent, the number of repeating oxyethylene units: 90) (50% by mass ethyl acetate solution, manufactured by Mitsui Chemicals, Inc.): 3.76 parts
·(Component 3) polyvalent isocyanate compound (1) (as 50% by mass ethyl acetate solution): 15.0 parts
·(Component 4) 65% by mass ethyl acetate solution of dipentaerythritol pentaacrylate (SR-399, manufactured by Sartomer Company Inc.): 11.54 parts
·(Component 5) 10% by mass ethyl acetate solution of sulfonate type surfactant (PIONIN A-41-C, manufactured by TAKEMOTO OIL & FAT Co., Ltd.): 4.42 parts

-Water-phase component-

·Distilled water: 46.87 parts

<<Coating liquid (2) for image-recording layer>>

·Infrared absorber (IR-1): 0.00600 parts
·Infrared absorber (IR-2): 0.0200 parts
·Color developing agent (S-1): 0.02500 parts
·Electron-accepting polymerization initiator (Int-1): 0.11000 parts
·Electron-donating polymerization initiator (TPB): 0.02500 parts
·Polymerizable compound (M-1): 0.27500 parts

- ·Anionic surfactant (A-1): 0.09000 parts
- ·Fluorine-based surfactant (W-1): 0.00416 parts
- ·2-Butanone: 4.9200 parts
- ·1-Methoxy-2-propanol: 3.1000 parts
- ·Methanol: 2.7900 parts
- ·Microgel liquid 2: 2.90700 parts

IR-2

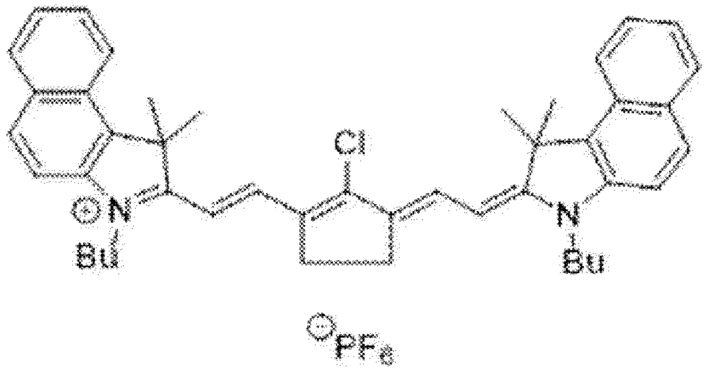

The energy level of HOMO of the infrared absorber (IR-2) is -5.31 eV. The energy level of LUMO of the infrared absorber (IR-2) is -3.78 eV. "Bu" in the chemical formula of the infrared absorber (IR-2) represents a butyl group.

[Synthesis method of microgel liquid 2]

-Preparation of oil-phase component-

A polyfunctional isocyanate compound (PM-200: manufactured by Wanhua Chemical Group Co., Ltd.: 6.66 g, a 50% by mass ethyl acetate solution of "TAKENATE (registered trademark) D-116N (adduct of trimethylolpropane (TMP), m-xylylene diisocyanate (XDI), and polyethylene glycol monomethyl ether (EO90) (following structure)" manufactured by Mitsui Chemicals, Inc.: 5.46 g, a 65% by mass ethyl acetate solution of dipentaerythritol pentaacrylate (SR-399, manufactured by Sartomer Company Inc.): 11.24 g, ethyl acetate: 14.47 g, and PIONIN (registered trademark) A-41-C manufactured by TAKEMOTO OIL & FAT Co., Ltd.: 0.45 g were mixed together and stirred at room temperature (25°C) for 15 minutes, thereby obtaining an oil-phase component.

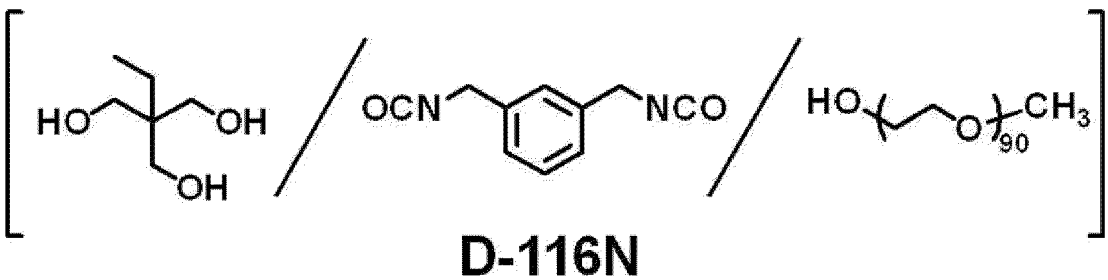

D-116N

-Preparation of water-phase component-

As a water-phase component, 47.2 g of distilled water was prepared.

-Microcapsule forming step-

The oil-phase component and the water-phase component were mixed together, and the obtained mixture was emulsified at 12,000 rpm for 16 minutes by using a homogenizer, thereby obtaining an emulsion.

Distilled water (16.8 g) was added to the obtained emulsion, and the obtained liquid was stirred at room temperature for 10 minutes.

After stirring, the liquid was heated at 45°C, and stirred for 4 hours in a state of being kept at 45°C such that ethyl acetate was distilled away from the liquid. Then, a 10% by mass aqueous solution of 5.12 g of 1,8-diazabicyclo[5.4.0] undec-7-ene-octylate (U-CAT SA102, manufactured by San-Apro Ltd.) was added thereto, and the solution was stirred at room temperature for 30 minutes and left to stand at 45°C for 24 hours. Distilled water was added thereto such that the concentration of solid contents was adjusted to 20% by mass, thereby obtaining an aqueous dispersion of a microgel. The microgel had a volume average particle diameter of 165 nm that was measured using a laser diffraction/scattering-type particle diameter distribution analyzer LA-920 (manufactured by HORIBA, Ltd.).

The obtained aqueous dispersion of the microgel was designated as a microgel liquid 2.

<<Coating liquid (3) for image-recording layer>>

·Infrared absorber (IR-3): 0.026 parts
·Electron-accepting polymerization initiator (Int-2): 0.060 parts
·Electron-donating polymerization initiator (TPB): 0.050 parts
·Polymerizable compound (M-2): 0.250 parts
·Polymerizable compound (M-3): 0.250 parts
·Binder (S-LEC BX-5Z, manufactured by SEKISUI CHEMICAL CO., LTD.): 0.150 parts
·1-Methoxy-2-propanol: 4.988 parts
·2-Butanone: 9.262 parts

IR-3

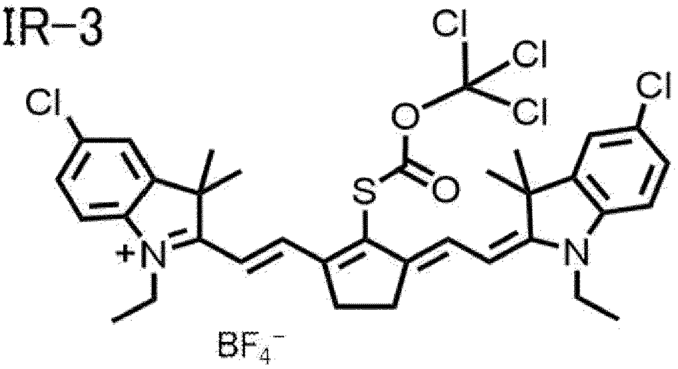

The energy level of HOMO of the infrared absorber (IR-3) is -5.43 eV. The energy level of LUMO of the infrared absorber (IR-3) is -3.95 eV.

Int-2

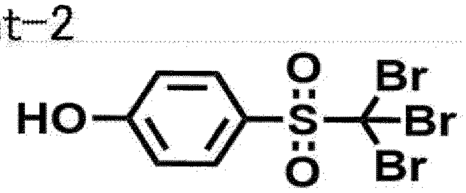

The energy level of HOMO of the electron-accepting polymerization initiator (Int-2) is -6.96 eV. The energy level of LUMO of the electron-accepting polymerization initiator (Int-2) is -3.18 eV.

M-2

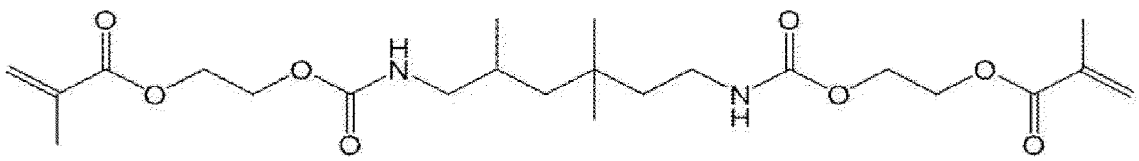

M-3

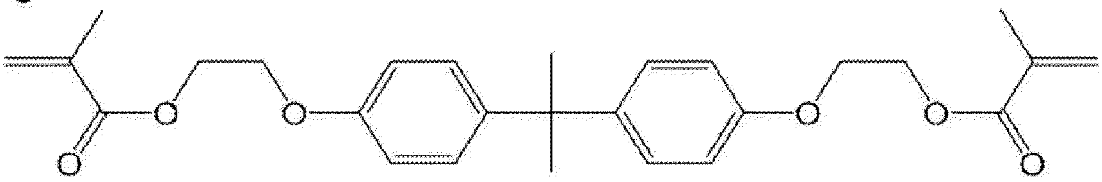

EMALEX BX-5Z

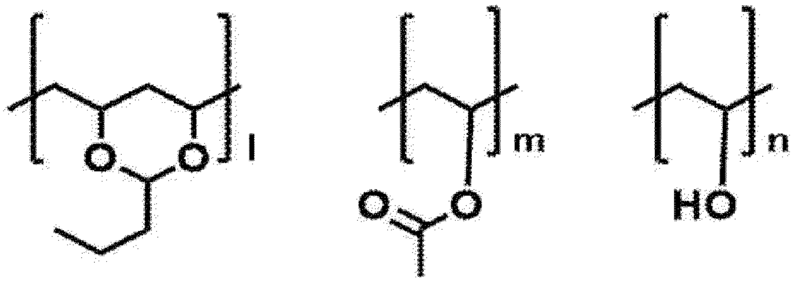

<<Coating liquid (4) for image-recording layer>>

- ·Infrared absorber (IR-4): 0.027 parts
- ·Infrared absorber (IR-5): 0.015 parts
- ·Electron-accepting polymerization initiator (Int-3): 0.041 parts
- ·Polymerizable compound (M-4): 0.100 parts
- ·Polymerizable compound (M-5): 0.096 parts
- ·Polymerizable compound (M-6): 0.096 parts
- ·Polymer particles 1: 0.300 parts
- ·Color developing agent (S-2): 0.041 parts
- ·Hydroxypropyl cellulose: 0.030 parts
- ·n-Propanol: 5.168 parts
- ·2-Butanone: 6.460 parts
- ·1-Methoxy-2-propanol: 1.615 parts
- ·Methanol: 2.907 parts

IR-4

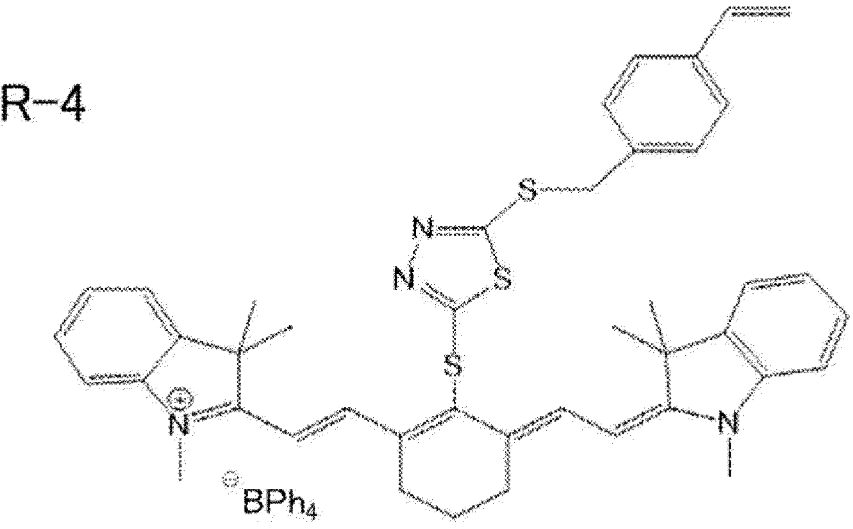

The energy level of HOMO of the infrared absorber (IR-4) is -5.42 eV. The energy level of LUMO of the infrared absorber (IR-4) is -3.82 eV. "Ph" in the chemical formula of the infrared absorber (IR-4) represents a phenyl group.

IR-5

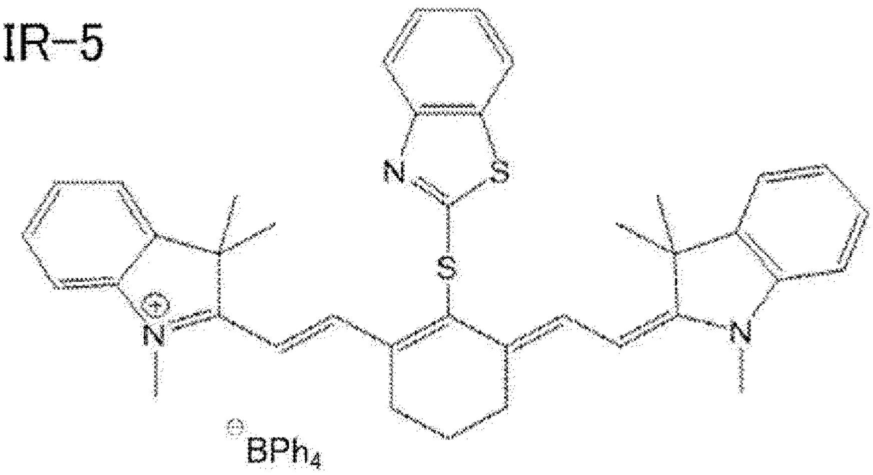

The energy level of HOMO of the infrared absorber (IR-5) is -5.43 eV. The energy level of LUMO of the infrared absorber (IR-5) is -3.84 eV. "Ph" in the chemical formula of the infrared absorber (IR-5) represents a phenyl group.

Int-3

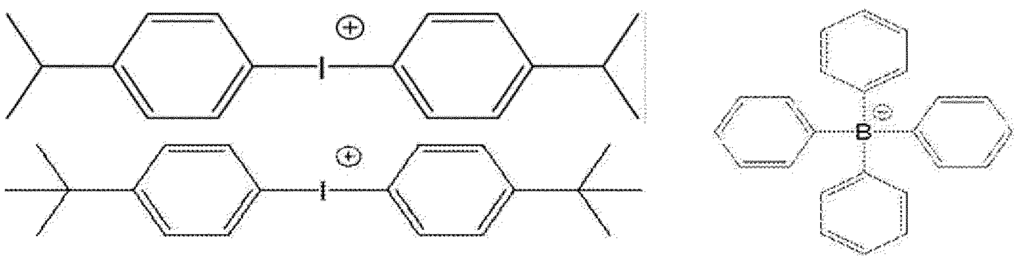

The energy level of HOMO of the electron-accepting polymerization initiator (Int-3) is -7.34 eV. The energy level of LUMO of the electron-accepting polymerization initiator (Int-3) is -3.26 eV.

M-4

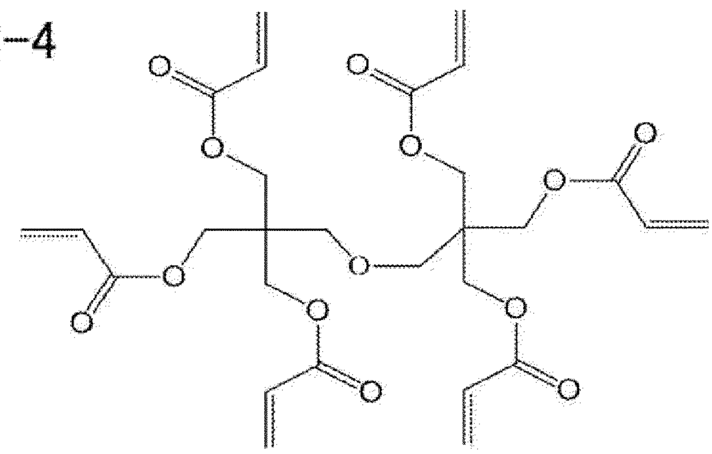

M-5

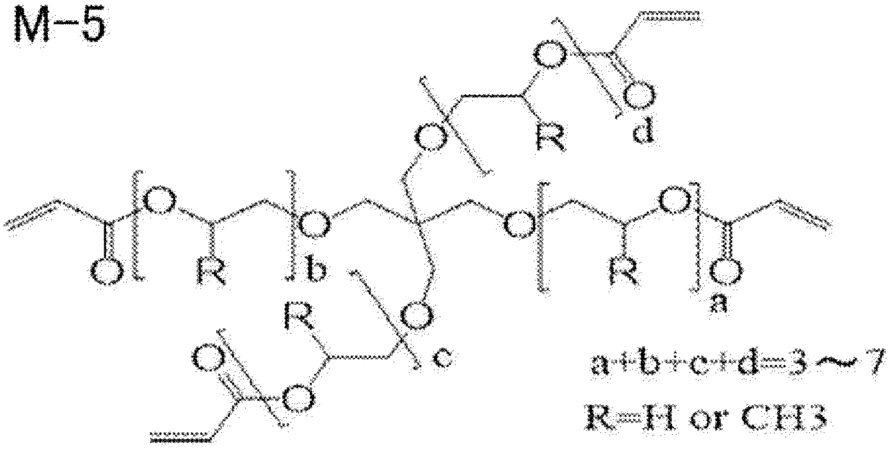

M-6

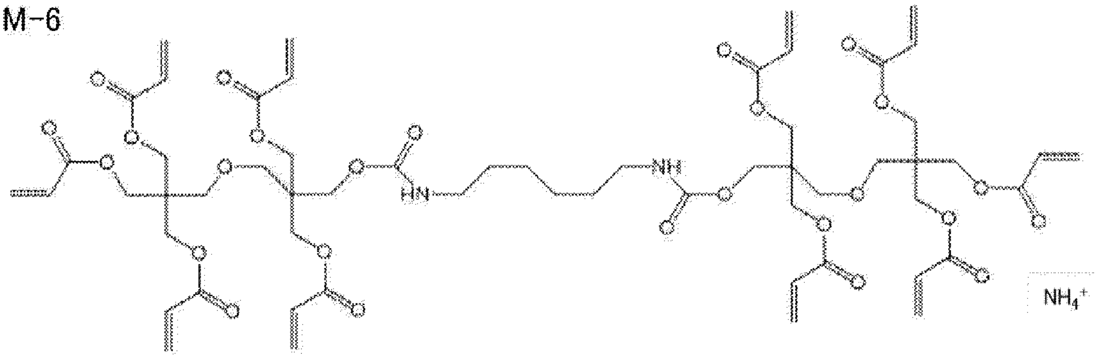

Polymer particles 1

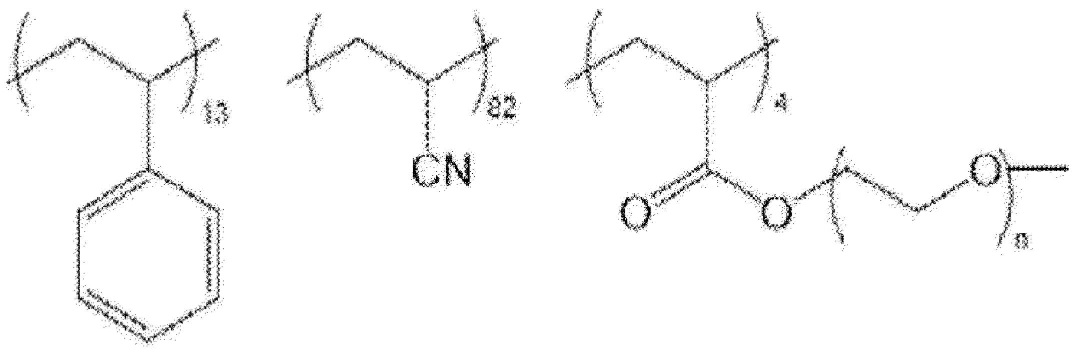

In the chemical structural formula of the polymer particles 1, n is 40. The weight-average molecular weight of the polymer particles 1 is 90,000.

S-2

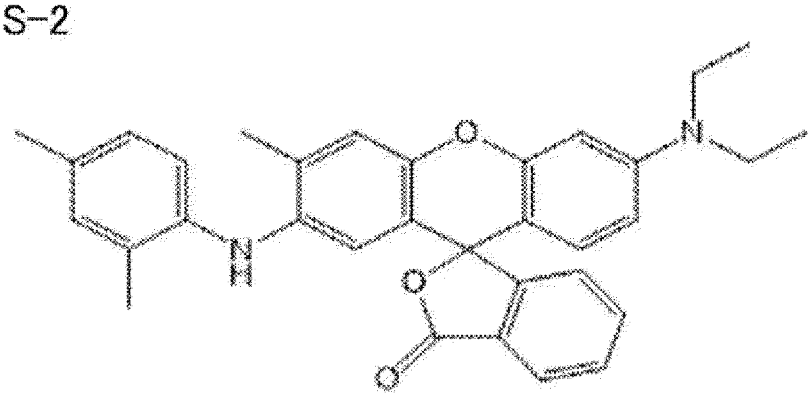

<<Coating liquid (5) for image-recording layer>>

The photosensitive liquid (1) described in paragraph "0139" of JP2012-66577A was used as a coating liquid (5) for an image-recording layer.

<<Coating liquid (6) for image-recording layer>>

- ·Infrared absorber (IR-1): 0.0175 parts
- ·Infrared absorber (IR-2): 0.0013 parts
- ·Color developing agent (S-1): 0.02500 parts
- ·Electron-accepting polymerization initiator (Int-1): 0.11000 parts
- ·Electron-donating polymerization initiator (TPB): 0.02500 parts
- ·Coloring compound (Z-1): 0.0010 parts
- ·Polymerizable compound (M-7): 0.27500 parts
- ·Anionic surfactant (A-1): 0.00600 parts
- ·Fluorine-based surfactant (W-1): 0.00416 parts
- ·2-Butanone: 4.3602 parts
- ·1-Methoxy-2-propanol: 4.4852 parts
- ·Methanol: 2.2838 parts
- ·Microgel liquid 1: 2.3256 parts

The coloring compound (Z-1) has the following chemical structure.

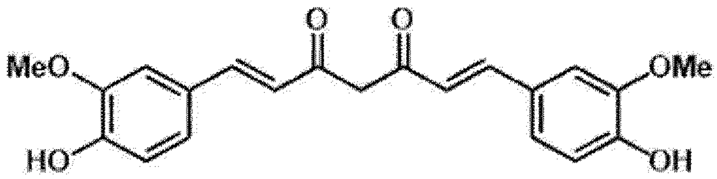

The polymerizable compound (M-7) is a urethane (meth) acrylate oligomer (U-15HA (number of functional groups: 15), SHIN-NAKAMURA CHEMICAL Co., LTD.) shown below. "Me" in the chemical formula of the polymerizable compound (M-7) represents a methyl group.

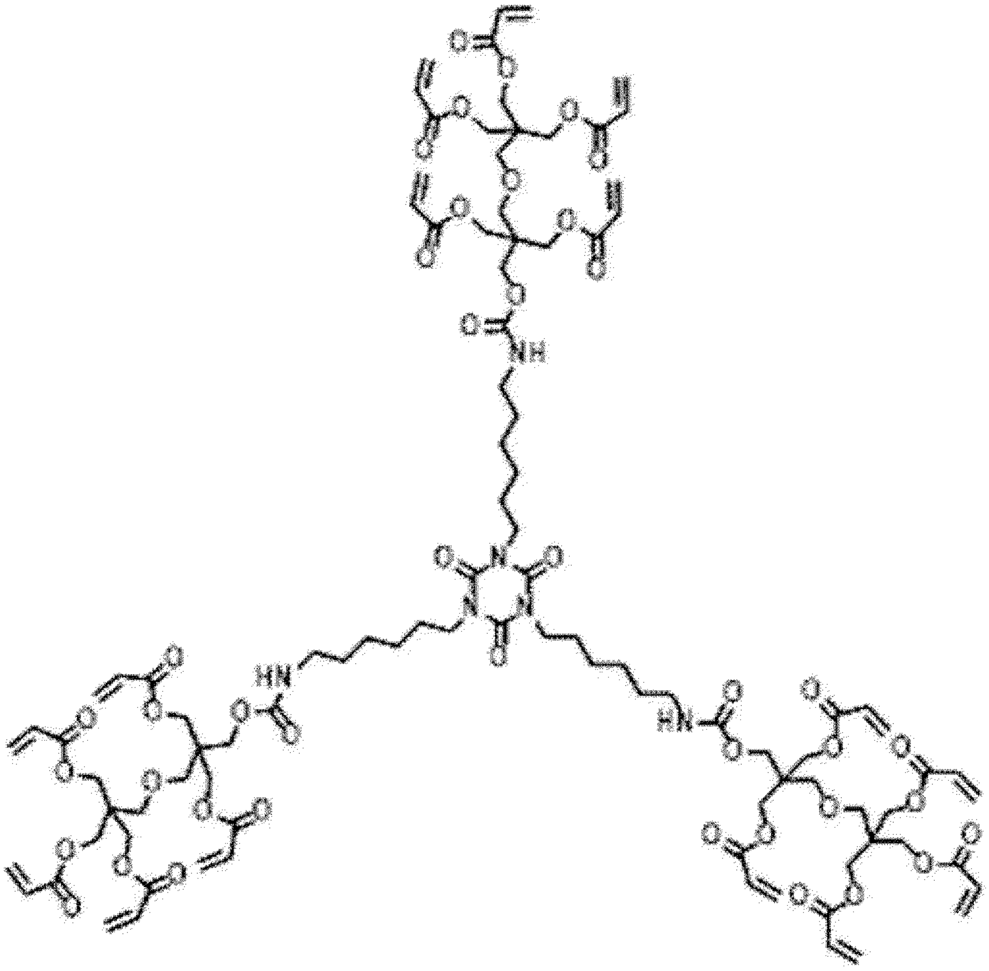

<<Coating liquid (7) for image-recording layer>>

- ·Infrared absorber (IR-1): 0.0125 parts
- ·Infrared absorber (IR-6): 0.005 parts
- ·Color developing agent (S-1): 0.02500 parts
- ·Electron-accepting polymerization initiator (Int-1): 0.11000 parts
- ·Electron-donating polymerization initiator (TPB): 0.02500 parts
- ·Coloring compound (Z-1): 0.0020 parts
- ·Polymerizable compound (M-7): 0.27500 parts
- ·Anionic surfactant (A-1): 0.00600 parts
- ·Fluorine-based surfactant (W-1): 0.00416 parts
- ·2-Butanone: 4.3602 parts
- ·1-Methoxy-2-propanol: 4.4852 parts
- ·Methanol: 2.2838 parts
- ·Microgel liquid 1: 2.3256 parts

The chemical structure of the infrared absorber (IR-6) will be shown below.

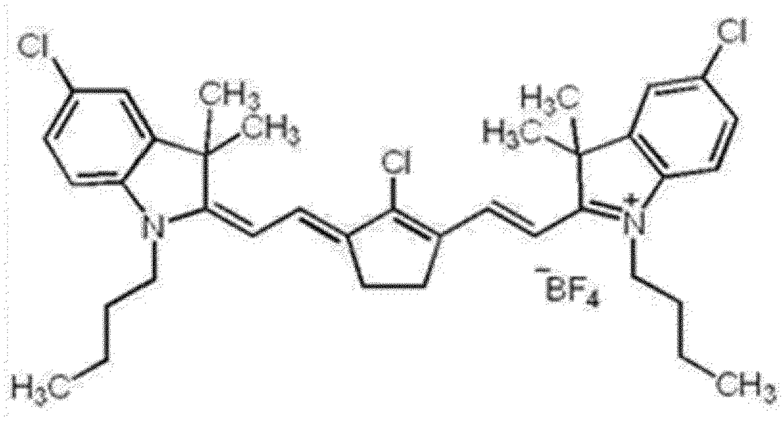

<<Coating liquid (8) for image-recording layer>>

·Infrared absorber (IR-1): 0.0175 parts
·Infrared absorber (IR-2): 0.0013 parts
·Color developing agent (S-1): 0.02500 parts
·Electron-accepting polymerization initiator (Int-1): 0.11000 parts
·Electron-donating polymerization initiator (TPB): 0.02500 parts
·Polymerizable compound (M-7): 0.27500 parts
·Anionic surfactant (A-1): 0.00600 parts
·Fluorine-based surfactant (W-1): 0.00416 parts
·2-Butanone: 4.3602 parts
·1-Methoxy-2-propanol: 4.4852 parts
·Methanol: 2.2838 parts
·Microgel liquid 1: 2.3256 parts

<<Coating liquid (9) for image-recording layer>>

·Infrared absorber (IR-1): 0.0175 parts
·Infrared absorber (IR-7): 0.0013 parts
·Color developing agent (S-1): 0.02500 parts
·Electron-accepting polymerization initiator (Int-1): 0.11000 parts
·Electron-donating polymerization initiator (TPB): 0.02500 parts
·Polymerizable compound (M-2): 0.27500 parts
·Anionic surfactant (A-1): 0.00600 parts
·Fluorine-based surfactant (W-1): 0.00416 parts
·2-Butanone: 4.3602 parts
·1-Methoxy-2-propanol: 4.4852 parts
·Methanol: 2.2838 parts
·Microgel liquid 1: 2.3256 parts

<<Coating liquid (10) for image-recording layer>>

·Infrared absorber (IR-1): 0.0175 parts
·Infrared absorber (IR-2): 0.0013 parts
·Color developing agent (S-1): 0.02500 parts
·Electron-accepting polymerization initiator (Int-1): 0.11000 parts
·Electron-donating polymerization initiator (TPB): 0.02500 parts

·Coloring compound (Z-1): 0.0020 parts
·Polymerizable compound (M-7): 0.27500 parts
·Tricresyl phosphate (plasticizer): 0.01250 parts
·Anionic surfactant (A-1): 0.00600 parts
·Fluorine-based surfactant (W-1): 0.00416 parts
·2-Butanone: 4.3602 parts
·1-Methoxy-2-propanol: 4.4852 parts
·Methanol: 2.2838 parts
·Microgel liquid 1: 2.3256 parts

<<Coating liquid (11) for image-recording layer>>

·Infrared absorber (IR-1): 0.0203 parts
·Infrared absorber (IR-2): 0.0068 parts
·Color developing agent (S-3): 0.0120 parts
·Color developing agent (S-4): 0.0300 parts
·Electron-accepting polymerization initiator (Int-1): 0.0981 parts
·Electron-donating polymerization initiator (TPB): 0.0270 parts
·Polymerizable compound (M-1): 0.3536 parts
·Tricresyl phosphate: 0.0450 parts
·Anionic surfactant (A-1): 0.0162 parts
·Fluorine-based surfactant (W-1): 0.0042 parts
·2-Butanone: 5.3155 parts
·1-Methoxy-2-propanol: 2.8825 parts
·Methanol: 2.3391 parts
·Microgel liquid 2: 2.8779 parts

S-3

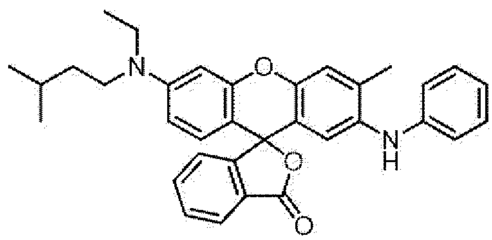

S-4

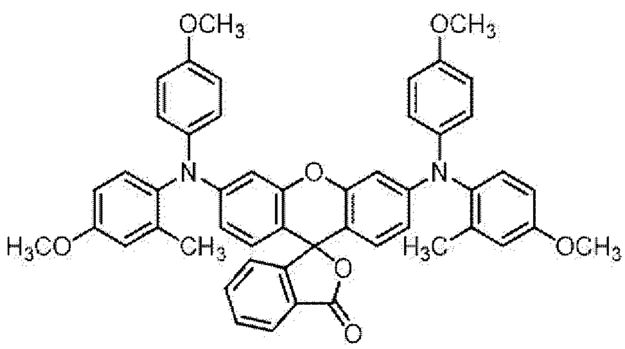

<<Coating liquid (12) for image-recording layer>>

·Infrared absorber (IR-1): 0.0203 parts

·Infrared absorber (IR-2): 0.0068 parts

·Color developing agent (S-3): 0.0120 parts

·Color developing agent (S-4): 0.0300 parts

·Electron-accepting polymerization initiator (Int-1): 0.0981 parts

·Electron-donating polymerization initiator (TPB): 0.0270 parts

·Polymerizable compound (M-1): 0.3536 parts

·Tricresyl phosphate: 0.0125 parts

·Anionic surfactant (A-1): 0.0162 parts

·Pionin A-41-C (manufactured by TAKEMOTO OIL & FAT Co., Ltd., 70% by mass methanol solution): 0.0081 parts

·Fluorine-based surfactant (W-1): 0.0042 parts

·2-Butanone: 5.3155 parts

·1-Methoxy-2-propanol: 2.8825 parts

·Methanol: 2.3391 parts

·Microgel liquid 2: 2.8779 parts

<<Coating liquid for outermost layer>>

The composition of a coating liquid for an outermost layer will be shown below. In each of the following tables, the numerical values described in each of the columns of "Hydrophilic polymer", "Hydrophobic polymer", "Discoloring compound", and "Others" are the amount of these components added (unit: parts by mass) excluding solvents. In each of the following tables, "※1" listed in the column of "Solvent" shows that the amount of the solvent added was adjusted according to the amount of "Hydrophilic polymer", "Hydrophobic polymer", "Discoloring compound", and "Others" added (including a solvent in the case of raw materials provided in the form of a solution or dispersion) such that the amount of the coating liquid was 1 part by mass.

[Table 3]

| Coating liquid for outermost layer | Hydrophilic polymer | Hydrophobic polymer | | | | | | | | Others | Solvent |
|---|---|---|---|---|---|---|---|---|---|---|---|
| | GOHSENX L3266 | FS-101 | FS-102 | FS-106 | FS-107 | FS-201 | FS-301 | FS-501 | FS-701 | EMALEX 710 | Pure water |
| (1) | 0.01000 | 0.01700 | - | - | - | - | - | - | - | 0.00350 | ※ 1 |
| (2) | 0.01000 | - | 0.01700 | - | - | - | - | - | - | 0.00350 | ※ 1 |
| (3) | 0.01000 | - | - | 0.01700 | - | - | - | - | - | 0.00350 | ※ 1 |
| (4) | 0.01000 | - | - | - | 0.01700 | - | - | - | - | 0.00350 | ※ 1 |
| (5) | 0.01000 | - | - | - | - | 0.01700 | - | - | - | 0.00350 | ※ 1 |
| (6) | 0.01000 | - | - | - | - | - | 0.01700 | - | - | 0.00350 | ※ 1 |
| (7) | 0.01000 | - | - | - | - | - | - | 0.01700 | - | 0.00350 | ※ 1 |
| (8) | 0.01000 | - | - | - | - | - | - | - | 0.01700 | 0.00350 | ※ 1 |

[Table 4]

| Coating liquid for outermost layer | Hydrophilic polymer | Hydrophobic polymer | | | | | Others | Solvent |
|---|---|---|---|---|---|---|---|---|
| | GOHSENX L3266 | BONCOAT SK-105E | BONCOAT ED-85E | BONCOAT H-5 | BONCOAT R-3380-E | BONCOAT AN-1170 | EMALEX 710 | Pure water |
| (9) | 0.01000 | 0.01700 | - | - | - | - | 0.00350 | ※ 1 |
| (10) | 0.01000 | - | 0.01700 | - | - | - | 0.00350 | ※ 1 |
| (11) | 0.01000 | - | - | 0.01700 | - | - | 0.00350 | ※ 1 |
| (12) | 0.01000 | - | - | - | 0.01700 | - | 0.00350 | ※ 1 |
| (13) | 0.01000 | - | - | - | - | 0.01700 | 0.00350 | ※ 1 |

[Table 5]

| Coating liquid for outermost layer | Hydrophilic polymer | Hydrophobic polymer | | | | | Others | Solvent |
|---|---|---|---|---|---|---|---|---|
| | GOHSENX L3266 | NEoCryl A-633 | NEoCryl A-639 | NEoCryl A-655 | NEoCryl A-662 | NEoCryl A-1092 | EMALEX 710 | Pure water |
| (14) | 0.01000 | 0.01700 | - | - | - | - | 0.00350 | ※ 1 |
| (15) | 0.01000 | - | 0.01700 | - | - | - | 0.00350 | ※ 1 |
| (16) | 0.01000 | - | - | 0.01700 | - | - | 0.00350 | ※ 1 |
| (17) | 0.01000 | - | - | - | 0.01700 | - | 0.00350 | ※ 1 |
| (18) | 0.01000 | - | - | - | - | 0.01700 | 0.00350 | ※ 1 |

[Table 6]

| Coating liquid for outermost layer | Hydrophilic polymer | | | | Hydrophobic polymer | | | | Discoloring compound | | | | | | | Others | Solvent |
|---|---|---|---|---|---|---|---|---|---|---|---|---|---|---|---|---|---|
| | GOHSENX L3266 | GOHSENX CKS-50 | Water-soluble polymer 1 | METOLOSE SM04 | FS-101 | FS-102 | FS-106 | FS-107 | IR-1A | IR-2A | IR-3A | IR-4A | IR-5A | IR-6A | IR-7A | EMALEX 710 | Pure water |
| (19) | - | 0.01000 | - | - | - | 0.01700 | - | - | - | - | - | - | - | - | - | 0.00350 | ※1 |
| (20) | - | - | 0.01000 | - | - | 0.01700 | - | - | - | - | - | - | - | - | - | 0.00350 | ※1 |
| (21) | - | - | - | 0.01000 | - | 0.01700 | - | - | - | - | - | - | - | - | - | 0.00350 | ※1 |
| (22) | 0.01000 | - | - | - | - | 0.01000 | - | - | - | - | - | - | - | - | - | 0.00350 | ※1 |
| (23) | 0.01000 | - | - | - | - | 0.00500 | - | - | - | - | - | - | - | - | - | 0.00350 | ※1 |
| (24) | 0.01000 | - | - | - | - | 0.03000 | - | - | - | - | - | - | - | - | - | 0.00350 | ※1 |
| (25) | 0.01000 | - | - | - | - | 0.00100 | - | - | - | - | - | - | - | - | - | 0.00350 | ※1 |
| (26) | 0.02000 | - | - | - | - | 0.01700 | - | - | - | - | - | - | - | - | - | 0.00350 | ※1 |
| (27) | 0.02000 | - | - | - | - | 0.01700 | - | - | - | - | - | - | - | - | - | 0.00350 | ※1 |
| (28) | 0.02000 | - | - | - | - | 0.01700 | - | - | - | - | - | - | - | - | - | 0.00350 | ※1 |
| (29) | 0.02000 | - | - | - | - | 0.01700 | - | - | - | - | - | - | - | - | - | 0.00350 | ※1 |
| (30) | - | 0.02000 | - | - | - | 0.02500 | - | - | - | - | - | - | - | - | - | 0.00350 | ※1 |
| (31) | - | 0.02000 | - | - | - | 0.05000 | - | - | - | - | - | - | - | - | - | 0.00350 | ※1 |
| (32) | - | - | - | - | 0.01700 | - | - | - | - | - | - | - | - | - | - | 0.00350 | ※1 |
| (33) | - | - | - | - | - | 0.01700 | - | - | - | - | - | - | - | - | - | 0.00350 | ※1 |
| (34) | - | - | - | - | - | - | 0.01700 | - | - | - | - | - | - | - | - | 0.00350 | ※1 |
| (35) | - | - | - | - | - | - | - | 0.01700 | - | - | - | - | - | - | - | 0.00350 | ※1 |
| (36) | 0.01000 | - | - | - | - | 0.01700 | - | - | 0.02000 | - | - | - | - | - | - | 0.00350 | ※1 |
| (37) | 0.01000 | - | - | - | - | 0.01700 | - | - | - | 0.02000 | - | - | - | - | - | 0.00350 | ※1 |
| (38) | 0.01000 | - | - | - | - | 0.01700 | - | - | - | - | 0.02000 | - | - | - | - | 0.00350 | ※1 |
| (39) | 0.01000 | - | - | - | - | 0.01700 | - | - | - | - | - | 0.02000 | - | - | - | 0.00350 | ※1 |
| (40) | 0.01000 | - | - | - | - | 0.01700 | - | - | - | - | - | - | 0.02000 | - | - | 0.00350 | ※1 |
| (41) | 0.01000 | - | - | - | - | 0.01700 | - | - | - | - | - | - | - | 0.02000 | - | 0.00350 | ※1 |
| (42) | 0.01000 | - | - | - | - | 0.01700 | - | - | - | - | - | - | - | - | 0.02000 | 0.00350 | ※1 |
| (1B) | 0.05000 | - | - | - | - | - | - | - | - | - | - | - | - | - | - | 0.00350 | ※1 |
| (2B) | - | 0.05000 | - | - | - | - | - | - | - | - | - | - | - | - | - | 0.00350 | ※1 |
| (3B) | - | - | 0.05000 | - | - | - | - | - | - | - | - | - | - | - | - | 0.00350 | ※1 |
| (4B) | - | - | - | 0.05000 | - | - | - | - | - | - | - | - | - | - | - | 0.00350 | ※1 |

The composition of a coating liquid (43) for an outermost layer will be shown below.

- ·Water: 1.0161 parts
- ·METOLOSE SM04: 0.0600 parts
- ·FS-102 (17% by mass aqueous dispersion): 0.1177 parts
- ·Lapisol A-80 (80% by mass aqueous solution, manufactured by NOF CORPORATION): 0.0063 parts

The composition of a coating liquid (44) for an outermost layer will be shown below.

- ·Water: 0.8009 parts
- ·METOLOSE SM04: 0.0400 parts
- ·FS-102 (17% by mass aqueous dispersion): 0.3529 parts
- ·Lapisol A-80 (80% by mass aqueous solution, manufactured by NOF CORPORATION): 0.0063 parts

Details of each component of the coating liquid for an outermost layer described will be shown below.

[Hydrophilic polymer]

- ·GOHSENX L3266: sulfonic acid-modified polyvinyl alcohol, manufactured by Mitsubishi Chemical Corporation., Mw = 17,000.
- ·GOHSENX CKS-50: sulfonic acid-modified polyvinyl alcohol, manufactured by Mitsubishi Chemical Corporation., Mw = 27,000.
- ·METOLOSE SM04: methyl cellulose, manufactured by Shin-Etsu Chemical Co., Ltd., methoxy substitution degree = 1.8

Water-soluble polymer **1**

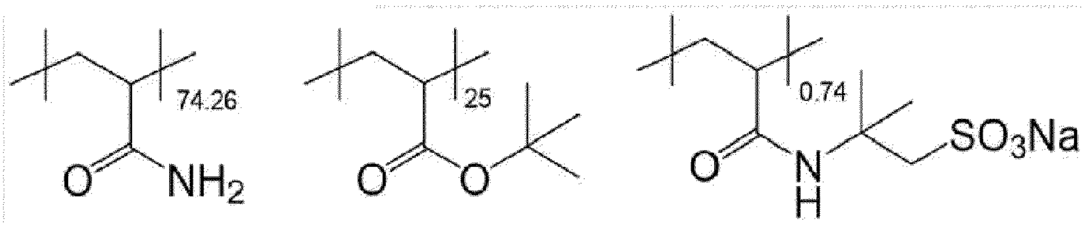

Mw=30,000

[Hydrophobic polymer]

- ·FS-101: acryl, manufactured by Nippon Paint Industrial Coatings Co., Ltd., Tg = 49°C
- ·FS-102: styrene-acryl, manufactured by Nippon Paint Industrial Coatings Co., Ltd., Tg = 103°C
- ·FS-106: acryl, manufactured by Nippon Paint Industrial Coatings Co., Ltd., Tg = 84°C
- ·FS-107: acryl, manufactured by Nippon Paint Industrial Coatings Co., Ltd., Tg = 84°C
- ·FS-201: styrene-acryl, manufactured by Nippon Paint Industrial Coatings Co., Ltd., Tg = 89°C
- ·FS-301: styrene-acryl, manufactured by Nippon Paint Industrial Coatings Co., Ltd., Tg = 55°C
- ·FS-501: acryl, manufactured by Nippon Paint Industrial Coatings Co., Ltd., Tg = 79°C
- ·FS-701: fluorine-based acryl, manufactured by Nippon Paint Industrial Coatings Co., Ltd., Tg = 82°C
- ·BONCOAT SK-105E: styrene, manufactured by DIC Corporation, Tg = 100°C
- ·BONCOAT ED-85E: acryl, manufactured by DIC Corporation, Tg = 30°C
- ·BONCOAT H-5: acryl, manufactured by DIC Corporation, Tg = 33°C
- ·BONCOAT R-3380-E: acryl, manufactured by DIC Corporation, Tg = 30°C

·BONCOAT AN-1170: acryl, manufactured by DIC Corporation, Tg = 60°C
·NEoCryl A-633: styrene-acryl, manufactured by DSM Coating Resins, LLC., Tg = 63°C
·NEoCryl A-639: styrene-acryl, manufactured by DSM Coating Resins, LLC., Tg = 62°C
·NEoCryl A-655: styrene-acryl, manufactured by DSM Coating Resins, LLC., Tg = 33°C
·NEoCryl A-662: styrene-acryl, manufactured by DSM Coating Resins, LLC., Tg = 95°C
·NEoCryl A-1092: styrene-acryl, manufactured by DSM Coating Resins, LLC., Tg = 98°C

[Discoloring compound]

The chemical structure of the discoloring compound will be shown below.

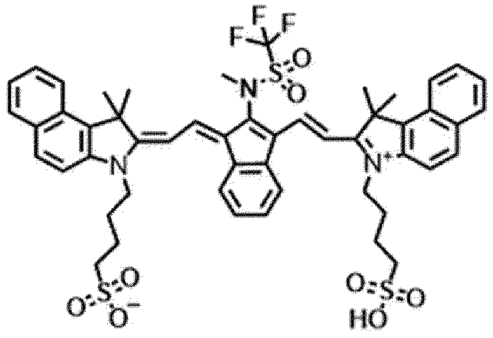

IR-1A

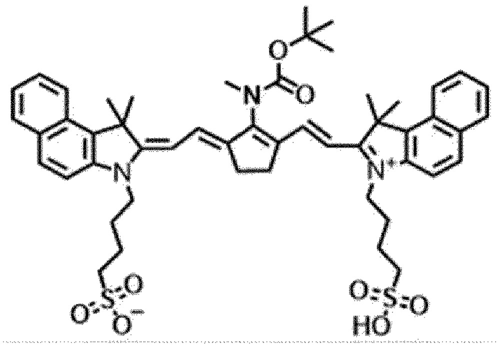

IR-2A

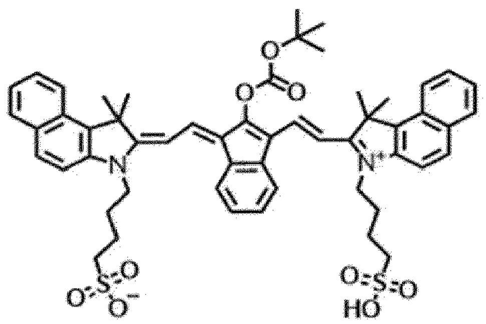

IR-3A

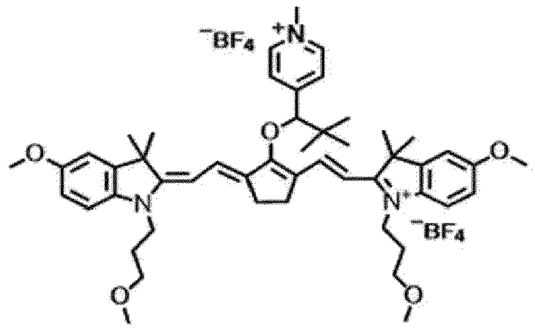

IR-4A

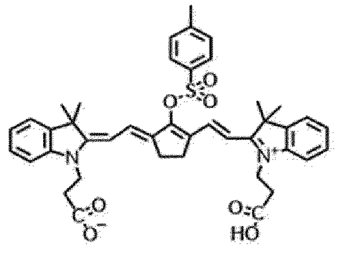

IR-5A

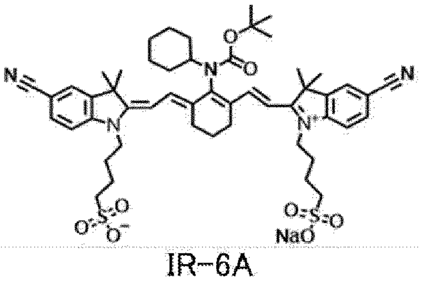

IR-6A

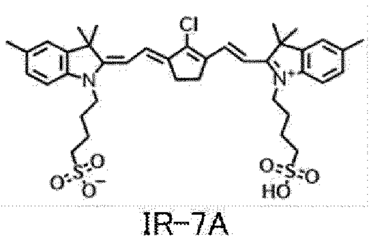

IR-7A

[Others]

·EMALEX 710: surfactant, polyoxyethylene lauryl ether, manufactured by Nihon Emulsion Co., Ltd.

<Examples 1 to 67 and Comparative Examples 1 to 4>

By using the support and coating liquid selected according to the description in Tables 7 to 9, a lithographic printing plate precursor was prepared by the following procedure. The layer marked with "-" in Tables 7 to 9 means a layer not included in the lithographic printing plate precursor.

<<Formation of undercoat layer>>

The support was coated with the coating liquid for an undercoat layer such that the dry coating amount was 100 $mg/m^2$. In this way, an undercoat layer was formed.

<<Formation of image-recording layer>>

The support or undercoat layer was bar-coated with the coating liquid for an image-recording layer and then dried in an oven at 120°C for 40 seconds, thereby forming an image-recording layer having a dry coating amount of 1.3 $g/m^2$.

<<Formation of outermost layer>>

The image-recording layer was bar-coated with a coating liquid for an outermost layer and then dried in an oven at 120°C for 60 seconds, thereby forming an outermost layer having a dry coating amount of 0.7 $g/m^2$.

<<Evaluation>>

[Ozone discoloration]

The prepared lithographic printing plate precursor was processed in a size of 3 cm × 3 cm, put in a 100 mL vial, and then left to stand on a table. An ozonizer (ozone concentration: about 150 ppm) was fixed to the upper portion of the Kiriyama filtration bottle, and the vial was covered with the Kiriyama filtration bottle. As a spacer, a stirring blade was placed at the lower portion of the Kiriyama filtration bottle, and an ozone stream was discharged for exposure. L*, a*, and b* of the lithographic printing plate before and after the 8 hours of exposure to ozone were measured using a colorimeter (Ecxact manufactured by X-Rite, Incorporated.). According to the following standard, the ozone discoloration was evaluated. The larger the numerical values of the following standard, the further the ozone discoloration is suppressed. The evaluation results are shown in Tables 7 to 9.

10: The color difference (ΔE) before and after the exposure to ozone was less than 0.5.
9: The color difference (ΔE) before and after the exposure to ozone was 0.5 or more and less than 1.0.
8: The color difference (ΔE) before and after the exposure to ozone was 1.0 or more and less than 1.5.
7: The color difference (ΔE) before and after the exposure to ozone was 1.5 or more and less than 2.0.
6: The color difference (ΔE) before and after the exposure to ozone was 2.0 or more and less than 2.5.
5: The color difference (ΔE) before and after the exposure to ozone was 2.5 or more and less than 3.0.
4: The color difference (ΔE) before and after the exposure to ozone was 3.0 or more and less than 3.5.
3: The color difference (ΔE) before and after the exposure to ozone was 3.5 or more and less than 4.0.
2: The color difference (ΔE) before and after the exposure to ozone was 4.0 or more and less than 4.5.
1: The color difference (ΔE) before and after the exposure to ozone was 4.5 or more.

[On-press development residues]

In Luxel PLATESETTER T-6000III manufactured by FUJIFILM Corporation that was equipped with an infrared semiconductor laser, the prepared lithographic printing plate precursor was exposed under the conditions of an outer drum rotation speed of 1,000 rpm, a laser output of 70%, and resolution of 2,400 dpi. The exposure image included a solid image and a 50% halftone dot chart of a 20 μm dot FM screen. The exposed lithographic printing plate precursor was mounted on a plate cylinder of a printer LITHRONE26 manufactured by KOMORI Corporation, without being subjected to a development treatment. By using dampening water containing Ecolity-2 (manufactured by FUJIFILM Corporation)/tap water = 2/98 (volume ratio) and SPACE COLOR FUSION G black ink (manufactured by DIC Graphics Corporation), on-press development was performed by supplying the dampening water and ink according to the standard automatic printing start method of LITHRONE26. Thereafter, printing was performed on 100 sheets of TOKUBISHI art paper (manufactured by MITSUBISHI PAPER MILLS LIMITED., ream weight: 76.5 kg) at a printing rate of 10,000 sheets/hour. The above operation was repeatedly carried out for 15 plates, and the state of the occurrence of residues adhering to the dampening

roller was assessed by sensory evaluation. A lithographic printing plate precursor where residues occurred was graded C, a lithographic printing plate precursor where few residues occurred was graded B, and a lithographic printing plate precursor where no residues occurred was graded A. The evaluation results are shown in Tables 7 to 9.

[Table 7]

| | Lithographic printing plate precursor | | | | | | | | ΔL | Evaluation | |
|---|---|---|---|---|---|---|---|---|---|---|---|
| | | | | | Outermost layer | | | | | | |
| | Type | Support | Undercoat layer | Image-recording layer | Type of coating liquid | Content of hydrophobic polymer (%) | Contact angle of water droplet (°) | Contact angle of oil droplet (°) | | Ozone discoloration | Resides of on-press development |
| Example 1 | 1 | Support (1) | Coating liquid (1) for undercoat layer | Coating liquid (1) for image-recording layer | Coating liquid (1) for outermost layer | 56 | 40 | 4.6 | 5 | 8 | A |
| Example 2 | 2 | Support (1) | Coating liquid (1) for undercoat layer | Coating liquid (1) for image-recording layer | Coating liquid (2) for outermost layer | 56 | 50 | 5.3 | 5 | 8 | A |
| Example 3 | 3 | Support (1) | Coating liquid (1) for undercoat layer | Coating liquid (1) for image-recording layer | Coating liquid (3) for outermost layer | 56 | 40 | 2.9 | 5 | 8 | A |
| Example 4 | 4 | Support (1) | Coating liquid (1) for undercoat layer | Coating liquid (1) for image-recording layer | Coating liquid (4) for outermost layer | 56 | 55 | 2.8 | 5 | 8 | A |
| Example 5 | 5 | Support (1) | Coating liquid (1) for undercoat layer | Coating liquid (1) for image-recording layer | Coating liquid (5) for outermost layer | 56 | 60 | 6.5 | 5 | 8 | A |
| Example 6 | 6 | Support (1) | Coating liquid (1) for undercoat layer | Coating liquid (1) for image-recording layer | Coating liquid (6) for outermost layer | 56 | 45 | 3.5 | 5 | 8 | A |
| Example 7 | 7 | Support (1) | Coating liquid (1) for undercoat layer | Coating liquid (1) for image-recording layer | Coating liquid (7) for outermost layer | 56 | 65 | 9 | 5 | 8 | A |
| Example 8 | 8 | Support (1) | Coating liquid (1) for undercoat layer | Coating liquid (1) for image-recording layer | Coating liquid (8) for outermost layer | 56 | 50 | 9.5 | 5 | 8 | A |
| Example 9 | 9 | Support (1) | Coating liquid (1) for undercoat layer | Coating liquid (1) for image-recording layer | Coating liquid (9) for outermost layer | 56 | 55 | 3.7 | 5 | 8 | A |
| Example 10 | 10 | Support (1) | Coating liquid (1) for undercoat layer | Coating liquid (1) for image-recording layer | Coating liquid (10) for outermost layer | 56 | 45 | 5.3 | 5 | 8 | A |
| Example 11 | 11 | Support (1) | Coating liquid (1) for undercoat layer | Coating liquid (1) for image-recording layer | Coating liquid (11) for outermost layer | 56 | 50 | 2.9 | 5 | 8 | A |
| Example 12 | 12 | Support (1) | Coating liquid (1) for undercoat layer | Coating liquid (1) for image-recording layer | Coating liquid (12) for outermost layer | 56 | 42 | 2.8 | 5 | 8 | A |
| Example 13 | 13 | Support (1) | Coating liquid (1) for undercoat layer | Coating liquid (1) for image-recording layer | Coating liquid (13) for outermost layer | 56 | 52 | 5.3 | 5 | 8 | A |
| Example 14 | 14 | Support (1) | Coating liquid (1) for undercoat layer | Coating liquid (1) for image-recording layer | Coating liquid (14) for outermost layer | 56 | 45 | 2.9 | 5 | 8 | A |

| | | | | | | | | | | | |
|---|---|---|---|---|---|---|---|---|---|---|---|
| Example 15 | 15 | Support (1) | Coating liquid (1) for undercoat layer | Coating liquid (1) for image-recording layer | Coating liquid (15) for outermost layer | 56 | 45 | 2.8 | 5 | 8 | A |
| Example 16 | 16 | Support (1) | Coating liquid (1) for undercoat layer | Coating liquid (1) for image-recording layer | Coating liquid (16) for outermost layer | 56 | 50 | 6.5 | 5 | 8 | A |
| Example 17 | 17 | Support (1) | Coating liquid (1) for undercoat layer | Coating liquid (1) for image-recording layer | Coating liquid (17) for outermost layer | 56 | 55 | 3.5 | 5 | 8 | A |
| Example 18 | 18 | Support (1) | Coating liquid (1) for undercoat layer | Coating liquid (1) for image-recording layer | Coating liquid (18) for outermost layer | 56 | 37 | 5 | 5 | 8 | A |
| Example 19 | 19 | Support (1) | Coating liquid (1) for undercoat layer | Coating liquid (1) for image-recording layer | Coating liquid (19) for outermost layer | 56 | 38 | 3.7 | 5 | 8 | A |
| Example 20 | 20 | Support (1) | Coating liquid (1) for undercoat layer | Coating liquid (1) for image-recording layer | Coating liquid (20) for outermost layer | 56 | 38 | 2.8 | 5 | 8 | A |
| Example 21 | 21 | Support (1) | Coating liquid (1) for undercoat layer | Coating liquid (1) for image-recording layer | Coating liquid (21) for outermost layer | 56 | 38 | 6.5 | 5 | 8 | A |
| Example 22 | 22 | Support (1) | Coating liquid (1) for undercoat layer | Coating liquid (1) for image-recording layer | Coating liquid (22) for outermost layer | 43 | 40 | 3.5 | 5 | 7 | A |
| Example 23 | 23 | Support (1) | Coating liquid (1) for undercoat layer | Coating liquid (1) for image-recording layer | Coating liquid (23) for outermost layer | 27 | 50 | 15 | 5 | 5 | A |
| Example 24 | 24 | Support (1) | Coating liquid (1) for undercoat layer | Coating liquid (1) for image-recording layer | Coating liquid (24) for outermost layer | 69 | 70 | 9.5 | 5 | 10 | A |
| Example 25 | 25 | Support (1) | Coating liquid (1) for undercoat layer | Coating liquid (1) for image-recording layer | Coating liquid (25) for outermost layer | 7 | 37 | 19 | 5 | 4 | B |
| Example 26 | 26 | Support (1) | Coating liquid (1) for undercoat layer | Coating liquid (1) for image-recording layer | Coating liquid (26) for outermost layer | 42 | 60 | 8 | 5 | 7 | A |
| Example 27 | 27 | Support (1) | Coating liquid (1) for undercoat layer | Coating liquid (1) for image-recording layer | Coating liquid (27) for outermost layer | 42 | 45 | 2 | 5 | 7 | A |
| Example 28 | 28 | Support (1) | Coating liquid (1) for undercoat layer | Coating liquid (1) for image-recording layer | Coating liquid (28) for outermost layer | 42 | 65 | 2.8 | 5 | 7 | A |
| Example 29 | 29 | Support (1) | Coating liquid (1) for undercoat layer | Coating liquid (1) for image-recording layer | Coating liquid (29) for outermost layer | 42 | 50 | 6.5 | 5 | 7 | A |
| Example 30 | 30 | Support (1) | Coating liquid (1) for undercoat layer | Coating liquid (1) for image-recording layer | Coating liquid (30) for outermost layer | 52 | 55 | 3.5 | 5 | 8 | A |

| | | | | | | | | | | |
|---|---|---|---|---|---|---|---|---|---|---|
| Example 31 | 31 | Support (1) | Coating liquid (1) for undercoat layer | Coating liquid (1) for image-recording layer | Coating liquid (31) for outermost layer | 68 | 45 | 2 | 5 | 10 | A |
| Example 32 | 32 | Support (1) | Coating liquid (2) for undercoat layer | Coating liquid (2) for image-recording layer | Coating liquid (13) for outermost layer | 56 | 50 | 2.9 | 5 | 8 | A |
| Example 33 | 33 | Support (1) | Coating liquid (2) for undercoat layer | Coating liquid (2) for image-recording layer | Coating liquid (14) for outermost layer | 56 | 42 | 2.8 | 5 | 8 | A |
| Example 34 | 34 | Support (1) | Coating liquid (2) for undercoat layer | Coating liquid (2) for image-recording layer | Coating liquid (15) for outermost layer | 56 | 52 | 5.3 | 5 | 8 | A |
| Example 35 | 35 | Support (1) | Coating liquid (2) for undercoat layer | Coating liquid (2) for image-recording layer | Coating liquid (16) for outermost layer | 56 | 45 | 2.9 | 5 | 8 | A |
| Example 36 | 36 | Support (1) | Coating liquid (2) for undercoat layer | Coating liquid (2) for image-recording layer | Coating liquid (17) for outermost layer | 56 | 45 | 2.8 | 5 | 8 | A |
| Example 37 | 37 | Support (1) | Coating liquid (2) for undercoat layer | Coating liquid (2) for image-recording layer | Coating liquid (18) for outermost layer | 56 | 50 | 6.5 | 5 | 8 | A |
| Example 38 | 38 | Support (1) | Coating liquid (2) for undercoat layer | Coating liquid (2) for image-recording layer | Coating liquid (19) for outermost layer | 56 | 65 | 6.5 | 5 | 8 | A |
| Example 39 | 39 | Support (1) | Coating liquid (2) for undercoat layer | Coating liquid (2) for image-recording layer | Coating liquid (20) for outermost layer | 56 | 50 | 3.5 | 5 | 8 | A |
| Example 40 | 40 | Support (1) | Coating liquid (2) for undercoat layer | Coating liquid (2) for image-recording layer | Coating liquid (21) for outermost layer | 56 | 55 | 9 | 5 | 8 | A |
| Example 41 | 41 | Support (2) | - | Coating liquid (3) for image-recording layer | Coating liquid (22) for outermost layer | 43 | 45 | 9.5 | 5 | 7 | A |
| Example 42 | 42 | Support (2) | - | Coating liquid (3) for image-recording layer | Coating liquid (23) for outermost layer | 27 | 50 | 3.7 | 5 | 5 | A |
| Example 43 | 43 | Support (3) | - | Coating liquid (4) for image-recording layer | Coating liquid (24) for outermost layer | 69 | 42 | 2.8 | 3 | 10 | A |
| Example 44 | 44 | Support (4) | Coating liquid (3) for undercoat layer | Coating liquid (5) for image-recording layer | Coating liquid (19) for outermost layer | 56 | 52 | 6.5 | 3 | 10 | A |
| Example 45 | 45 | Support (1) | - | Coating liquid (1) for image-recording layer | Coating liquid (26) for outermost layer | 42 | 45 | 3.7 | 5 | 8 | A |
| Example 46 | 46 | Support (1) | Coating liquid (1) for undercoat layer | Coating liquid (1) for image-recording layer | Coating liquid (32) for outermost layer | 83 | 100 | 10 | 5 | 6 | A |

| | | | | | | | | | | | |
|---|---|---|---|---|---|---|---|---|---|---|---|
| Example 47 | 47 | Support (1) | Coating liquid (1) for undercoat layer | Coating liquid (1) for image-recording layer | Coating liquid (33) for outermost layer | 83 | 100 | 10 | 5 | 6 | A |
| Example 48 | 48 | Support (1) | Coating liquid (1) for undercoat layer | Coating liquid (1) for image-recording layer | Coating liquid (34) for outermost layer | 83 | 100 | 10 | 5 | 6 | A |
| Example 49 | 49 | Support (1) | Coating liquid (1) for undercoat layer | Coating liquid (1) for image-recording layer | Coating liquid (35) for outermost layer | 83 | 100 | 10 | 5 | 6 | A |
| Example 50 | 50 | Support (1) | Coating liquid (1) for undercoat layer | Coating liquid (1) for image-recording layer | Coating liquid (36) for outermost layer | 56 | 40 | 4.6 | 8 | 8 | A |
| Example 51 | 51 | Support (1) | Coating liquid (1) for undercoat layer | Coating liquid (1) for image-recording layer | Coating liquid (37) for outermost layer | 56 | 40 | 4.6 | 8 | 8 | A |
| Example 52 | 52 | Support (1) | Coating liquid (1) for undercoat layer | Coating liquid (1) for image-recording layer | Coating liquid (38) for outermost layer | 56 | 40 | 4.6 | 8 | 8 | A |
| Example 53 | 53 | Support (1) | Coating liquid (1) for undercoat layer | Coating liquid (1) for image-recording layer | Coating liquid (39) for outermost layer | 56 | 40 | 4.6 | 8 | 8 | A |
| Example 54 | 54 | Support (1) | Coating liquid (1) for undercoat layer | Coating liquid (1) for image-recording layer | Coating liquid (40) for outermost layer | 56 | 40 | 4.6 | 8 | 8 | A |
| Example 55 | 55 | Support (1) | Coating liquid (1) for undercoat layer | Coating liquid (1) for image-recording layer | Coating liquid (41) for outermost layer | 56 | 40 | 4.6 | 8 | 8 | A |
| Example 56 | 56 | Support (1) | Coating liquid (1) for undercoat layer | Coating liquid (1) for image-recording layer | Coating liquid (42) for outermost layer | 56 | 40 | 4.6 | 8 | 8 | A |
| Comparative Example 1 | 1B | Support (1) | Coating liquid (1) for undercoat layer | Coating liquid (1) for image-recording layer | Coating liquid (1B) for outermost layer | 0 | 10 | 70 | 5 | 1 | C |
| Comparative Example 2 | 2B | Support (1) | Coating liquid (1) for undercoat layer | Coating liquid (1) for image-recording layer | Coating liquid (2B) for outermost layer | 0 | 10 | 70 | 5 | 1 | C |
| Comparative Example 3 | 3B | Support (1) | Coating liquid (1) for undercoat layer | Coating liquid (1) for image-recording layer | Coating liquid (3B) for outermost layer | 0 | 10 | 70 | 5 | 1 | C |
| Comparative Example 4 | 4B | Support (1) | Coating liquid (1) for undercoat layer | Coating liquid (1) for image-recording layer | Coating liquid (4B) for outermost layer | 0 | 10 | 70 | 5 | 1 | C |

[Table 8]

| | Lithographic printing plate precursor | | | | | | | | ΔL | Evaluation | |
|---|---|---|---|---|---|---|---|---|---|---|---|
| | Type | Support | Undercoat layer | Image-recording layer | Outermost layer | | | | | Ozone discoloration | Resides of on-press development |
| | | | | | Type of coating liquid | Content of hydrophobic polymer (%) | Contact angle of water droplet (°) | Contact angle of oil droplet (°) | | | |
| Example 57 | 57 | Support (1) | Coating liquid (1) for undercoat layer | Coating liquid (6) for image-recording layer | Coating liquid (21) for outermost layer | 56 | 38 | 2.8 | 6 | 8 | A |
| Example 58 | 58 | Support (1) | Coating liquid (1) for undercoat layer | Coating liquid (7) for image-recording layer | Coating liquid (21) for outermost layer | 56 | 38 | 2.8 | 6 | 8 | A |
| Example 59 | 59 | Support (1) | Coating liquid (1) for undercoat layer | Coating liquid (8) for image-recording layer | Coating liquid (21) for outermost layer | 56 | 38 | 2.8 | 6 | 8 | A |
| Example 60 | 60 | Support (1) | Coating liquid (1) for undercoat layer | Coating liquid (9) for image-recording layer | Coating liquid (21) for outermost layer | 56 | 38 | 2.8 | 6 | 8 | A |
| Example 61 | 61 | Support (1) | Coating liquid (1) for undercoat layer | Coating liquid (10) for image-recording layer | Coating liquid (21) for outermost layer | 56 | 38 | 2.8 | 6 | 8 | A |

[Table 9]

| | Lithographic printing plate precursor | | | | | | | | ΔL | Evaluation | |
|---|---|---|---|---|---|---|---|---|---|---|---|
| | | | | | Outermost layer | | | | | | |
| | Type | Support | Undercoat layer | Image-recording layer | Type of coating liquid | Content of hydrophobic polymer (%) | Contact angle of water droplet (°) | Contact angle of oil droplet (°) | | Ozone discoloration | Resides of on-press development |
| Example 62 | 62 | Support (1) | Coating liquid (4) for undercoat layer | Coating liquid (11) for image-recording layer | Coating liquid (43) for outermost layer | 23 | 25 | 5 | 6 | 8 | A |
| Example 63 | 63 | Support (1) | Coating liquid (5) for undercoat layer | Coating liquid (11) for image-recording layer | Coating liquid (43) for outermost layer | 23 | 25 | 5 | 6 | 8 | A |
| Example 64 | 64 | Support (1) | Coating liquid (4) for undercoat layer | Coating liquid (12) for image-recording layer | Coating liquid (43) for outermost layer | 23 | 25 | 5 | 6 | 8 | A |
| Example 65 | 65 | Support (1) | Coating liquid (4) for undercoat layer | Coating liquid (11) for image-recording layer | Coating liquid (44) for outermost layer | 56 | 38 | 2.8 | 6 | 8 | A |
| Example 66 | 66 | Support (1) | Coating liquid (5) for undercoat layer | Coating liquid (11) for image-recording layer | Coating liquid (44) for outermost layer | 56 | 38 | 2.8 | 6 | 8 | A |
| Example 67 | 67 | Support (1) | Coating liquid (4) for undercoat layer | Coating liquid (12) for image-recording layer | Coating liquid (44) for outermost layer | 56 | 38 | 2.8 | 6 | 8 | A |

In Tables 7 to 9, "Content of hydrophobic polymer" shows the content of the hydrophobic polymer calculated based on the total mass of the outermost layer. "Content of hydrophobic polymer" in Tables 7 to 9 can be evaluated as the proportion of an area occupied by the hydrophobic polymer within the surface of the outermost layer.
"Contact angle of water droplet" in Tables 7 to 9 shows the contact angle of a water droplet on the surface of the outermost layer that is measured 2 seconds after the water droplet is landed by an airborne water droplet method.
"Contact angle of oil droplet" in Tables 7 to 9 shows the contact angle of an oil droplet on the surface of the outermost layer that is measured 2 seconds after the oil droplet is landed by an airborne oil droplet method.
"ΔL" in Tables 7 to 9 shows a brightness change ΔL before and after exposure to infrared having a wavelength of 830 nm at an energy density of 110 $mJ/cm^2$.
As shown in Tables 7 to 9, the occurrence of ozone discoloration was further suppressed in Examples 1 to 67 than in Comparative Examples 1 to 4. In addition, the occurrence of development residues during on-press development is further suppressed in Examples 1 to 67 than in Comparative Examples 1 to 4.

Explanation of References

12a, 12b: aluminum support
18: aluminum plate
20a, 20b: anodic oxide film
22a, 22b: micropore
24: large diameter portion
26: small diameter portion
D: depth
610: anodization treatment device
612: power supply tank
614: electrolytic treatment tank
616: aluminum plate
618, 626: electrolytic solution
620: power supply electrode
622, 628: roller
624: nip roller
630: electrolysis electrode
632: cell wall
634: direct current power source

## Claims

1. An on-press development type lithographic printing plate precursor comprising, in the following order:

   a support;
   an image-recording layer; and
   an outermost layer,
   wherein a contact angle of a water droplet on a surface of the outermost layer that is measured at 25 °C and 2 seconds after the water droplet is landed by an airborne water droplet method is greater than 36°, and wherein a contact angle of a linseed oil droplet on the surface of the outermost layer that is measured at 25 °C and 2 seconds after the oil droplet is landed by an airborne oil droplet method is 20° or less.

2. The on-press development type lithographic printing plate precursor according to claim 1,
   wherein the outermost layer contains a hydrophobic polymer and a hydrophilic polymer.

3. The on-press development type lithographic printing plate precursor according to claim 2,
   wherein a proportion of an area occupied by the hydrophobic polymer within the surface of the outermost layer is 10% or more.

4. The on-press development type lithographic printing plate precursor according to claim 2 or 3,
   wherein the hydrophobic polymer is in a form of particles.

**5.** The on-press development type lithographic printing plate precursor according to any one of claims 2 to 4, wherein a glass transition temperature of the hydrophobic polymer is 60°C or higher.

**6.** The on-press development type lithographic printing plate precursor according to any one of claims 2 to 5, wherein a content of the hydrophobic polymer is equal to or more than 1.7 times a content of the hydrophilic polymer based on mass.

**7.** The on-press development type lithographic printing plate precursor according to any one of claims 1 to 6, wherein the outermost layer contains a discoloring compound, wherein a discoloring compound refers to a compound which undergoes change in absorption in the visible light region of wavelength 400 nm or more and less than 750 nm, due to the exposure to infrared.

**8.** The on-press development type lithographic printing plate precursor according to claim 7, wherein in a case where the on-press development type lithographic printing plate precursor is subjected to exposure to infrared having a wavelength of 830 nm at an energy density of 110 $mJ/cm^2$, a brightness change $\Delta L$ before and after the exposure is 2.0 or more.

**9.** The on-press development type lithographic printing plate precursor according to 7 or 8,

wherein the discoloring compound is a compound represented by Formula **1-1,**

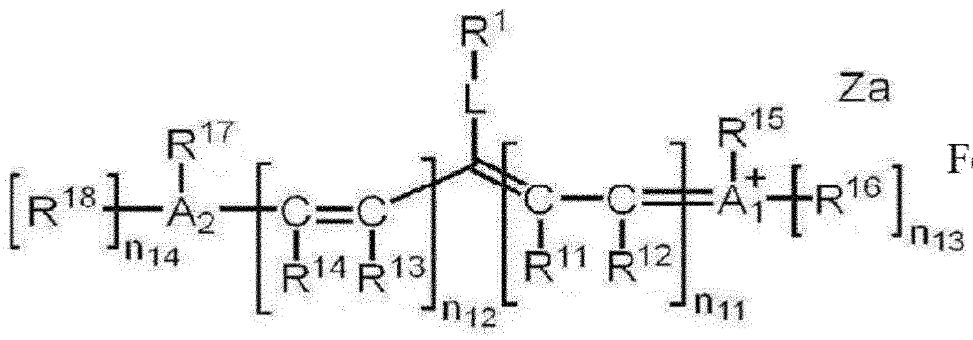

Formula 1-1

in Formula 1-1, $R^1$ represents a group that is represented by any one of Formula 2, Formula 3, or Formula 4, $R^{11}$ to $R^{18}$ each independently represent a hydrogen atom, a halogen atom, $-R^a$, $-OR^b$, $-SR^c$, or $-NR^dR^e$, $R^a$ to $R^e$ each independently represent a hydrocarbon group, $A_1$, $A_2$, and a plurality of $R^{11}$ to $R^{18}$ may be linked to each other to form a monocyclic or polycyclic ring, $A_1$ and $A_2$ each independently represent an oxygen atom, a sulfur atom, or a nitrogen atom, $n_{11}$ and $n_{12}$ each independently represent an integer of 0 to 5, a sum of $n_{11}$ and $n_{12}$ is 2 or more, $n_{13}$ and $n_{14}$ each independently represent 0 or 1, L represents an oxygen atom, a sulfur atom, or $-NR^{10}-$, $R^{10}$ represents a hydrogen atom, an alkyl group, or an aryl group, and Za represents a counterion that neutralizes charge,

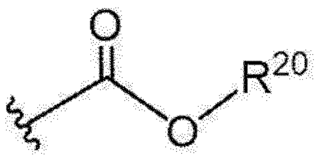

Formula 2

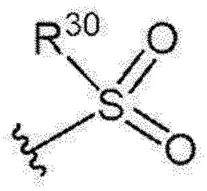

Formula 3

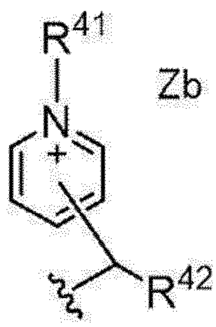

Formula 4

in Formula 2 to Formula 4, $R^{20}$, $R^{30}$, $R^{41}$, and $R^{42}$ each independently represent an alkyl group or an aryl group, Zb represents a counterion that neutralizes charge, and a wavy line represents a bonding site with L.

**10.** The on-press development type lithographic printing plate precursor according to any one of claims 7 to 9,

wherein the discoloring compound is a compound represented by Formula 1-2,

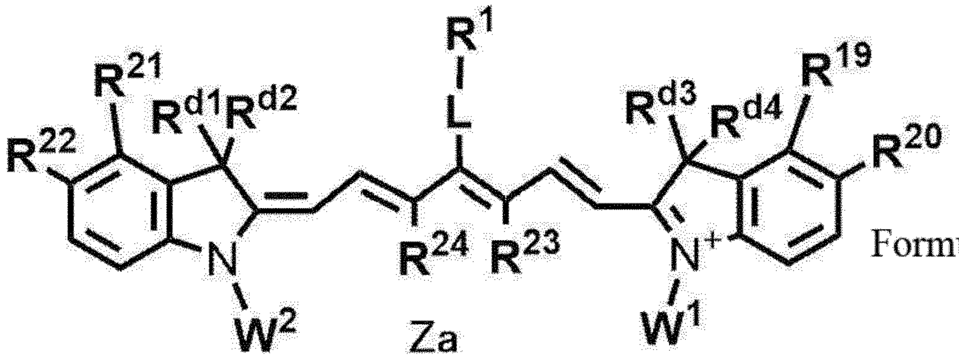

Formula 1-2

in Formula 1-2, $R^1$ represents a group that is represented by any one of Formula 2, Formula 3, or Formula 4, $R^{19}$ to $R^{22}$ each independently represent a hydrogen atom, a halogen atom, $-R^a$, $-OR^b$, -CN, $-SR^c$, or $-NR^dR^e$, $R^{23}$ and $R^{24}$ each independently represent $-R^a$, $R^a$ to $R^e$ each independently represent a hydrocarbon group, $R^{19}$ and $R^{20}$, $R^{21}$ and $R^{22}$, or $R^{23}$ and $R^{24}$ may be linked to each other to form a monocyclic or polycyclic ring, L represents an oxygen atom, a sulfur atom, or $-NR^{10}-$, $R^{10}$ represents a hydrogen atom, an alkyl group, or an aryl group, $R^{d1}$ to $R^{d4}$, $W^1$, and $W^2$ each independently represent an alkyl group which may have a substituent, and Za represents a counterion that neutralizes charge,

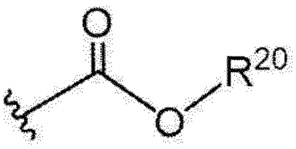

Formula 2

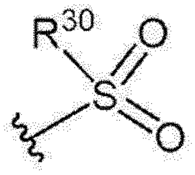

Formula 3

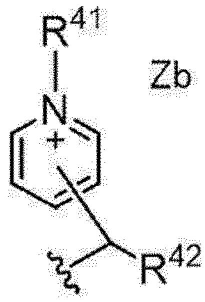

Formula 4

in Formula 2 to Formula 4, $R^{20}$, $R^{30}$, $R^{41}$, and $R^{42}$ each independently represent an alkyl group or an aryl group, Zb represents a counterion that neutralizes charge, and a wavy line represents a bonding site with L.

**11.** The on-press development type lithographic printing plate precursor according to any one of claims 1 to 10,

wherein the image-recording layer contains at least one kind of polymerization initiator selected from the group consisting of an electron-accepting polymerization initiator and an electron-donating polymerization initiator, and wherein the electron-accepting polymerization initiator includes a compound represented by Formula (II),

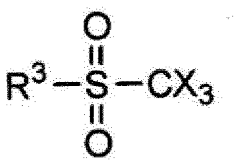

(II)

in Formula (II), X represents a halogen atom, and $R^3$ represents an aryl group.

**12.** The on-press development type lithographic printing plate precursor according to any one of claims 1 to 11, wherein the image-recording layer contains a compound in which an electron-donating polymerization initiator and an electron-accepting polymerization initiator form an ion pair.

**13.** The on-press development type lithographic printing plate precursor according to any one of claims 1 to 12, wherein the image-recording layer contains a polymerizable compound having 7 or more polymerizable groups.

**14.** The on-press development type lithographic printing plate precursor according to claim 1, wherein the outermost layer contains a hydrophobic polymer and a hydrophilic polymer, and a content of the hydrophobic polymer is equal to or more than 1.7 times a content of the hydrophilic polymer based on mass.

**15.** A method of preparing a lithographic printing plate, comprising:

a step of exposing the on-press development type lithographic printing plate precursor according to any one of claims 1 to 14 in a shape of an image; and
a step of supplying at least one material selected from the group consisting of a printing ink and dampening water on a printer to remove the image-recording layer in a non-image area.

**Patentansprüche**

**1.** Lithographischer Druckplattenvorläufer des Auf-Presse-Entwicklungstyps, umfassend, in der folgenden Reihenfolge:

einen Träger;
eine Bildaufzeichnungsschicht; und
eine äußerste Schicht,
wobei ein Kontaktwinkel eines Wassertröpfchens auf einer Oberfläche der äußersten Schicht, der bei 25 °C und 2 Sekunden, nachdem das Wassertröpfchen durch ein Verfahren mit in Luft getragenen Wassertröpfchen aufgebracht wurde, gemessen wird, größer als 36° ist, und wobei ein Kontaktwinkel eines Leinöltröpfchens auf der Oberfläche der äußersten Schicht, der bei 25 °C und 2 Sekunden, nachdem das Leinöltröpfchen durch ein Verfahren mit in Luft getragenen Wassertröpfchen aufgebracht wurde, gemessen wird, 20° oder weniger beträgt.

**2.** Lithographischer Druckplattenvorläufer des Auf-Presse-Entwicklungstyps nach Anspruch 1,
wobei die äußerste Schicht ein hydrophobes Polymer und ein hydrophiles Polymer enthält.

**3.** Lithographischer Druckplattenvorläufer des Auf-Presse-Entwicklungstyps nach Anspruch 2,
wobei ein Anteil einer Fläche, die von dem hydrophoben Polymer innerhalb der Oberfläche der äußersten Schicht eingenommen wird, 10 % oder mehr beträgt.

**4.** Lithographischer Druckplattenvorläufer des Auf-Presse-Entwicklungstyps nach Anspruch 2 oder 3,
wobei das hydrophobe Polymer in einer Form von Partikeln vorliegt.

**5.** Lithographischer Druckplattenvorläufer des Auf-Presse-Entwicklungstyps nach einem der Ansprüche 2 bis 4,
wobei eine Glasübergangstemperatur des hydrophoben Polymers 60 °C oder höher ist.

**6.** Lithographischer Druckplattenvorläufer des Auf-Presse-Entwicklungstyps nach einem der Ansprüche 2 bis 5,
wobei ein Gehalt des hydrophoben Polymers gleich oder mehr als das 1,7 -Fache eines Gehalts des hydrophilen Polymers auf der Grundlage von Masse ist.

**7.** Lithographischer Druckplattenvorläufer des Auf-Presse-Entwicklungstyps nach einem der Ansprüche 1 bis 6,
wobei die äußerste Schicht eine Verfärbungsverbindung enthält, wobei sich eine Verfärbungsverbindung auf eine Verbindung bezieht, die sich aufgrund der Exposition gegenüber Infrarot Änderung in Absorption in dem Bereich von sichtbarem Licht mit Wellenlängen von 400 nm oder mehr und weniger als 750 nm erfährt.

**8.** Lithographischer Druckplattenvorläufer des Auf-Presse-Entwicklungstyps nach Anspruch 7,
wobei in einem Fall, in dem der lithographische Druckplattenvorläufer des Auf-Presse-Entwicklungstyps einer Exposition gegenüber Infrarot mit einer Wellenlänge von 830 nm bei einer Energiedichte von 110 $mJ/cm^2$ unterzogen wird, eine Helligkeitsänderung $\Delta L$ vor und nach der Exposition 2,0 oder mehr beträgt.

**9.** Lithographischer Druckplattenvorläufer des Auf-Presse-Entwicklungstyps nach 7 oder 8,

wobei die Verfärbungsverbindung eine durch Formel 1-1 dargestellte Verbindung ist,

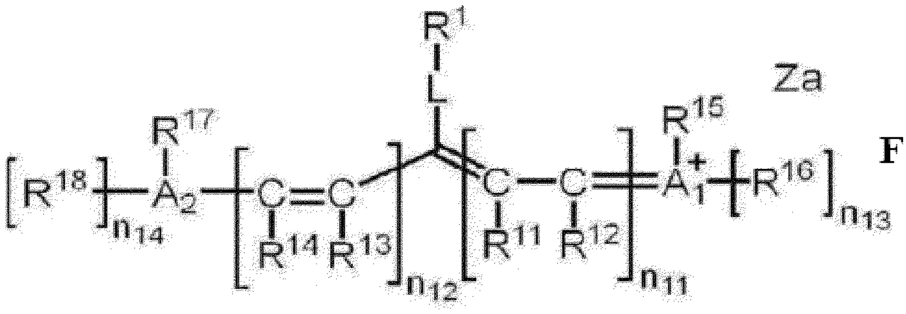

Formel 1-1

in Formel 1-1 $R^1$ eine Gruppe darstellt, die durch eine beliebige von Formel 2, Formel 3 oder Formel 4 dargestellt wird, $R^{11}$ bis $R^{18}$ jeweils unabhängig ein Wasserstoffatom, ein Halogenatom, $-R^a$, $-OR^b$, $-SR^c$ oder $-NR^dR^e$ darstellen, $R^a$ bis $R^e$ jeweils unabhängig eine Kohlenwasserstoffgruppe darstellen, $A_1$, $A_2$ und mehrere von $R^{11}$ bis $R^{18}$ so miteinander verbunden sein können, dass sie einen monozyklischen oder polyzyklischen Ring bilden, $A_1$ und $A_2$ jeweils unabhängig ein Sauerstoffatom, ein Schwefelatom oder ein Stickstoffatom darstellen, $n_{11}$ und $n_{12}$ jeweils unabhängig eine ganze Zahl von 0 bis 5 darstellen, eine Summe aus $n_{11}$ und $n_{12}$ 2 oder mehr beträgt, $n_{13}$ und $n_{14}$ jeweils unabhängig 0 oder 1 darstellen, L ein Sauerstoffatom, ein Schwefelatom oder $-NR^{10}-$ darstellt, $R^{10}$ ein Wasserstoffatom, eine Alkylgruppe oder eine Arylgruppe darstellt und Za ein Gegenion, das Ladung neutralisiert, darstellt,

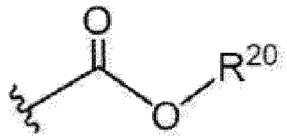

Formel 2

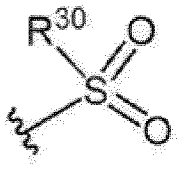

Formel 3

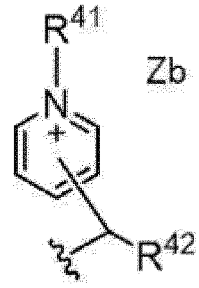

Formel 4

in Formel 2 bis Formel 4 $R^{20}$, $R^{30}$, $R^{41}$ und $R^{42}$ jeweils unabhängig eine Alkylgruppe oder eine Arylgruppe darstellen, Zb ein Gegenion darstellt, das Ladung neutralisiert, und eine Wellenlinie eine Bindungsstelle mit L darstellt.

**10.** Lithographischer Druckplattenvorläufer des Auf-Presse-Entwicklungstyps nach einem der Ansprüche 7 bis 9,

wobei die Verfärbungsverbindung eine durch Formel 1-2 dargestellte Verbindung ist,

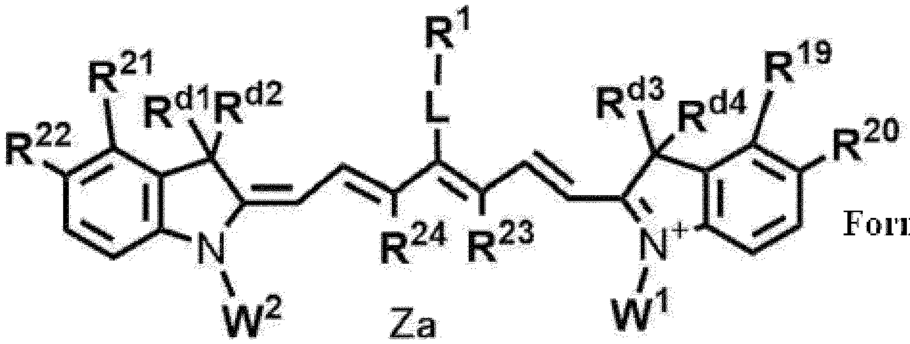

Formel 1-2

in Formel 1-2 $R^1$ eine Gruppe, die durch eine beliebige von Formel 2, Formel 3 oder Formel 4 dargestellt wird, $R^{19}$ bis $R^{22}$ jeweils unabhängig ein Wasserstoffatom, ein Halogenatom, $-R^a$, $-OR^b$, -CN, $-SR^c$ oder $-NR^dR^e$ darstellen, $R^{23}$ und $R^{24}$ jeweils unabhängig ein Wasserstoffatom oder $-R^a$ darstellen, $R^a$ bis $R^e$ jeweils unabhängig eine

Kohlenwasserstoffgruppe darstellen, $R^{19}$ und $R^{20}$, $R^{21}$ und $R^{22}$ oder $R^{23}$ und $R^{24}$ so miteinander verbunden sein können, dass sie einen monozyklischen oder polyzyklischen Ring bilden, L ein Sauerstoffatom, ein Schwefelatom oder -$NR^{10}$-darstellt, $R^{10}$ ein Wasserstoffatom, eine Alkylgruppe oder eine Arylgruppe darstellt, $R^{d1}$ bis $R^{d4}$, $W^1$ und $W^2$ jeweils unabhängig eine Alkylgruppe, die einen Substituenten aufweisen kann, darstellen und Za ein Gegenion, das Ladung neutralisiert, darstellt,

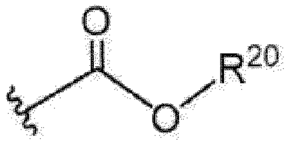

Formel 2

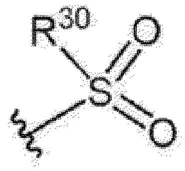

Formel 3

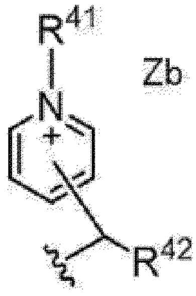

Formel 4

in Formel 2 bis Formel 4 $R^{20}$, $R^{30}$, $R^{41}$ und $R^{42}$ jeweils unabhängig eine Alkylgruppe oder eine Arylgruppe darstellen, Zb ein Gegenion darstellt, das Ladung neutralisiert, und eine Wellenlinie eine Bindungsstelle mit L darstellt.

**11.** Lithographischer Druckplattenvorläufer des Auf-Presse-Entwicklungstyps nach einem der Ansprüche 1 bis 10,

wobei die Bildaufzeichnungsschicht mindestens eine Art von Polymerisationsinitiator, der aus der Gruppe, die aus einem elektronenannehmenden Polymerisationsinitiator und einem elektronenabgebenden Polymerisationsinitiator besteht, ausgewählt wird, enthält, und
wobei der elektronenannehmende Polymerisationsinitiator eine durch Formel (II) dargestellte Verbindung enthält,

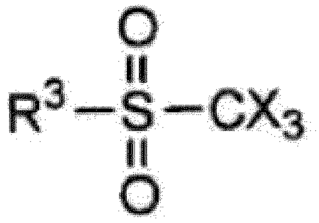

(II)

in Formel (II) X ein Halogenatom darstellt und $R^3$ eine Arylgruppe darstellt.

**12.** Lithographischer Druckplattenvorläufer des Auf-Presse-Entwicklungstyps nach einem der Ansprüche 1 bis 11, wobei die Bildaufzeichnungsschicht eine Verbindung enthält, in der ein elektronenabgebender Polymerisationsinitiator und ein elektronenannehmender Polymerisationsinitiator ein Ionenpaar bilden.

**13.** Lithographischer Druckplattenvorläufer des Auf-Presse-Entwicklungstyps nach einem der Ansprüche 1 bis 12, wobei die Bildaufzeichnungsschicht eine polymerisierbare Verbindung, die 7 oder mehr polymerisierbare Gruppen aufweist, enthält.

**14.** Lithographischer Druckplattenvorläufer des Auf-Presse-Entwicklungstyps nach Anspruch 1, wobei die äußerste Schicht ein hydrophobes Polymer und ein hydrophiles Polymer enthält und ein Gehalt des hydrophoben Polymers auf der Grundlage von Masse gleich oder mehr als das 1,7-Fache eines Gehalts des hydrophilen Polymers ist.

**15.** Verfahren des Herstellens einer lithographischen Druckplatte, umfassend:

einen Schritt des Belichtens des lithographischen Druckplattenvorläufers des Auf-Presse-Entwicklungstyps nach einem der Ansprüche 1 bis 14 in einer Form eines Bildes; und
einen Schritt des Zuführens von mindestens einem Material, das aus der Gruppe ausgewählt wird, die aus einer Druckfarbe und Feuchtwasser besteht, auf einen Drucker, um die Bildaufzeichnungsschicht in einem Nichtbildbereich zu entfernen.

## Revendications

1. Précurseur de plaque d'impression lithographique de type développement sur presse comprenant, dans l'ordre suivant :

   un support ;
   une couche d'enregistrement d'images ; et
   une couche la plus externe,
   dans lequel un angle de contact d'une gouttelette d'eau sur une surface de la couche la plus externe qui est mesuré à 25 °C et 2 secondes après le dépôt de la gouttelette d'eau par une méthode de gouttelette d'eau en suspension dans l'air est supérieur à 36°, et
   dans lequel un angle de contact d'une gouttelette d'huile de lin sur la surface de la couche la plus externe qui est mesuré à 25 °C et 2 secondes après le dépôt de la gouttelette d'huile par une méthode de gouttelette d'huile en suspension dans l'air est de 20° ou moins.

2. Précurseur de plaque d'impression lithographique de type développement sur presse selon la revendication 1, dans lequel la couche la plus externe contient un polymère hydrophobe et un polymère hydrophile.

3. Précurseur de plaque d'impression lithographique de type développement sur presse selon la revendication 2, dans lequel une proportion d'une surface occupée par le polymère hydrophobe au sein de la surface de la couche la plus externe est de 10 % ou plus.

4. Précurseur de plaque d'impression lithographique de type développement sur presse selon la revendication 2 ou la revendication 3,
   dans lequel le polymère hydrophobe se présente sous forme de particules.

5. Précurseur de plaque d'impression lithographique de type développement sur presse selon l'une quelconque des revendications 2 à 4,
   dans lequel une température de transition vitreuse du polymère hydrophobe est de 60 °C ou plus.

6. Précurseur de plaque d'impression lithographique de type développement sur presse selon l'une quelconque des revendications 2 à 5,
   dans lequel une teneur en polymère hydrophobe est égale ou supérieure à 1,7 fois une teneur en polymère hydrophile, en masse.

7. Précurseur de plaque d'impression lithographique de type développement sur presse selon l'une quelconque des revendications 1 à 6,
   dans lequel la couche la plus externe contient un composé décolorant, où un composé décolorant se réfère à un composé qui subit un changement d'absorption dans la région de lumière visible de longueur d'onde de 400 nm ou plus et moins de 750 nm, en raison de l'exposition à l'infrarouge.

8. Précurseur de plaque d'impression lithographique de type développement sur presse selon la revendication 7,
   dans lequel dans un cas où le précurseur de plaque d'impression lithographique de type développement sur presse est soumis à une exposition à l'infrarouge ayant une longueur d'onde de 830 nm à une densité d'énergie de 110 $mJ/cm^2$, une variation de luminosité $\Delta L$ avant et après l'exposition est de 2,0 ou plus.

9. Précurseur de plaque d'impression lithographique de type développement sur presse selon la revendication 7 ou la revendication 8,

   dans lequel le composé décolorant est un composé représenté par Formule **1-1,**

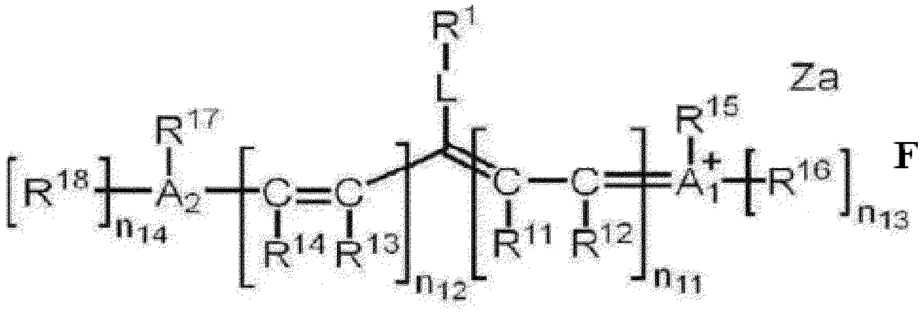

Formule 1-1

dans Formule 1-1, $R^1$ représente un groupe représenté par l'une quelconque des Formules 2, 3 ou 4, $R^{11}$ à $R^{18}$ représentent chacun indépendamment un atome d'hydrogène, un atome d'halogène, $-R^a$, $-OR^b$, $-SR^c$ ou $-NR^dR^e$, $R^a$ à $R^e$ représentent chacun indépendamment un groupe hydrocarboné, $A_1$, $A_2$ et une pluralité de $R^{11}$ à $R^{18}$ peuvent être liés entre eux pour former un cycle monocyclique ou polycyclique, $A_1$ et $A_2$ représentent chacun indépendamment un atome d'oxygène, un atome de soufre ou un atome d'azote, $n_{11}$ et $n_{12}$ représentent chacun indépendamment un entier de 0 à 5, une somme de $n_{11}$ et $n_{12}$ est 2 ou plus, $n_{13}$ et $n_{14}$ représentent chacun indépendamment 0 ou 1, L représente un atome d'oxygène, un atome de soufre ou $-NR^{10}-$, $R^{10}$ représente un atome d'hydrogène, un groupe alkyle ou un groupe aryle, et Za représente un contre-ion qui neutralise la charge,

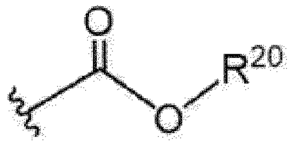

Formule 2

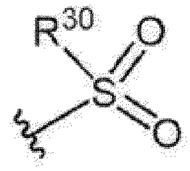

Formule 3

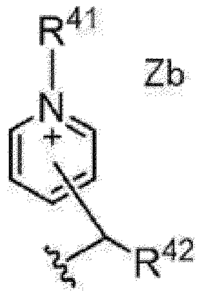

Formule 4

dans Formule 2 à Formule 4, $R^{20}$, $R^{30}$, $R^{41}$ et $R^{42}$ représentent chacun indépendamment un groupe alkyle ou un groupe aryle, Zb représente un contre-ion qui neutralise la charge, et une ligne ondulée représente un site de liaison avec L.

**10.** Précurseur de plaque d'impression lithographique de type développement sur presse selon l'une quelconque des revendications 7 à 9,

dans lequel le composé décolorant est un composé représenté par Formule 1-2,

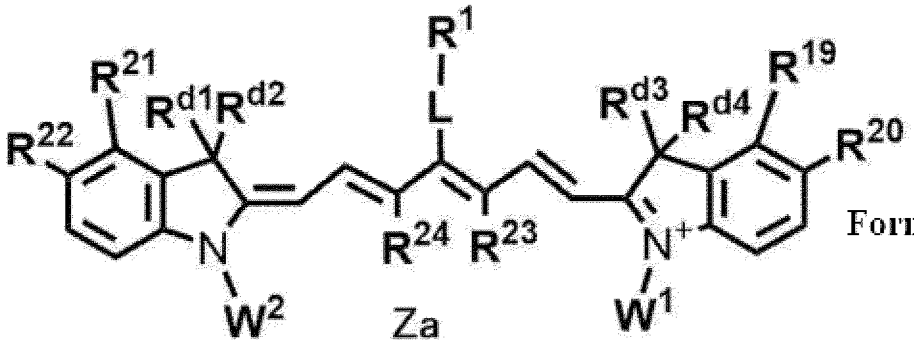

Formule 1-2

dans Formule 1-2, $R^1$ représente un groupe représenté par l'une quelconque des formules 2, 3 ou 4, $R^{19}$ à $R^{22}$ représentent chacun indépendamment un atome d'hydrogène, un atome d'halogène, $-R^a$, $-OR^b$, -CN, $-SR^c$ ou $-NR^dR^e$, $R^{23}$ et $R^{24}$ représentent chacun indépendamment $-R^a$, $R^a$ à $R^e$ représentent chacun indépendamment un groupe hydrocarboné, $R^{19}$ et $R^{20}$, $R^{21}$ et $R^{22}$ ou $R^{23}$ et $R^{24}$ peuvent être liés entre eux pour former un cycle monocyclique ou polycyclique, L représente un atome d'oxygène, un atome de soufre ou $-NR^{10}-$, $R^{10}$ représente

un atome d'hydrogène, un groupe alkyle ou un groupe aryle, R $^{d1}$ à $R^{d4}$, $W^1$ et $W^2$ représentent chacun indépendamment un groupe alkyle qui peut comporter un substituant, et Za représente un contre-ion qui neutralise la charge,

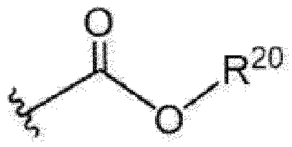

Formule 2

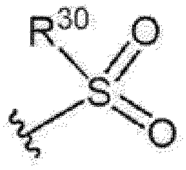

Formule 3

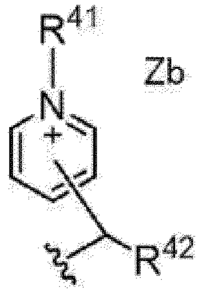

Formule 4

dans Formule 2 à Formule 4, $R^{20}$, $R^{30}$, $R^{41}$ et $R^{42}$ représentent chacun indépendamment un groupe alkyle ou un groupe aryle, Zb représente un contre-ion qui neutralise la charge, et une ligne ondulée représente un site de liaison avec L.

**11.** Précurseur de plaque d'impression lithographique de type développement sur presse selon l'une quelconque des revendications 1 à 10,

dans lequel la couche d'enregistrement d'images contient au moins un type d'initiateur de polymérisation choisi dans le groupe constitué d'un initiateur de polymérisation accepteur d'électrons et d'un initiateur de polymérisation donneur d'électrons, et
dans lequel l'initiateur de polymérisation accepteur d'électrons inclut un composé représenté par Formule (II),

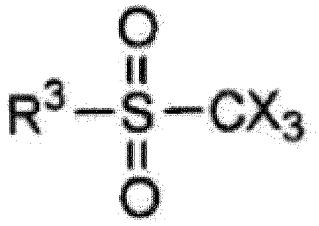

( II )

dans Formule (II), X représente un atome d'halogène, et $R^3$ représente un groupe aryle.

**12.** Précurseur de plaque d'impression lithographique de type développement sur presse selon l'une quelconque des revendications 1 à 11,
dans lequel la couche d'enregistrement d'images contient un composé dans lequel un initiateur de polymérisation donneur d'électrons et un initiateur de polymérisation accepteur d'électrons forment une paire d'ions.

**13.** Précurseur de plaque d'impression lithographique de type développement sur presse selon l'une quelconque des revendications 1 à 12,
dans lequel la couche d'enregistrement d'images contient un composé polymérisable comportant 7 groupes polymérisables ou plus.

**14.** Précurseur de plaque d'impression lithographique de type développement sur presse selon la revendication 1, dans lequel la couche la plus externe contient un polymère hydrophobe et un polymère hydrophile, et une teneur en polymère hydrophobe est égale ou supérieure à 1,7 fois une teneur en polymère hydrophile, en masse.

**15.** Procédé de préparation d'une plaque d'impression lithographique, comprenant :

une étape d'exposition du précurseur de plaque d'impression lithographique de type développement sur presse selon l'une quelconque des revendications 1 à 14 sous une forme d'une image ; et
une étape de fourniture d'au moins un matériau choisi dans le groupe constitué d'une encre d'impression et d'eau de mouillage sur une presse pour éliminer la couche d'enregistrement d'images dans une zone sans image.

FIG. 1

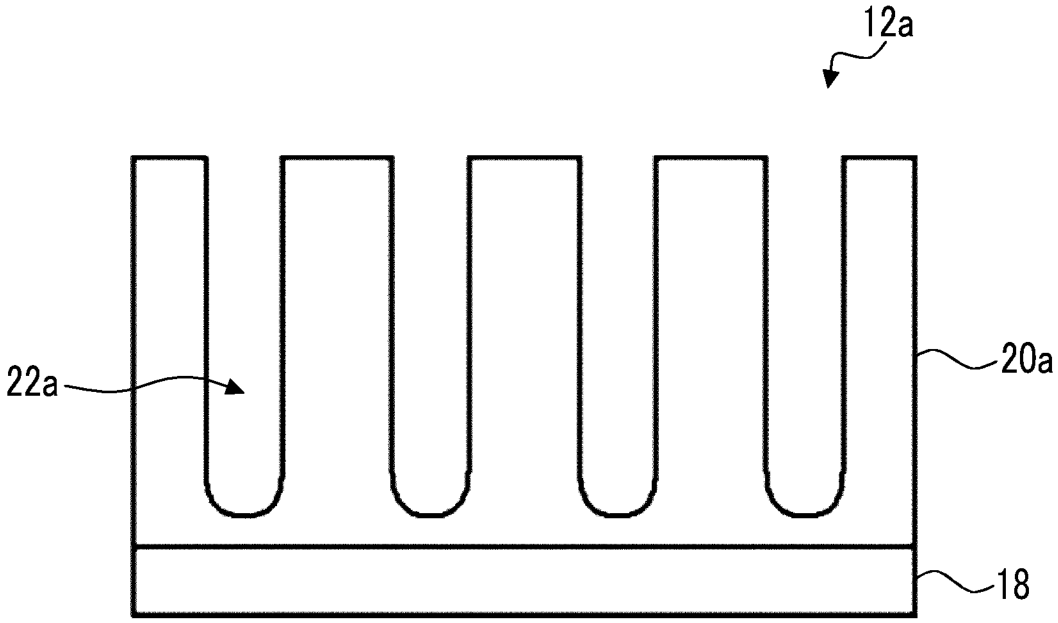


FIG. 2

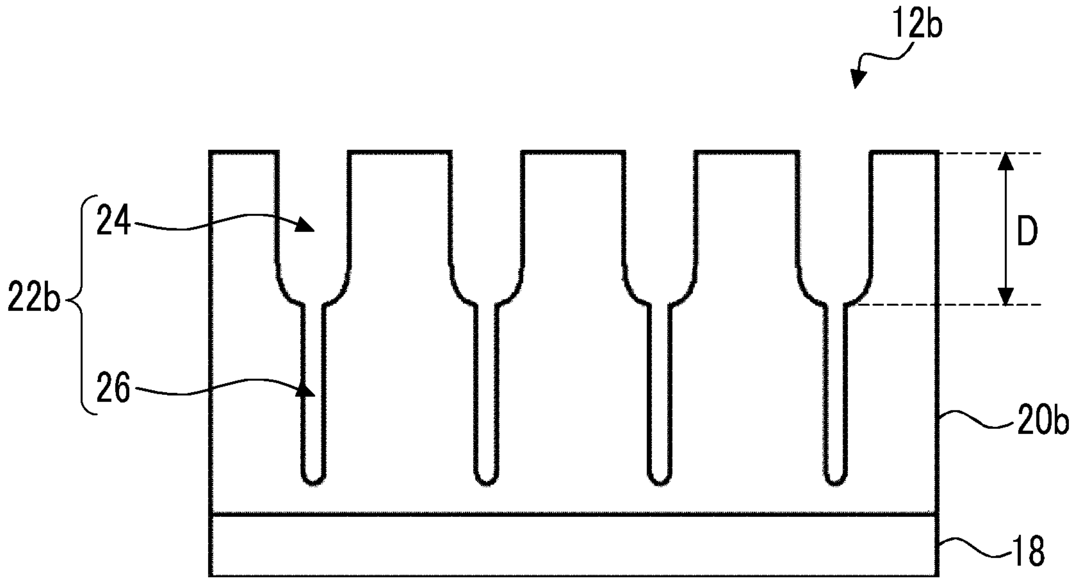

FIG. 3

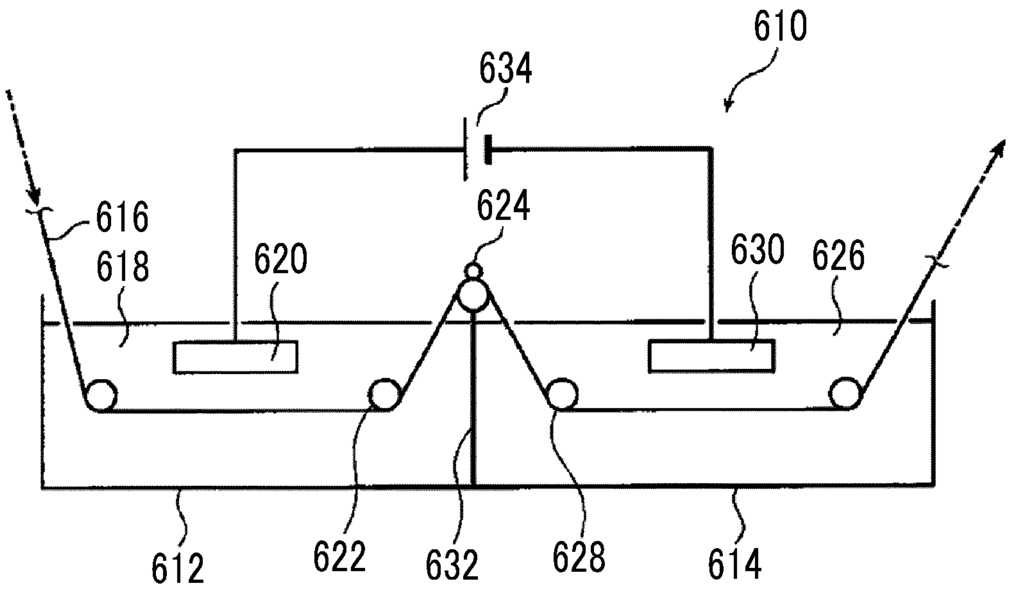

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2019243036 A
- JP 2004237605 A
- WO 2019150788 A
- EP 3991990 A
- US 3458311 A
- JP 55049729 B
- JP S5549729 B
- JP 2005250216 A
- JP 2006259137 A
- WO 2019219560 A
- WO 2016047392 A
- JP 2019162855 A
- JP 2001133969 A
- JP 2002023360 A
- JP 2002040638 A
- JP 2002278057 A
- JP 2008195018 A
- JP 2007090850 A
- JP 2012206495 A
- JP 5005005 A
- JP H055005 A
- JP 2001222101 A
- JP 2008544322 A
- WO 2016027886 A
- WO 2017141882 A
- WO 2018043259 A
- WO 2019013268 A
- JP 9123387 A
- JP H09123387 A
- JP 9131850 A
- JP H09131850 A
- JP 9171249 A
- JP H09171249 A
- JP 9171250 A
- JP H09171250 A
- EP 931647 B
- JP 2001277740 A
- JP 2001277742 A
- JP 2019064269 A
- JP 2012148555 A
- JP 2019018412 A
- JP 10282679 A
- JP H10282679 A
- JP 2304441 A
- JP H02304441 A
- JP 2005238816 A
- JP 2005125749 A
- JP 2006239867 A
- JP 2006215263 A
- JP 2006188038 A
- JP 2012158022 A
- JP 2012066577 A


### Non-patent literature cited in the description


- Dye Handbooks. Society of Synthetic Organic Chemistry, 1970
- *Research Disclosure*, January 1992 (33303)
- Iwanami Dictionary of Physics and Chemistry. Iwanami Shoten, Publishers, 1998